(19) Europäisches Patentamt
European Patent Office
Office européen des brevets

(11) EP 4 166 323 A1

(12) **EUROPEAN PATENT APPLICATION**
published in accordance with Art. 153(4) EPC

(43) Date of publication:
**19.04.2023 Bulletin 2023/16**

(21) Application number: **21823057.1**

(22) Date of filing: **09.06.2021**

(51) International Patent Classification (IPC):
***B32B 27/00*** *(2006.01)* ***B32B 27/30*** *(2006.01)*
***C09J 11/06*** *(2006.01)* ***C09J 109/00*** *(2006.01)*
***C09J 123/26*** *(2006.01)* ***C09J 133/00*** *(2006.01)*
***C09J 133/04*** *(2006.01)* ***C09J 133/14*** *(2006.01)*
***C09J 7/38*** *(2018.01)*

(52) Cooperative Patent Classification (CPC):
**B32B 27/00; B32B 27/30; C09J 7/38; C09J 11/06; C09J 109/00; C09J 123/26; C09J 133/00; C09J 133/04; C09J 133/14**

(86) International application number:
**PCT/JP2021/021961**

(87) International publication number:
**WO 2021/251435 (16.12.2021 Gazette 2021/50)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **12.06.2020 JP 2020102636**

(71) Applicant: **NITTO DENKO CORPORATION**
**Ibaraki-shi**
**Osaka 567-8680 (JP)**

(72) Inventors:
- **KATAMI, Hirofumi**
**Ibaraki-shi, Osaka 567-8680 (JP)**
- **MATSUMOTO, Masamichi**
**Ibaraki-shi, Osaka 567-8680 (JP)**
- **NONAKA, Takahiro**
**Ibaraki-shi, Osaka 567-8680 (JP)**

(74) Representative: **Grünecker Patent- und Rechtsanwälte**
**PartG mbB**
**Leopoldstraße 4**
**80802 München (DE)**

(54) **ADHESIVE SHEET, OPTICAL MEMBER, AND TOUCH PANEL**

(57) An object of the present invention is to provide a pressure-sensitive adhesive sheet enables a pressure-sensitive adhesive layer to be formed, wherein the pressure-sensitive adhesive layer has a low dielectric constant, is excellent in level difference conformability while maintaining adhesive strength and adhesion reliability at high temperatures, and suitable for laminating a metal mesh film and the like. The pressure-sensitive adhesive sheet of the present invention is a pressure-sensitive adhesive sheet having a pressure-sensitive adhesive layer, the pressure-sensitive adhesive layer containing an acrylic polymer (A) and a hydrogenated polyolefinic resin (B) that exhibits liquid flowability at 25°C. The pressure-sensitive adhesive layer has a dielectric constant at a frequency of 1 MHz of from 2.3 to 3.5. The pressure-sensitive adhesive sheet has a 180° peel adhesive strength to a glass plate at a tensile speed of 300 mm/minute at 65°C of 6 N/20 mm or more. In the pressure-sensitive adhesive sheet, the proportion of the 180° peel adhesive strength to a glass plate at a tensile speed of 300 mm/minute at 65°C to the 180° peel adhesive strength to a glass plate at a tensile speed of 300 mm/minute at 25°C (180° peel adhesive strength to a glass plate at a tensile speed of 300 mm/minute at 65°C/180° peel adhesive strength to a glass plate at a tensile speed of 300 mm/minute at 25°C × 100) is 30 or more.

[Fig. 1]

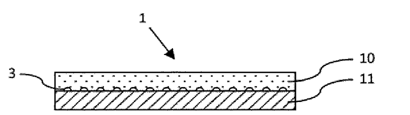


EP 4 166 323 A1

## Description

Technical Field

The present invention relates to a pressure-sensitive adhesive sheet, an optical member, and a touch panel.

Background Art

In recent years, display devices such as liquid crystal displays (LCDs), and input devices such as touch panels, which are used in combination with such display devices, have been widely used in various fields. In these display devices, input devices, and the like, a pressure-sensitive adhesive sheet having a pressure-sensitive adhesive layer is used in applications for laminating optical members. For example, transparent pressure-sensitive adhesive sheets are used for laminating a touch panel with various display members and optical members (see e.g., Patent Literatures 1 to 3).

Particularly, in applications such as production of capacitive touch panels, a pressure-sensitive adhesive sheet may be laminated directly to a metal thin film or metal oxide thin film such as an ITO (indium tin oxide) film (hereinafter, metal thin films and metal oxide thin films may be generically referred to as "metal thin films").

In recent years, in applications such as production of capacitive touch panels, ones in which a film having metal mesh wiring obtained by processing a metal such as silver or copper into a mesh form (metal mesh film) or a film having a silver nanowire layer (AgNW layer) (silver nanowire film) is used as the metal thin film have increased, instead of conventional ITO films. A capacitive touch panel in which a metal mesh film or silver nanowire film is used is an input device that is highly sensitive by virtue of metal wiring having low resistance and widely applicable to displays of small to large sizes.

Silver and copper, which are used in metal mesh films and silver nanowire film, have a problem of easily causing ion migration to pressure-sensitive adhesive layers to easily lead to malfunctions of touch panels due to electric noises. This problem has become more pronounced in association with reduction in the thickness of pressure-sensitive adhesive layers.

In order to suppress malfunctions of touch panels, a pressure-sensitive adhesive layer containing an acrylic polymer having a low dielectric constant is contemplated to be used to thereby enhance the insulation resistance of a pressure-sensitive adhesive layer itself (e.g., see Patent Literature 4).

It is also contemplated to formulate a material having a low dielectric constant in a pressure-sensitive adhesive composition to thereby lower the dielectric constant of a pressure-sensitive adhesive layer (e.g., see Patent Literatures 5 and 6).

Citation List

Patent Literatures

Patent Literature 1: Japanese Patent Laid-Open No. 2003-238915
Patent Literature 2: Japanese Patent Laid-Open No. 2003-342542
Patent Literature 3: Japanese Patent Laid-Open No. 2004-231723
Patent Literature 4: Japanese Patent Laid-Open No. 2016-172865
Patent Literature 5: Japanese Patent Laid-Open No. 2019-038947
Patent Literature 6: Japanese Patent Laid-Open No. 2019-182928

Summary of Invention

Technical Problem

An acrylic polymer having a low dielectric constant, constituted by a low-polar monomer having a high glass transition temperature of its homopolymer, becomes a polymer having a high glass transition temperature and low stress relaxation properties (hardness), thus having problems of inability to sufficiently conform to a level difference formed by metal wiring or the like, probability of air bubbles remaining, and inferior level difference conformability.

Although lowering the molecular weight is also contemplated in order to improve the stress relaxation properties of an acrylic polymer having a low dielectric constant, there is a problem in that the gel fraction decreases to thereby make it difficult to maintain adhesive strength and adhesion reliability at high temperatures.

Accordingly, an object of the present invention is to provide a pressure-sensitive adhesive sheet that has a low

dielectric constant, is excellent in level difference conformability while maintaining adhesive strength and adhesion reliability at high temperatures, and is suitable for lamination of a metal mesh film and the like.

Another object of the present invention is to provide an optical member and a touch panel of high performance that comprise the pressure-sensitive adhesive sheet and are unlikely to suffer malfunctions.

Solution to Problem

The present inventors have intensively studied to achieve the objects of the present invention and have found that a pressure-sensitive adhesive sheet that has a low dielectric constant, is excellent in level difference conformability while maintaining adhesive strength and adhesion reliability at high temperatures, and is suitable for lamination of metal mesh films and silver nanowire films can be formed by using an acrylic polymer as a base polymer constituting a pressure-sensitive adhesive layer and formulating a polyolefinic resin of a specific configuration, having completed the present invention.

A first aspect of the present invention provides a pressure-sensitive adhesive sheet having a pressure-sensitive adhesive layer. In the first aspect of the present invention, the dielectric constant of the pressure-sensitive adhesive layer at a frequency of 1 MHz is from 2.3 to 3.5. The configuration is preferable from the viewpoint that a malfunction due to ion migration or the like can be prevented even when the pressure-sensitive adhesive sheet of the first aspect of the present invention is laminated with a film having metal wiring such as a metal mesh film or silver nanowire film.

In the first aspect of the present invention, the pressure-sensitive adhesive layer contains an acrylic polymer (A) and a hydrogenated polyolefinic resin (B) that exhibits liquid flowability at 25°C.

In the first aspect of the present invention, a configuration in which the pressure-sensitive adhesive layer contains the acrylic polymer (A) is preferable in that adjusting the monomer composition enables the pressure-sensitive adhesive layer to have a lower dielectric constant. However, in order to cause the pressure-sensitive adhesive layer to have a lower dielectric constant, it is necessary to use a monomer component being low in polarity and having a high glass transition temperature (Tg) of its homopolymer (e.g., Tg:-80 to 0°C) as a monomer component constituting the acrylic polymer (A). Thus, the acrylic polymer (A) becomes a polymer having a high glass transition temperature and low stress relaxation properties (hardness), cannot sufficiently conform to a level difference formed by metal wiring or the like, is likely to cause air bubbles to remain, and may have inferior level difference conformability. When the molecular weight is lowered in order to improve the stress relaxation properties of the acrylic polymer (A), there is a problem in that the gel fraction decreases to thereby makes it difficult to maintain adhesive strength and adhesion reliability at high temperatures.

In the first aspect of the present invention, a configuration in which the pressure-sensitive adhesive layer contains the hydrogenated polyolefinic resin (B) that exhibits liquid flowability at 25°C is preferable in that the stress relaxation properties are improved while adhesive strength and adhesion reliability at high temperatures are maintained without lowering the molecular weight of the acrylic polymer (A) to thereby impart excellent level difference conformability to the pressure-sensitive adhesive layer. The hydrogenated polyolefinic resin (B), which is a material having a low dielectric constant, exhibits liquid flowability at 25°C (room temperature). Thus, by formulating the hydrogenated polyolefinic resin (B) to the acrylic polymer (A), the stress relaxation properties of the pressure-sensitive adhesive layer can be improved to thereby enhance the level difference conformability without raising the dielectric constant.

Additionally, when the pressure-sensitive adhesive layer contains the hydrogenated polyolefinic resin (B), the stress relaxation properties can be improved without lowering the molecular weight of the acrylic polymer (A). Further, the hydrogenated polyolefinic resin (B), in which carbon-carbon double bonds in the molecule have been reduced by hydrogenation and thus carbon-carbon double bonds in the molecule have decreased, is unlikely to cause polymerization inhibition when the pressure-sensitive adhesive layer is cured by ultraviolet irradiation, for example, to thereby scarcely lead to decrease in the polymerization ratio and lowering of the molecular weight. Thus, the adhesive strength and adhesion reliability at high temperatures of the pressure-sensitive adhesive sheet of the first aspect of the present invention can be maintained at a high level.

The hydrogenated polyolefinic resin (B), which is excellent in the compatibility to the acrylic polymer (A), is preferable also in that the transparency of the pressure-sensitive adhesive layer can be maintained at a higher level.

Thus, the first aspect of the present invention provides a pressure-sensitive adhesive sheet in which the pressure-sensitive adhesive layer contains an acrylic polymer (A) and a hydrogenated polyolefinic resin (B), the pressure-sensitive adhesive sheet thus having a low dielectric constant while maintaining adhesive strength and adhesion reliability at high temperatures at a high level, being excellent in level difference conformability, and being able to be preferably used for applications for lamination on a transparent conductive film including a metal wiring layer formed, such as a metal mesh film and silver nanowire film.

As described above, the pressure-sensitive adhesive sheet of the first aspect of the present invention can achieve adhesive strength and adhesion reliability at high temperatures onto a transparent conductive film including a metal wiring layer formed, such as a metal mesh film and silver nanowire film. In other words, the 180° peel adhesive

strength of the pressure-sensitive adhesive sheet of the first aspect of the present invention to a glass plate at a tensile speed of 300 mm/minute at 65°C is 6 N/20 mm or more.

In the pressure-sensitive adhesive sheet of the first aspect of the present invention, the proportion of the 180° peel adhesive strength to a glass plate at a tensile speed of 300 mm/minute at 65°C to the 180° peel adhesive strength to a glass plate at a tensile speed of 300 mm/minute at 25°C (180° peel adhesive strength to a glass plate at a tensile speed of 300 mm/minute at 65°C/180° peel adhesive strength to a glass plate at a tensile speed of 300 mm/minute at 25°C × 100) is 30 or more. The elastic modulus of the pressure-sensitive adhesive layer decreases at high temperatures, and thus the proportion generally becomes smaller. However, the proportion in the pressure-sensitive adhesive sheet of the first aspect of the present invention is 30 or more, and thus the adhesive strength and adhesion reliability at high temperatures and inhibition of lifting at a level difference are further excellent.

The 180° peel adhesive strength of the pressure-sensitive adhesive sheet of the first aspect of the present invention to a glass plate at a tensile speed of 300 mm/minute at 25°C is preferably 10 N/20 mm or more from the viewpoint that sufficient adherence is obtained on a transparent conductive film including a metal wiring layer formed, such as a metal mesh film and silver nanowire film.

In the first aspect of the present invention, the pressure-sensitive adhesive layer preferably has a gel fraction of from 40 to 85% from the viewpoint that excellent bendability is achieved while excellent adhesive strength and adhesion reliability at high temperatures are maintained.

The haze (in accordance with JIS K 7136) of the pressure-sensitive adhesive sheet of the first aspect of the present invention is preferably 1.0% or less from the viewpoint of excellent transparency and appearance.

The total light transmittance (in accordance with JIS K 7361-1) of the pressure-sensitive adhesive sheet of the first aspect of the present invention is preferably 90% or more from the viewpoint of excellent transparency and appearance.

The thickness of the pressure-sensitive adhesive sheet of the first aspect of the present invention is preferably from 12 to 350 um from the viewpoint that peeling at a level difference site is unlikely to occur and excellent appearance is more likely to be retained.

In first aspect of the present invention, the number average molecular weight (Mn) of the hydrogenated polyolefinic resin (B) is preferably from 1000 to 5000. The configuration is preferable in that moderate stress relaxation properties and flowability are imparted to the pressure-sensitive adhesive layer and the compatibility to the acrylic polymer (A) is enhanced. In other words, a configuration in which the number average molecular weight (Mn) is 1000 or more is preferable in that the moderate stress relaxation properties and flowability can be imparted to the pressure-sensitive adhesive layer. A configuration in which the number average molecular weight (Mn) is 5000 or less is preferable in that the compatibility to the acrylic polymer (A) is enhanced and also that the transparency of the pressure-sensitive adhesive layer can be maintained at a higher level.

In the first aspect of the present invention, the polydispersity (Mw/Mn) of the hydrogenated polyolefinic resin (B) is 2.0 or less. The configuration is preferable in that moderate stress relaxation properties and flowability are imparted to the pressure-sensitive adhesive layer and the compatibility to the acrylic polymer (A) is enhanced.

In the first aspect of the present invention, the hydrogenated polyolefinic resin (B) preferably contains at least one selected from the group consisting of a hydrogenated polyolefin and a hydrogenated polyolefin polyol. This configuration is preferable in that the effect of the hydrogenated polyolefinic resin (B) can be further enhanced, which effect is an ability of forming a pressure-sensitive adhesive layer that has a low dielectric constant and is excellent in level difference conformability while maintaining adhesive strength and adhesion reliability at high temperatures.

In the first aspect of the present invention, the hydrogenated polyolefinic resin (B) preferably contains at least one selected from the group consisting of a hydrogenated polybutadiene and a hydrogenated polybutadiene polyol. This configuration is preferable in that the above effect of the hydrogenated polyolefinic resin (B) can be further enhanced, which effect is an ability of forming a pressure-sensitive adhesive layer that has a low dielectric constant and is excellent in level difference conformability while maintaining adhesive strength and adhesion reliability at high temperatures.

In the first aspect of the present invention, the pressure-sensitive adhesive layer preferably contains 3 to 35 parts by weight of the hydrogenated polyolefinic resin (B) based on 100 parts by weight of the acrylic polymer (A). The configuration is preferable from the viewpoint that moderate stress relaxation properties and flowability are imparted to the pressure-sensitive adhesive layer and that excellent level difference absorptivity, adhesiveness, and handleability can be obtained. In other words, a configuration in which the content of the hydrogenated polyolefinic resin (B) is 3 parts by weight or more is preferable in that excellent level difference absorptivity can be imparted to the pressure-sensitive adhesive layer. A configuration in which the content is 35 parts by weight or less is preferable in that the gel fraction of the pressure-sensitive adhesive layer is enhanced and adhesive strength and adhesion reliability at high temperatures can be maintained at a high level. The configuration is preferable also in that process soiling caused by soil at cut ends of the pressure-sensitive adhesive layer is prevented to thereby enhance the handleability.

In the first aspect of the present invention, the acrylic polymer (A) preferably contains a (meth)acrylic alkyl ester having a branched-chain alkyl group having 10 to 24 carbon atoms" as a constituent monomer component.

The "(meth)acrylic alkyl ester having a branched-chain alkyl group having 10 to 24 carbon atoms herein may be referred to as the "(meth)acrylic alkyl ester (A)".

The (meth)acrylic alkyl ester (A) is a low-polar monomer component. Thus, when the acrylic polymer (A) contains the (meth)acrylic alkyl ester (A) as a constituent monomer component, the polymer will have a low dielectric constant, and a pressure-sensitive adhesive layer having a low dielectric constant can be achieved. This is preferable because a malfunction due to ion migration or the like can be prevented even when a film having metal wiring such as a metal mesh film or silver nanowire film is laminated.

In the first aspect of the present invention, the (meth)acrylic alkyl ester (A) ((meth)acrylic alkyl ester having a branched-chain alkyl group having 10 to 24 carbon atoms) preferably contains isostearyl (meth)acrylate. The configuration is preferable in that the dielectric constant of the acrylic polymer (A) is easily controlled low. The configuration is preferable also in that the compatibility to the hydrogenated polyolefinic resin (B) is further enhanced to thereby enable the transparency of the pressure-sensitive adhesive layer to be maintained at a higher level.

In the first aspect of the present invention, it is preferable to contain from 3 to 50 parts by weight of the (meth)acrylic alkyl ester (A) ((meth)acrylic alkyl ester having a branched-chain alkyl group having 10 to 24 carbon atoms) based on the total amount of the monomer components constituting the acrylic polymer (A) (100 parts by weight). The configuration is preferable in respect of enabling a moderate dielectric constant and compatibility to the hydrogenated polyolefinic resin (B) to be imparted to the acrylic polymer (A). In other words, a configuration in which the content of the (meth)acrylic alkyl ester (A) is 3 parts by weight or more is preferable in respect of enabling a low dielectric constant and compatibility to the hydrogenated polyolefinic resin (B) to be imparted to the acrylic polymer (A). A configuration in which the content is 50 parts by weight or less is preferable in that moderate stress relaxation properties and excellent level difference absorptivity can be obtained in the pressure-sensitive adhesive layer.

In the first aspect of the present invention, at least one selected from the group consisting of (meth)acrylic alkyl esters having a linear-chain alkyl group having 1 to 24 carbon atoms and (meth)acrylic alkyl esters having a branched-chain alkyl group having 3 to 9 carbon atoms is preferably further contained as a monomer component constituting the acrylic polymer (A). The configuration is preferable in that the Tg of the acrylic polymer (A) itself is adjusted, the stress relaxation properties of the pressure-sensitive adhesive layer are enhanced, and the level difference conformability can be improved. In respect that the compatibility to the hydrogenated polyolefinic resin (B) is further enhanced to enable the transparency of the pressure-sensitive adhesive layer to be maintained at a higher level, a (meth)acrylic alkyl ester having a linear-chain alkyl group having 1 to 24 carbon atoms is preferable as the monomer component.

In the first aspect of the present invention, it is preferable to contain 0.1 to 25 parts by weight of a hydroxyl group-containing monomer based on the total amount of the monomer components constituting the acrylic polymer (A) (100 parts by weight). The configuration is preferable in that favorable cohesion and high high-temperature adhesion reliability are imparted to the pressure-sensitive adhesive layer and also favorable compatibility to the hydrogenated polyolefinic resin (B) can be obtained. In other words, a configuration in which the content of the hydroxyl group-containing monomer is 0.1 parts by weight or more is preferable in that favorable cohesion and high adhesion reliability can be imparted to the pressure-sensitive adhesive layer. A configuration in which the content is 25 parts by weight or less is preferable in that favorable compatibility to the hydrogenated polyolefinic resin (B) can be obtained.

In the first aspect of the present invention, it is preferable to contain 3 to 30 parts by weight of at least one selected from nitrogen atom-containing monomers and alicyclic structure-containing monomers based on the total amount of the monomer components constituting the acrylic polymer (A) (100 parts by weight). The configuration is preferable in that favorable cohesion and high high-temperature adhesion reliability are imparted to the pressure-sensitive adhesive layer and also favorable compatibility to the hydrogenated polyolefinic resin (B) can be obtained. In other words, a configuration in which the content of at least one selected from a nitrogen atom-containing monomer and an alicyclic structure-containing monomer is 3 parts by weight or more is preferable in that favorable cohesion and high adhesion reliability can be imparted to the pressure-sensitive adhesive layer. A configuration in which the content is 30 parts by weight or less is preferable in that favorable compatibility to the hydrogenated polyolefinic resin (B) can be obtained.

In the first aspect of the present invention, the acrylic polymer (A) is preferably free or substantially free of a carboxyl group-containing monomer as a constituent monomer component. The configuration is preferable in that an excellent corrosion prevention effect on metal wiring such as metal mesh wiring and silver nanowire can be obtained.

In the first aspect of the present invention, the pressure-sensitive adhesive layer preferably further contains a polyfunctional (meth)acrylate. The configuration is preferable in that the pressure-sensitive adhesive layer has moderate cohesion and the pressure-sensitive adhesive strength and level difference absorptivity are more likely to be enhanced.

In the first aspect of the present invention, the pressure-sensitive adhesive layer preferably further contains an anti-corrosive agent. The configuration is preferable in that an excellent corrosion prevention effect on metal wiring such as metal mesh wiring and silver nanowire can be obtained. The anti-corrosive agent is preferably a benzotriazole compound in respect of compatibility to the acrylic polymer (A) and transparency, and in respect that the reaction (crosslinking and polymerization) is less likely to be inhibited when the acrylic polymer (A) is further allowed to react after addition.

In the first aspect of the present invention, the pressure-sensitive adhesive layer preferably further contains a silane coupling agent. The configuration is preferable in that excellent adhesiveness to glass (particularly, excellent adhesion reliability to glass at high temperatures and high humidity) is more easily obtained.

In the first aspect of the present invention, the pressure-sensitive adhesive layer preferably further contains an antioxidant. The configuration is preferable for preventing oxidative degradation during storage of the pressure-sensitive adhesive sheet of the first aspect of the present invention.

A second aspect of the present invention provides an optical member having at least the pressure-sensitive adhesive sheet of the first aspect of the present invention and a substrate, wherein the substrate comprises metal wiring on at least one face, and the pressure-sensitive adhesive sheet is laminated on the face of the substrate on the side having the metal wiring.

A third aspect of the present invention provides a touch panel having at least the pressure-sensitive adhesive sheet of the first aspect of the present invention and a substrate, wherein the substrate comprises metal wiring on at least one face, and the pressure-sensitive adhesive sheet is laminated on the face of the substrate on the side having the metal wiring.

In the optical member of the second aspect of the present invention and the touch panel of the third aspect of the present invention, the metal wiring is preferably metal mesh wiring or silver nanowire.

In the optical member of the second aspect of the present invention and the touch panel of the third aspect of the present invention, metal wiring such as metal mesh wiring or silver nanowire is laminated by the pressure-sensitive adhesive sheet that has a low dielectric constant and is excellent in level difference conformability while maintaining adhesive strength and adhesion reliability at high temperatures. Thus, level differences such as metal wiring is filled with the pressure-sensitive adhesive sheet with no clearance, and malfunctions are unlikely to occur.

Advantageous Effects of Invention

The pressure-sensitive adhesive sheet of the present invention has a pressure-sensitive adhesive layer that has a low dielectric constant and is excellent in level difference conformability while maintaining adhesive strength and adhesion reliability at high temperatures. Accordingly, a highly-reliable and high-performance optical member such as a touch panel that maintains adhesive strength and adhesion reliability at high temperatures, exhibits excellent level difference absorptivity, which provides sufficient conformability to level differences and causes no air bubble to remain, as well as is unlikely to suffer malfunctions can be efficiently produced by laminating a metal mesh film or silver nanowire film using the pressure-sensitive adhesive sheet of the present invention.

Thus, the pressure-sensitive adhesive sheet of the present invention can be preferably used in optical members having metal mesh wiring or a silver nanowire layer, particularly in applications for lamination on a transparent conductive film including a metal wiring layer formed, such as a metal mesh film and silver nanowire film.

Brief Description of Drawings

[Figure 1] Figure 1 is a schematic view illustrating a specific example of a preferable form of the optical member of the present invention.
[Figure 2] Figure 2 is a schematic view illustrating a specific example of a preferable form of the touch panel of the present invention.
[Figure 3] Figure 3 is the top view of glass having a level difference used in foaming and peeling resistance evaluation.
[Figure 4] Figure 4 is a cross-sectional view of the glass having a level difference (cross-sectional view along line A-A').
[Figure 5] Figure 5 is a cross-sectional view of the glass having a level difference (cross-sectional view along line B-B').

Description of Embodiments

[1. Pressure-sensitive adhesive sheet and pressure-sensitive adhesive layer]

The pressure-sensitive adhesive sheet of the first aspect of the present invention is a pressure-sensitive adhesive sheet comprising a pressure-sensitive adhesive layer, wherein the pressure-sensitive adhesive layer contains an acrylic polymer (A) and a hydrogenated polyolefinic resin (B),

the pressure-sensitive adhesive layer has a dielectric constant at a frequency of 1 MHz of from 2.3 to 3.5,
the pressure-sensitive adhesive sheet has a 180° peel adhesive strength to a glass plate at a tensile speed of 300 mm/minute at 65°C of 6 N/20 mm or more, and

the proportion of the 180° peel adhesive strength to a glass plate at a tensile speed of 300 mm/minute at 65°C to the 180° peel adhesive strength to a glass plate at a tensile speed of 300 mm/minute at 25°C (180° peel adhesive strength to a glass plate at a tensile speed of 300 mm/minute at 65°C/180° peel adhesive strength to a glass plate at a tensile speed of 300 mm/minute at 25°C $\times$ 100) is 30 or more.

The pressure-sensitive adhesive layer constituting the pressure-sensitive adhesive sheet of the first aspect of the present invention herein may be referred to as "the pressure-sensitive adhesive layer of the present invention". The pressure-sensitive adhesive composition forming the pressure-sensitive adhesive layer of the present invention may be referred to as "the pressure-sensitive adhesive composition of the present invention".

For example, when "the pressure-sensitive adhesive layer of the present invention contains an acrylic polymer (A) and a hydrogenated polyolefinic resin (B)" is referred to herein, a case in which the pressure-sensitive adhesive composition forming the pressure-sensitive adhesive layer of the present invention (the pressure-sensitive adhesive composition of the present invention) contains the acrylic polymer (A) and the hydrogenated polyolefinic resin (B) is intended to be also included. The same applies to a case in which the pressure-sensitive adhesive layer of the present invention contains, is free of, or is substantially free of a component other than the acrylic polymer (A) and hydrogenated polyolefinic resin (B).

The pressure-sensitive adhesive layer of the present invention (the pressure-sensitive adhesive composition of the present invention) may contain a polyfunctional (meth)acrylate, an anti-corrosive agent, a silane coupling agent, an antioxidant, and other additives mentioned below, besides those described above.

The pressure-sensitive adhesive composition of the present invention may have any form, and examples thereof include an emulsion type, a thermofusible type (hot-melt type), a solventless type (active energy ray-curable type, e.g., a monomer mixture, or a monomer mixture and a partially polymerized product thereof). Particularly, the pressure-sensitive adhesive composition of the present invention is preferably not a solvent type. This is because defects in the appearance, such as orange peel, are likely to occur when a pressure-sensitive adhesive layer is attempted to be obtained by use of a solvent-type pressure-sensitive adhesive composition. "Orange peel" refers to a phenomenon in which unevenness like the skin of yuzu, a type of citrus fruit, occurs. The pressure-sensitive adhesive composition of the present invention is preferably an active energy ray-curable type in respect of obtaining a pressure-sensitive adhesive layer excellent in appearance. Herein, the pressure-sensitive adhesive composition means a composition to be used for forming the pressure-sensitive adhesive layer and is intended to include the meaning of a composition to be used for forming the pressure-sensitive adhesive.

The pressure-sensitive adhesive composition of the present invention is preferably not a solvent type, as described above, that is, is free of or substantially free of an organic solvent.

The organic solvent described above is not particularly limited as long as being an organic compound used as a solvent, and examples thereof include hydrocarbon solvents such as cyclohexane, hexane, and heptane; aromatic solvents such as toluene and xylene; ester solvents such as ethyl acetate and methyl acetate; ketone solvents such as acetone and methyl ethyl ketone; and alcohol solvents such as methanol, ethanol, butanol, and isopropyl alcohol. The organic solvent may be a mixed solvent including two or more organic solvents.

In the pressure-sensitive adhesive composition of the present invention, the phrase "substantially free of" an organic solvent refers to actively formulating no organic solvent except when an organic solvent is inevitably mixed. Specifically, it can be said that one in which the content of the organic solvent in the pressure-sensitive adhesive composition is 1.0% by weight or less (preferably 0.5% by weight or less, further preferably 0.2% by weight or less) based on the total amount of the pressure-sensitive adhesive composition (total weight, 100% by weight) is substantially free thereof.

As the base polymer constituting the pressure-sensitive adhesive composition of the present invention, an acrylic polymer is included in respect of the transparency, weatherability, adhesion reliability, ease of function design of the pressure-sensitive adhesive layer due to abundance of types of monomers, and the like. In other words, the pressure-sensitive adhesive composition of the present invention is an acrylic pressure-sensitive adhesive composition containing an acrylic polymer (A) mentioned below as the base polymer. Such acrylic polymers (A) may be used singly or in combination of two or more.

The content of the acrylic polymer (A) as the base polymer in the pressure-sensitive adhesive composition of the present invention is, but not particularly limited to, preferably 74% by weight or more (e.g., from 74 to 99.9% by weight), more preferably 84% by weight or more (e.g., from 84 to 99.9% by weight).

The pressure-sensitive adhesive layer of the present invention (the pressure-sensitive adhesive composition of the present invention) is more preferably free of or substantially free of a carboxyl group-containing monomer as a constituent monomer component constituting the acrylic polymer (A). Thus, the pressure-sensitive adhesive layer described above can obtain a corrosion prevention effect on metal wiring such as metal mesh wiring and silver nanowire. It can be said that one in which the content of a carboxyl group-containing monomer is preferably 0.05% by weight or less (e.g., from 0 to 0.05% by weight), more preferably 0.01% by weight or less (e.g., from 0 to 0.01% by weight), further

preferably 0.001% by weight or less (e.g., from 0 to 0.001% by weight) based on the total amount of the pressure-sensitive adhesive layer described above is substantially free of a carboxyl group-containing monomer.

The pressure-sensitive adhesive layer of the present invention, of which the dielectric constant is controlled low, enables malfunctions of optical members such as a touch panel having the pressure-sensitive adhesive layer to be prevented. In the pressure-sensitive adhesive layer of the present invention, the dielectric constant at a frequency of 1 MHz is preferably 3.5 or less, more preferably 3.3 or less, further preferably 3.2 or less. The lower limit value of the dielectric constant at a frequency of 1 MHz is, but not particularly limited to, preferably 2.3 or more, more preferably 2.4 or more, further preferably 2.5 or more.

The dielectric constant at a frequency of 100 kHz is preferably 4.0 or less, more preferably 3.9 or less, further preferably 3.8 or less. The lower limit value of the dielectric constant at a frequency of 100 kHz is, but not particularly limited to, preferably 2.3 or more, more preferably 2.4 or more, further preferably 2.5 or more.

The dielectric constant of the pressure-sensitive adhesive layer of the present invention can be adjusted by adjusting the monomer composition of the acrylic polymer (A), the type of the hydrogenated polyolefinic resin (B), the formulation ratio of the acrylic polymer (A) and the hydrogenated polyolefinic resin (B), and the like. The dielectric constant is measured according to the method described in Examples listed below.

In the pressure-sensitive adhesive sheet of the present invention, which is excellent in adhesive strength and adhesion reliability at high temperatures, the 180° peel adhesive strength to a glass plate at a tensile speed of 300 mm/minute at 65°C (particularly, the 180° peel adhesive strength of the adhesive face provided by the pressure-sensitive adhesive layer described above (the pressure-sensitive adhesive layer of the present invention) to a glass plate at a tensile speed of 300 mm/minute at 65°C) is 6 N/20 mm or more, preferably 6.5 N/20 mm or more, more preferably 7 N/20 mm or more, further preferably 7.5 N/20 mm or more. The 180° peel adhesive strength of the pressure-sensitive adhesive sheet of the present invention to a glass plate at a tensile speed of 300 mm/minute at 65°C is equal to or higher than a certain value, and thus adhesiveness to glass at high temperatures and inhibition of lifting at a level difference are further excellent. The upper limit value of the 180° peel adhesive strength of the pressure-sensitive adhesive sheet of the present invention to a glass plate at a tensile speed of 300 mm/minute at 65°C is, not particularly limited, for example, preferably 60 N/20 mm or less, more preferably 40 N/20 mm or less.

In the pressure-sensitive adhesive sheet of the present invention, the proportion of the 180° peel adhesive strength to a glass plate at a tensile speed of 300 mm/minute at 65°C to the 180° peel adhesive strength to a glass plate at a tensile speed of 300 mm/minute at 25°C (180° peel adhesive strength to a glass plate at a tensile speed of 300 mm/minute at 65°C/180° peel adhesive strength to a glass plate at a tensile speed of 300 mm/minute at 25°C $\times$ 100) is 30 or more, more preferably 35 or more, further preferably 40 or more, further more preferably 45 or more. The elastic modulus of the pressure-sensitive adhesive layer decreases at high temperatures, and thus the proportion generally becomes smaller. However, the proportion in the pressure-sensitive adhesive sheet of the present invention is equal to or higher than a certain value, and thus the adhesive strength and adhesion reliability to glass at high temperatures and inhibition of lifting at a level difference are further excellent. The upper limit value of the proportion described above, but not particularly limited to, may be practically 100 or less or may be 95 or less.

The 180° peel adhesive strength of the pressure-sensitive adhesive sheet of the present invention to a glass plate at a tensile speed of 300 mm/minute at 25°C (particularly, the 180° peel adhesive strength of the adhesive face provided by the pressure-sensitive adhesive layer described above (the pressure-sensitive adhesive layer of the present invention) to a glass plate at a tensile speed of 300 mm/minute at 25°C) is, but not particularly limited to, preferably 10 N/20 mm or more, more preferably 12 N/20 mm or more, further preferably 14 N/20 mm or more, further more preferably 16 N/20 mm or more, from the viewpoint that, when the adhesive strength is high, sufficient adherence to a metal surface such as metal mesh wiring, silver nanowire, or the like is obtained and the corrosion prevention effect is also improved. When the 180° peel adhesive strength of the pressure-sensitive adhesive sheet of the present invention to a glass plate at a tensile speed of 300 mm/minute at 25°C is equal to or higher than a certain value, adhesiveness to glass and inhibition of lifting at a level difference are further excellent. The upper limit value of the 180° peel adhesive strength of the pressure-sensitive adhesive sheet of the present invention to a glass plate at a tensile speed of 300 mm/minute at 25°C is, not particularly limited, for example, preferably 60 N/20 mm or less, more preferably 40 N/20 mm or less.

The 180° peel adhesive strength to a glass plate at a tensile speed of 300 mm/minute at 25°C and 65°C is determined by the following method for measuring the 180° peel adhesive strength. Examples of the glass plate include, but not particularly limited to, trade name "Soda lime glass #0050" (manufactured by Matsunami Glass Ind., Ltd.). Examples thereof also include alkali-free glass and chemically reinforced glass.

The above-described adhesive strength and the proportion of the adhesive strength of the pressure-sensitive adhesive sheet of the present invention can be adjusted by adjusting the monomer composition of the acrylic polymer (A), the type of the hydrogenated polyolefinic resin (B), the formulation ratio of the acrylic polymer (A) and the hydrogenated polyolefinic resin (B), and the like.

(A-1. Method for measuring 180° peel adhesive strength)

The adhesive face of the pressure-sensitive adhesive sheet is laminated to an object, subjected to pressure-bonding under pressure-bonding conditions of a 2-kg roller and one reciprocation, and aged under an atmosphere of 23°C and 50% RH for 30 minutes. After the aging, the pressure-sensitive adhesive sheet is peeled off from the object in accordance with JIS Z 0237 under an atmosphere of 25°C or 65°C and 50% RH under conditions of a tensile speed of 300 mm/minute and a separation angle of 180°, and the 180° peel adhesive strength (N/20 mm) is measured.

The gel fraction of the pressure-sensitive adhesive layer of the present invention (the proportion of the solvent insoluble component) is preferably from 40 to 85%, more preferably from 45 to 80%, further preferably from 45 to 75%. A case in which the gel fraction is 40% or more is preferable because the cohesion of the pressure-sensitive adhesive layer is enhanced, foaming or peeling at the interface with the object under a high-temperature environment is suppressed, and excellent foaming and peeling resistance is more easily obtained. The case is preferable also from the viewpoint of changes in the roll appearance during extended storage in a roll form and handleability, that is, low likelihood of protrusion of the pressure-sensitive adhesive from ends during handling of a sheet. The case is preferable also from the viewpoint that flexibility is imparted to the pressure-sensitive adhesive layer to thereby enable the bendability to be enhanced. A case in which the gel fraction is 95% or less is preferable because moderate flexibility is obtained to thereby the adhesiveness to be further enhanced.

(Gel fraction)

The gel fraction (the proportion of the solvent insoluble component) described above is specifically a value calculated by "Method for measuring gel fraction" below, for example.

About 0.1 g of the pressure-sensitive adhesive layer is collected from the pressure-sensitive adhesive sheet and wrapped with a porous tetrafluoroethylene sheet having an average pore diameter of 0.2 μm (trade name "NTF1122", manufactured by NITTO DENKO CORPORATION), and then tied up with a kite string. The weight at this time is measured, and this weight is defined as the weight before immersion. The weight before immersion is the total weight of the pressure-sensitive adhesive layer (the pressure-sensitive adhesive layer collected above), the tetrafluoroethylene sheet, and the kite string. The total weight of the tetrafluoroethylene sheet and the kite string is also measured, and this weight is defined as the packaging weight.

Next, the pressure-sensitive adhesive layer wrapped with the tetrafluoroethylene sheet and tied up with the kite string (referred to as the "sample") is put in a 50 ml vessel filled with ethyl acetate, followed by allowing to stand at 23°C for 7 days. The sample (after ethyl acetate treatment) is then taken out of the vessel and transferred to an aluminum cup, followed by drying in a dryer at 130°C for 2 hours to remove ethyl acetate. Thereafter, the weight is measured, and this weight is defined as the weight after immersion.

The gel fraction is then calculated according to the following formula.

$$\text{Gel fraction [\% (\% by weight)]} = (X - Y)/(Z - Y) \times 100$$

The gel fraction described above can be controlled by, for example, the monomer composition and weight average molecular weight of the acrylic polymer (A), amount to be used (amount to be added) of the crosslinking agent, and the like. When the pressure-sensitive adhesive composition of the present invention is cured by ultraviolet irradiation, polymerization inhibition is more unlikely to occur because of decrease in carbon-carbon double bonds of the hydrogenated polyolefinic resin (B), and the gel fraction can be prevented from decreasing.

The pressure-sensitive adhesive sheet of the present invention has excellent transparency because of being excellent in compatibility between the acrylic polymer (A) and the hydrogenated polyolefinic resin (B) of the present invention. For this reason, the visibility and appearance through the pressure-sensitive adhesive sheet are excellent. As described above, the pressure-sensitive adhesive sheet of the present invention is suitably used for optical purposes.

The haze of the pressure-sensitive adhesive sheet of the present invention (in accordance with JIS K7136) is, but not particularly limited to, preferably 1.0% or less, more preferably 0.8% or less. A case in which the haze is 1.0% or less is preferable because excellent transparency and excellent appearance can be obtained. The lower limit value of the haze is, but not particularly limited to, theoretically 0%, and may be practically 0.01% or more. The haze described above can be measured, for example, on a specimen made by allowing the pressure-sensitive adhesive sheet to stand under normal conditions (23°C, 50% RH) for at least 24 hours, then, if the layer has a separator, separating the separator, and laminating the layer on slide glass (e.g., one having a total light transmittance of 92% and a haze of 0.2%), by use of a haze meter (manufactured by Murakami Color Research Laboratory Co., Ltd., trade name "HM-150N") or an equivalent thereof.

The total light transmittance in the visible light wavelength region (in accordance with JIS K7361-1) of the pressure-sensitive adhesive sheet of the present invention is, but not particularly limited to, preferably 90% or more, more preferably 91% or more, further preferably 92% or more. A case in which the total light transmittance is 90% or more is preferable because excellent transparency and an excellent appearance can be obtained. The upper limit value of the total light transmittance is, but not particularly limited to, theoretically a value obtained by subtracting the optical loss due to the reflection occurring at the air interface (Fresnel Loss) from 100%, and may be practically 95% or less. The total light transmittance described above can be measured, for example, on a specimen made by allowing the pressure-sensitive adhesive sheet to stand under normal conditions (2°C, 50% RH) for at least 24 hours, then, if the layer has a separator, separating the separator, and laminating the layer on slide glass (e.g., one having a total light transmittance of 92% and a haze of 0.2%), by use of a haze meter (manufactured by Murakami Color Research Laboratory Co., Ltd., trade name "HM-150N") or an equivalent thereof.

The thickness (total thickness) of the pressure-sensitive adhesive sheet of the present invention is, but not particularly limited to, preferably from 12 to 350 μm, more preferably from 12 to 300 um. A case in which the thickness is equal to or larger than a certain thickness is preferable because peeling at a level difference site is more unlikely to occur. A case in which the thickness is equal to or smaller than a certain thickness is preferable in that an excellent appearance is more easily retained during production and storage as a roll and adhesive stains are unlikely to occur during cutting processing. The thickness of the separator is intended not to be included in the thickness of the pressure-sensitive adhesive sheet of the present invention.

The method for producing the pressure-sensitive adhesive sheet having the pressure-sensitive adhesive layer of the present invention is not particularly limited. For example, the pressure-sensitive adhesive layer can be produced by producing the pressure-sensitive adhesive composition of the present invention (precursor composition) and if necessary, conducting irradiation with active energy rays, heat-drying, or the like. Specific examples of the method include a method in which the pressure-sensitive adhesive layer is produced by adding and mixing the hydrogenated polyolefinic resin (B), other additives, and the like to the mixture of monomer components or a partially polymerized product thereof.

[1-1. Acrylic polymer (A)]

The pressure-sensitive adhesive layer of the present invention is an acrylic pressure-sensitive adhesive layer containing the acrylic polymer (A) as the main component. The specific content of the acrylic polymer (A) is, but not particularly limited to, preferably 74% by weight or more (e.g., from 74 to 99.9% by weight), more preferably 84% by weight or more (e.g., from 84 to 99.9% by weight) based on the total amount of the pressure-sensitive adhesive layer of the present invention (total weight, 100% by weight).

Examples of the pressure-sensitive adhesive composition of the present invention that forms the pressure-sensitive adhesive layer containing the acrylic polymer (A) as the main component include, but not particularly limited to, compositions containing the acrylic polymer (A) as an essential component; compositions containing a mixture of monomer components constituting the acrylic polymer (A) (may be referred to as a "monomer mixture") or a partially polymerized product thereof as an essential component. Without particular limitation, examples of the former include so-called water-dispersible compositions (emulsion compositions), and examples of the latter include so-called active energy ray-curable compositions. The pressure-sensitive adhesive composition described above may contain other additives.

The "monomer mixture" described above is intended to include a case in which the mixture is constituted by a single monomer component and a case in which the mixture is constituted by two or more monomer components. The "partially polymerized product" described above means a composition in which one or two or more components of the constituent components of the monomer mixture are partially polymerized. Of these, the pressure-sensitive adhesive composition is preferably a composition containing a monomer mixture or a partially polymerized product thereof as an essential component.

The acrylic polymer (A) is a polymer containing an acrylic monomer as an essential monomer unit (monomer constituent unit). In other words, the acrylic polymer (A) is a polymer containing a constituent unit derived from an acrylic monomer as a constituent unit. That is, the acrylic polymer (A) is a polymer composed (formed) of an acrylic monomer as an essential monomer component. Herein, "(meth)acryl" represents either one or both of "acryl" and" methacryl", and the same applies to the following. The weight average molecular weight of the acrylic polymer (A) is, but not particularly limited to, preferably from 100000 to 5000000.

The acrylic polymer (A) is preferably a polymer containing a (meth)acrylic alkyl ester (A) ((meth)acrylic alkyl ester having a branched-chain alkyl group having 10 to 24 carbon atoms). That is, the acrylic polymer (A) of the present invention is preferably obtained by polymerizing a monomer component containing a (meth)acrylic alkyl ester having a long branched-chain alkyl group, such as a (meth)acrylic alkyl ester (A). A pressure-sensitive adhesive layer having a low dielectric constant can be achieved by the action of the long branched-chain alkyl group, and even in the case of

lamination on a transparent conductive film including a layer of metal wiring such as metal mesh wiring or silver nanowire formed, a malfunction can be prevented because the pressure-sensitive adhesive layer has a low dielectric constant.

In order to lower the dielectric constant, it is conceivably only required to make the dipole moment of the molecule smaller and make the molar volume larger according to the Clausius-Mossotti equation. The (meth)acrylic alkyl ester (A) according to the main monomer unit constituting the acrylic polymer (A) of the present invention as the main component of the pressure-sensitive adhesive layer of the present invention has a long branched-chain alkyl group. Accordingly, in the pressure-sensitive adhesive layer obtained from the pressure-sensitive adhesive composition of the present invention, it is conceived that the molar volume increases and further the dipole moment is lowered because the alkyl group has a branch. As described above, a pressure-sensitive adhesive layer having a balance between the both, such as an increased molar volume and a lowered dipole moment, is considered to be achieved in the case of using the acrylic polymer (A) of the present invention having a branched-chain alkyl group having 10 to 24 carbon atoms as the alkyl group.

The Tg of the homopolymer of the (meth)acrylic alkyl ester (A) (a (meth)acrylic alkyl ester having a branched-chain alkyl group having 10 to 24 carbon atoms) is preferably from -80 to 0°C, further preferably from -70 to -10°C. A Tg of homopolymer of -80°C or less is not preferable because the modulus of elasticity of the pressure-sensitive adhesive layer at normal temperature may decrease excessively, and a case of a Tg exceeding 0°C is not preferable because the adhesive strength may decrease. The Tg of the homopolymer is a value measured with a differential scanning calorimeter (DSC). Although the branched-chain alkyl group has 10 to 24 carbon atoms in the view of satisfying a low dielectric constant and moderate elastic modulus, an alkyl (meth)acrylate having a preferable alkyl group can be selected as appropriate in accordance with a method for producing a (meth)acrylic polymer. For example, when a (meth)acrylic polymer is produced by solution polymerization or the like, the alkyl group has further preferably 10 to 18 carbon atoms, further preferably 10 to 16 carbon atoms, further preferably 10 to 14 carbon atoms. When the acrylic polymer (A) is produced by radiation polymerization or the like, the alkyl group has further preferably 12 to 18 carbon atoms, further preferably 14 to 18 carbon atoms. Even with a Tg of the homopolymer according to the (meth)acrylic alkyl ester of -80 to 0°C, an effect of allowing the pressure-sensitive adhesive layer to have a lower dielectric constant is not large if the alkyl group is linear or has 9 or less carbon atoms.

Examples of the (meth)acrylic alkyl ester (A) can include isodecyl acrylate (number of carbon atoms: 10, Tg of homopolymer = -60°C, hereinafter, simply abbreviated as Tg), isodecyl methacrylate (number of carbon atoms: 10, Tg = -41°C), isomyristyl acrylate (number of carbon atoms: 14, Tg = -56°C), isostearyl acrylate (number of carbon atoms: 18, Tg = -18°C), 2-propylheptyl acrylate, isoundecyl acrylate, isododecyl acrylate, isotridecyl acrylate, isopentadecyl acrylate, isohexadecyl acrylate, isoheptadecyl acrylate, and the methacrylate monomers exemplified. The (meth)acrylic alkyl esters (A) may be used singly or in combination of two or more.

Among the branched-chain alkyl groups having 10 to 24 carbon atoms, ones having a branched-chain alkyl group such as a t-butyl group at the end of the ester group are particularly preferable in that it is considered that the molar volume increases, the dipole moment decreases, and a pressure-sensitive adhesive layer having a balance between the both can be obtained. The ones are preferable also in respect of being excellent in the compatibility to the acrylic polymer (A) and the hydrogenated polyolefinic resin (B) of the present invention. As the branched-chain alkyl group provided at the end of the ester group, branched-chain alkyl groups having 4 to 6 carbon atoms such as a neopentyl group and a t-pentyl group are preferable, and a t-butyl group is particularly preferable. A preferable example of the (meth)acrylic alkyl ester (A) having a t-butyl group at the end of the ester group includes isostearyl acrylate represented by the following formula.

[Formula 1]

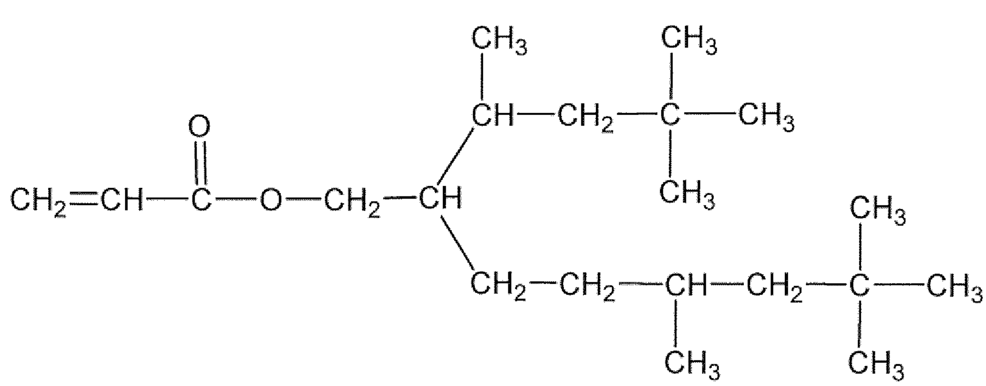

As the (meth)acrylic alkyl ester (A), a methacrylic alkyl ester is more preferable than an acrylic alkyl ester, in respect of the effect of allowing the pressure-sensitive adhesive layer to have a lower dielectric constant due to an increased molar volume and a lowered dipole moment. Meanwhile, an acrylic alkyl ester is more preferable than a methacrylic alkyl ester, in respect that the polymerization time of the acrylic polymer (A) is reduced to enable the productivity to be improved. Particularly when the acrylic polymer (A) of the present invention is cured by radiation polymerization, an acrylic alkyl ester is suitable.

The content (proportion) of the (meth)acrylic alkyl ester (A) described above in the total monomer units of the acrylic polymer (A) (the total amount of the monomer components constituting the acrylic polymer (A)) is, but not particularly limited to, preferably from 3 to 50 parts by weight, more preferably from 10 to 48 parts by weight, further preferably from 20 to 45 parts by weight based on the total amount of the monomer components constituting the acrylic polymer (A) (100 parts by weight). Using 3 parts by weight or more thereof is preferable in respect of lowering the dielectric constant, and using 50 parts by weight or less thereof is preferable in respect of maintaining the adhesive strength and level difference conformability.

The acrylic polymer (A) of the present invention may contain a (meth)acrylic alkyl ester other than the (meth)acrylic alkyl ester (A) (hereinafter, may be referred to as the "(meth)acrylic alkyl ester (B)") as a monomer component. The (meth)acrylic alkyl ester (A) is a monomer component of which the homopolymer has a high Tg. Thus, when the acrylic polymer (A) further contains the (meth)acrylic alkyl ester (B), of which the homopolymer has a Tg lower than that of the (meth)acrylic alkyl ester (A), it is possible to adjust the Tg of the acrylic polymer (A) itself, enhance the stress relaxation properties of the pressure-sensitive adhesive layer of the present invention, and improve the level difference conformability thereof.

Examples of the (meth)acrylic alkyl ester (B) include (meth)acrylic alkyl esters having a linear-chain alkyl group having 1 to 24 carbon atoms and (meth)acrylic alkyl esters having a branched-chain alkyl group having 3 to 9 carbon atoms. In respect of further enhancing the compatibility to the hydrogenated polyolefinic resin (B) and enabling the transparency of the pressure-sensitive adhesive layer of the present invention to be maintained at a higher level, (meth)acrylic alkyl esters having a linear-chain alkyl group having 1 to 24 carbon atoms are preferable. The (meth)acrylic alkyl esters (B) may be used singly or in combination of two or more.

Examples of the (meth)acrylic alkyl ester having a linear-chain alkyl group having 1 to 24 carbon atoms include methyl (meth)acrylate, ethyl (meth)acrylate, propyl (meth)acrylate, butyl (meth)acrylate, (n-butyl (meth)acrylate), pentyl (meth)acrylate, hexyl (meth)acrylate, heptyl (meth)acrylate, octyl (meth)acrylate, nonyl (meth)acrylate, decyl (meth)acrylate, undecyl (meth)acrylate, dodecyl (meth)acrylate, tridecyl (meth)acrylate, tetradecyl (meth)acrylate, pentadecyl (meth)acrylate, hexadecyl (meth)acrylate, heptadecyl (meth)acrylate, octadecyl (meth)acrylate, nonadecyl (meth)acrylate, and eicosyl (meth)acrylate.

Examples of the (meth)acrylic alkyl ester having a branched-chain alkyl group having 3 to 9 carbon atoms include isopropyl (meth)acrylate, isobutyl (meth)acrylate, s-butyl (meth)acrylate, t-butyl (meth)acrylate, isopentyl (meth)acrylate, 2-ethylhexyl (meth)acrylate, isooctyl (meth)acrylate, and isononyl (meth)acrylate.

The Tg of the homopolymer of the (meth)acrylic alkyl ester (B) (a (meth)acrylic alkyl ester other than (meth)acrylic alkyl esters having a branched-chain alkyl group having 10 to 24 carbon atoms) is preferably from - 100 to -30°C, further preferably from -90 to -40°C. A Tg of homopolymer of -100°C or less is not preferable because the elastic modulus of the pressure-sensitive adhesive layer at normal temperature may decrease excessively. In a case of a Tg exceeding -30°C, the stress relaxation properties of the pressure-sensitive adhesive layer may decrease, causing insufficient level difference conformability.

Of these, as the (meth)acrylic alkyl ester (B), in respect of improving the stress relaxation properties of the pressure-sensitive adhesive layer to adjust the level difference conformability, (meth)acrylic alkyl esters having a linear-chain alkyl group having 6 to 18 carbon atoms in the alkyl group and (meth)acrylic alkyl esters having a branched-chain alkyl group having 6 to 9 carbon atoms are preferable, (meth)acrylic alkyl esters having a linear-chain alkyl group having 8 to 14 carbon atoms in the alkyl group and (meth)acrylic alkyl esters having a branched-chain alkyl group having 7 to 9 carbon atoms are more preferable, and 2-ethylhexyl acrylate (branched-chain alkyl having 8 carbon atoms, Tg = -70°C) and lauryl acrylate (linear-chain alkyl having 12 carbon atoms, Tg = -50°C) are particularly preferable.

As the (meth)acrylic alkyl ester (B), a methacrylic alkyl ester is more preferable than an acrylic alkyl ester, in respect of the effect of allowing the pressure-sensitive adhesive layer to have a lower dielectric constant due to an increased molar volume and a lowered dipole moment. Meanwhile, an acrylic alkyl ester is preferable than a methacrylic alkyl ester in respect that the polymerization time of the acrylic polymer (A) is reduced to enable the productivity to be improved. Particularly when the acrylic polymer (A) of the present invention is cured by radiation polymerization, an acrylic alkyl ester is suitable.

The content (proportion) of the (meth)acrylic alkyl ester (B) described above in the total monomer units of the acrylic polymer (A) (the total amount of the monomer components constituting the acrylic polymer (A)) is, but not particularly limited to, preferably from 3 to 50 parts by weight, more preferably from 10 to 48 parts by weight, further preferably from 20 to 45 parts by weight based on the total amount of the monomer components constituting the acrylic polymer

(A) (100 parts by weight). Using 3 parts by weight or more thereof is preferable in respect of maintaining the adhesive strength and level difference conformability, and using 50 parts by weight or less thereof is preferable in respect of lowering the dielectric constant.

The acrylic polymer (A) may contain a monomer that can be copolymerized (copolymerizable monomer) as a monomer unit in addition to the (meth)acrylic alkyl ester (A) and (meth)acrylic alkyl ester (B) described above. That is, the acrylic polymer (A) may contain a copolymerizable monomer as a constituent monomer component. Copolymerizable monomers may be used singly or in combination of two or more.

Preferable examples of the copolymerizable monomer described above include hydroxyl group-containing monomers. When the acrylic polymer (A) contains a hydroxyl group-containing monomer as a monomer unit, polymerization is facilitated on polymerizing the constituent monomer components, and favorable cohesion is more easily obtained. Thus, strong adhesiveness is more easily obtained. Also, excellent foaming and peeling resistance is more easily obtained by increasing the gel fraction. Further, whitening of the pressure-sensitive adhesive sheet, which may occur under a high-humidity environment, is more easily suppressed. Anti-corrosive agents to be mentioned below have selective solubility for monomers. For example, a benzotriazole compound, which is one of the anti-corrosive agents to be mentioned below, has favorable solubility for hydroxyl group-containing monomers.

The content (proportion) of the hydroxyl group-containing monomer described above based on the total amount of the monomer components constituting the acrylic polymer (A) (100 parts by weight) is not particularly limited. When the amount of the hydroxyl group-containing monomer is equal to or larger than a certain amount, in respect of cohesion, adhesiveness and adhesion reliability such as foaming and peeling resistance are more easily obtained. The lower limit of the content of the hydroxyl group-containing monomer described above is preferably 0.1 parts by weight or more, more preferably 0.5 parts by weight or more, further preferably 1 part by weight or more. The upper limit of the content of the hydroxyl group-containing monomer is preferably 25 parts by weight or less, more preferably 23 parts by weight or less, further preferably 21 parts by weight or less in respect that the compatibility to the hydrogenated polyolefinic resin (B) is more easily obtained.

Further, preferable examples of the copolymerizable monomer described above include nitrogen atom-containing monomers and/or alicyclic structure-containing monomers. When the acrylic polymer (A) contains a nitrogen atom-containing monomer and/or an alicyclic structure-containing monomer as a monomer unit, moderate cohesion is more easily obtained. Thus, the 180° (degree) peel adhesive strength to a glass plate and the 180° peel adhesive strength to an acryl plate are increased, and strong adhesiveness is more easily obtained. Also, the gel fraction is increased, and excellent foaming and peeling resistance is more easily obtained. Further, the moderate flexibility is more easily obtained via the pressure-sensitive adhesive layer, and 300% tensile residual stress is adjusted within a specific range to allow excellent stress relaxation properties and excellent level difference conformability to be easily obtained.

The content (proportion) of at least one selected from the nitrogen atom-containing monomer and alicyclic structure-containing monomer described above based on the total amount of the monomer components constituting the acrylic polymer (A) (100 parts by weight) is, but not particularly limited to, preferably 3 parts by weight or more. The lower limit of the content of at least one selected from the nitrogen atom-containing monomer and alicyclic structure-containing monomer described above, in respect of cohesion, adhesiveness, and foaming and peeling resistance, is more preferably 5 parts by weight or more, further preferably 10 parts by weight or more based on the total amount of the monomer components constituting the acrylic polymer (A) (100 parts by weight). The upper limit of the content of at least one selected from the nitrogen atom-containing monomer and alicyclic structure-containing monomer described above is, in respect that moderate flexibility is more easily obtained via the pressure-sensitive adhesive layer and excellent stress relaxation properties and excellent level difference conformability are more easily obtained, preferably 30 parts by weight or less, more preferably 28 parts by weight or less, further preferably 25 parts by weight or less.

The ratio between the nitrogen atom-containing monomer and the alicyclic structure-containing monomer (nitrogen atom-containing monomer/alicyclic structure-containing monomer) contained in the acrylic polymer (A) is not particularly limited, and can be selected as appropriate from the range of 100/0 to 0/100, preferably 95/5 to 5/95, more preferably 90/10 to 10/90.

The acrylic polymer (A) described above can be obtained by polymerizing the monomer unit (monomer component) described above by a known or customary polymerization method. Examples of the method for polymerizing the acrylic polymer (A) include a solution polymerization method, an emulsion polymerization method, a bulk polymerization method, and a polymerization method by an active energy-ray irradiation (active energy-ray polymerization method). Of these, in respect of transparency, water resistance, costs, and the like of the pressure-sensitive adhesive layer, the solution polymerization method and active energy-ray polymerization method are preferable, and the active energy-ray polymerization method is more preferable.

Examples of the active energy rays to be applied in the active energy-ray polymerization (photopolymerization) include ionizing radiation such as an $\alpha$-ray, a $\beta$-ray, a $\gamma$-ray, a neutron ray, and an electron ray, and ultraviolet, and ultraviolet is particularly preferable. The irradiation energy, irradiation time, irradiation method, and the like of the active energy ray are not particularly limited, and it is only required that the reaction of the monomer components can be

generated by activating a photopolymerization initiator.

In polymerization of the acrylic polymer (A), various common solvents may be used. Examples of such solvents include organic solvents such as: esters such as ethyl acetate and n-butyl acetate; aromatic hydrocarbons such as toluene and benzene; aliphatic hydrocarbons such as n-hexane and n-heptane; alicyclic hydrocarbons such as cyclohexane and methylcyclohexane; and ketones such as methyl ethyl ketone and methyl isobutyl ketone. The solvents may be used singly or in combination of two or more.

In polymerization of the acrylic polymer (A), a polymerization initiator such as a thermal polymerization initiator or a photopolymerization initiator (photoinitiator) may be used depending on the type of polymerization reaction. The polymerization initiators may be used singly or in combination of two or more.

Examples of the photopolymerization initiator described above include, but not particularly limited to, benzoin ether photopolymerization initiators, acetophenone photopolymerization initiators, α-ketol photopolymerization initiators, aromatic sulfonyl chloride photopolymerization initiators, photoactive oxime photopolymerization initiators, benzoin photopolymerization initiators, benzyl photopolymerization initiators, benzophenone photopolymerization initiators, ketal photopolymerization initiators, and thioxantone photopolymerization initiators. The photopolymerization initiators may be used singly or in combination of two or more.

Examples of the benzoin ether photopolymerization initiators described above include benzoin methyl ether, benzoin ethyl ether, benzoin propyl ether, benzoin isopropyl ether, benzoin isobutyl ether, 2,2-dimethoxy-1,2-diphenylethane-1-on, and anisole methyl ether. Examples of the acetophenone photopolymerization initiators described above include 2,2-diethoxyacetophenone, 2,2-dimethoxy-2-phenylacetophenone, 1-hydroxycyclohexylphenylketone, 4-phenoxydicycloacetophenone, and 4-(t-butyl)dichloroacetophenone. Examples of the α-ketol photopolymerization initiators described above include 2-methyl-2-hydroxypropiophenone and 1-[4-(2-hydroxyethyl)phenyl]-2-methylpropan-1-one. Examples of the aromatic sulfonyl chloride photopolymerization initiators include 2-naphthalenesulfonyl chloride. Examples of the photoactive oxime photopolymerization initiators described above include 1-phenyl-1,1-propanedion-2-(o-ethoxycarbonyl)-oxime. Examples of the benzoin photopolymerization initiators described above include benzoin. Examples of the benzyl photopolymerization initiators described above include benzyl. Examples of the benzophenone photopolymerization initiators described above include benzophenone, benzoyl benzoate, 3,3'-dimethyl-4-methoxybenzophenone, polyvinyl benzophenone, and α-hydroxycyclohexyl phenyl ketone. Examples of the ketal photopolymerization initiators described above include benzyl dimethyl ketal. Examples of the thioxantone photopolymerization initiators described above include thioxantone, 2-chlorothioxantone, 2-methylthioxantone, 2,4-dimethylthioxantone, isopropylthioxantone, 2,4-diisopropylthioxantone, and dodecylthioxantone.

The amount of the photopolymerization initiator described above to be used is, but not particularly limited to, for example, preferably from 0.001 to 1 part by weight, more preferably from 0.01 to 0.50 parts by weight based on 100 parts by weight of the total monomer units of the acrylic polymer (A) (the total amount of the monomer components constituting the acrylic polymer (A)).

Examples of the thermal polymerization initiator include, but not particularly limited to, azo polymerization initiators, peroxide polymerization initiators (e.g., dibenzoyl peroxide and tert-butyl permaleate), and redox polymerization initiators. Of these, preferable are the azo polymerization initiators disclosed in Japanese Patent Laid-Open No. 2002-69411. Examples of the azo polymerization initiators described above include 2,2'-azobisisobutyronitrile (hereinafter, may be referred to as "AIBN"), 2,2'-azobis-2-methylbutyronitrile (hereinafter, may be referred to as "AMBN"), dimethyl 2,2'-azobis(2-2-methylpropionate), and 4,4'-azobis-4-cyanovaleric acid.

The amount of the thermal polymerization initiator described above to be used is, but not particularly limited to, for example, in the case of the azo polymerization initiator described above, preferably from 0.05 to 0.5 parts by weight, more preferably from 0.1 to 0.3 parts by weight based on 100 parts by weight of the total monomer units of the acrylic polymer (A) (the total amount of the monomer components constituting the acrylic polymer (A)).

[1-2. Carboxyl group-containing monomer and the like]

The pressure-sensitive adhesive layer of the present invention is preferably substantially free of a carboxyl group-containing monomer as a monomer component constituting the acrylic polymer (A). The phrase "substantially free of" herein refers to actively formulating no carboxyl group-containing monomer except when a carboxyl group-containing monomer is inevitably mixed. The carboxyl group-containing monomer means a monomer having at least one carboxyl group in the molecule. From the viewpoint that a superior corrosion prevention effect can be obtained, specifically, ones in which the content of the carboxyl group-containing monomer is preferably 0.05 parts by weight or less (e.g., from 0 to 0.05 parts by weight), more preferably 0.01 parts by weight or less (e.g., from 0 to 0.01 parts by weight), further preferably 0.001 parts by weight or less (e.g., from 0 to 0.001 parts by weight) based on the total amount of the monomer components constituting the acrylic polymer (A) (100 parts by weight) can be said to be substantially free of a carboxyl group-containing monomer. Examples of the carboxyl group-containing monomer described above include (meth)acrylic acid, itaconic acid, maleic acid, fumaric acid, crotonic acid, and isocrotonic acid. In the carboxyl

group-containing monomers described above, acid anhydride group-containing monomers such as maleic anhydride and itaconic anhydride are also included.

Further, from the viewpoint that a superior corrosion prevention effect can be obtained, the pressure-sensitive adhesive layer of the present invention is not only substantially free of a carboxyl group-containing monomer as a monomer component constituting the acrylic polymer (A), but also preferably substantially free of a monomer having an acidic group other than a carboxyl group (sulfo group, phosphate group, or the like) as a monomer component constituting the acrylic polymer (A). That is, the acrylic polymer (A) is preferably substantially free of any of carboxyl group-containing monomers and monomers having an acidic group other than a carboxyl group, as a constituent monomer component. Specifically, ones in which the total amount of the carboxyl group-containing monomer and monomers having an acidic group other than a carboxy group as monomer components constituting the acrylic polymer (A) is preferably 0.05 parts by weight or less (e.g., from 0 to 0.05 parts by weight), more preferably from 0.01 parts by weight or less (e.g., from 0 to 0.01 parts by weight), further preferably 0.001 parts by weight or less (e.g., from 0 to 0.001 parts by weight) based on the total amount of the monomer components constituting the acrylic polymer (A) (100 parts by weight) can be said to be substantially free of a carboxyl group-containing monomer and monomers having an acidic group other than a carboxy group.

The pressure-sensitive adhesive layer of the present invention is preferably free of or substantially free of an acidic group-containing monomer as a monomer component constituting a polymer other than the acrylic polymer (A), from the similar viewpoint. For example, the pressure-sensitive adhesive composition of the present invention is preferably substantially free of a carboxyl group-containing monomer. The meaning of "substantially free of", a preferable extent, monomers having an acidic group other than a carboxyl group, and the like are the same as in the case of the monomer component constituting the acrylic polymer (A).

[1-3. Basic group-containing monomer]

The pressure-sensitive adhesive layer of the present invention is preferably free of or substantially free of a basic group-containing monomer as a monomer component constituting the acrylic polymer (A). The respect in that being substantially free of a basic group-containing monomer also as a monomer component constituting a polymer other than the acrylic polymer (A) is preferable and being substantially free of a basic group-containing monomer in the pressure-sensitive adhesive layer described above is preferable even when the monomer is not a monomer component constituting various monomers is the same as in the case of the carboxyl group-containing monomer. The meaning of "substantially free of", a preferable extent, and the like are also the same.

[1-4. Hydroxyl group-containing monomer]

A hydroxyl group-containing monomer means a monomer having at least one hydroxyl group in the molecule. A monomer having at least one hydroxyl group in the molecule and having at least one carboxyl group in the molecule is a carboxyl group-containing monomer and is intended not to be a hydroxyl group-containing monomer. Specific examples of the hydroxyl group-containing monomer described above include, but not particularly limited to, hydroxyl group-containing (meth)acrylic esters such as 2-hydroxyethyl (meth)acrylate, 2-hydroxypropyl (meth)acrylate, 2-hydroxybutyl (meth)acrylate, 3-hydroxypropyl (meth)acrylate, 4-hydroxybutyl (meth)acrylate, 6-hydroxyhexyl (meth)acrylate, hydroxyoctyl (meth)acrylate, hydroxydecyl (meth)acrylate, hydroxylauryl (meth)acrylate, and (4-hydroxymethylcyclohexyl) (meth)acrylate; vinyl alcohol, and allyl alcohol. Of these, as the hydroxyl group-containing monomer described above, hydroxyl group-containing (meth)acrylic esters are preferable, and 2-hydroxyethyl acrylate (HEA), 2-hydroxypropyl (meth)acrylate (HPA), and 4-hydroxybutyl acrylate (4HBA) are more preferable, from the viewpoint that favorable cohesion is more easily obtained and adhesion reliability at high temperatures is more easily obtained. The hydroxyl group-containing monomers may be used singly or in combination of two or more.

[1-5. Nitrogen atom-containing monomer]

A nitrogen atom-containing monomer means a monomer having at least one nitrogen atom in the molecule (in one molecule). However, the nitrogen atom-containing monomer described above is intended not to be included in the hydroxyl group-containing monomers described above. That is, herein, a monomer having a hydroxyl group and a nitrogen atom in the molecule is intended to be included in the nitrogen atom-containing monomer. A monomer having at least one nitrogen atom in the molecule and having at least one carboxyl group in the molecule is intended to be a carboxyl group-containing monomer and not to be a nitrogen atom-containing monomer.

As the nitrogen atom-containing monomer described above, from the viewpoint of improving foaming and peeling resistance, N-vinyl cyclic amides, (meth)acrylamides, and the like are preferable. The nitrogen atom-containing monomers may be used singly or in combination of two or more.

As the N-vinyl cyclic amide described above, N-vinyl cyclic amides represented by the following formula (1) are preferable from the viewpoint that favorable cohesion is more easily obtained and adhesion reliability at high temperatures is more easily obtained.

[Formula 2]

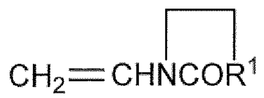 (1)

In formula (1), $R^1$ represents a divalent organic group.

$R^1$ in the above formula (1) is a divalent organic group, preferably a divalent saturated hydrocarbon group or unsaturated hydrocarbon group, more preferably a divalent saturated hydrocarbon group (e.g., an alkylene group having 3 to 5 carbon atoms).

The N-vinyl cyclic amide represented by the above formula (1) is preferably N-vinyl-2-pyrrolidone (NVP), N-vinyl-2-piperidone, N-vinyl-2-caprolactam, N,N-dimethyl (meth)acrylamide, N,N-diethyl (meth)acrylamide, N-vinyl-3-morpholinone, N-vinyl-1,3-oxazin-2-one, N-vinyl-3,5-morpholine dione, or the like, more preferably N-vinyl-2-pyrrolidone, N-vinyl-2-caprolactam, N,N-dimethyl (meth)acrylamide, and N,N-diethyl (meth)acrylamide, further preferably N-vinyl-2-pyrrolidone, from the viewpoint of further improving the foaming and peeling resistance and the compatibility of the benzotriazole compound.

Examples of the (meth)acrylamides include (meth)acrylamide, N-alkyl (meth)acrylamides, and N,N-dialkyl (meth)acrylamides. Examples of the N-alkyl(meth)acrylamides described above include N-ethyl(meth)acrylamide, N-isopropyl(meth)acrylamide, N-n-butyl(meth)acrylamide, and N-octylacrylamide. Further, (meth)acrylamides having an amino group such as dimethylaminoethyl(meth)acrylamide, diethylaminoethyl(meth)acrylamide, and dimethylaminopropyl(meth)acrylamide are also included in the N-alkyl(meth)acrylamides. Examples of the N,N-dialkyl(meth)acrylamides described above include N,N-dimethyl(meth)acrylamide, N,N-diethyl(meth)acrylamide, N,N-dipropyl(meth)acrylamide, N,N-diisopropyl(meth)acrylamide, N,N-di(n-butyl)(meth)acrylamide, and N,N-di(t-butyl)(meth)acrylamide.

In the (meth)acrylamides described above, various N-hydroxyalkyl(meth)acrylamide, for example, are also included. Examples of the N-hydroxyalkyl(meth)acrylamide described above include N-methylol(meth)acrylamide, N-(2-hydroxyethyl)(meth)acrylamide, N-(2-hydroxypropyl)(meth)acrylamide, N-(1-hydroxypropyl)(meth)acrylamide, N-(3-hydroxypropyl)(meth)acrylamide, N-(2-hydroxybutyl)(meth)acrylamide, N-(3-hydroxybutyl)(meth)acrylamide, N-(4-hydroxybutyl)(meth)acrylamide, and N-methyl-N-2-hydroxyethyl(meth)acrylamide.

In the (meth)acrylamides described above, various N-alkoxyalkyl(meth)acrylamides, for example, are also included. Examples of the N-alkoxyalkyl(meth)acrylamide described above include N-methoxymethyl(meth)acrylamide and N-butoxymethyl(meth)acrylamide.

Examples of nitrogen atom-containing monomers other than the N-vinyl cyclic amides and (meth)acrylamides described above include amino group-containing monomers such as aminoethyl(meth)acrylate, dimethylaminoethyl(meth)acrylate, dimethylaminopropyl(meth)acrylate, and t-butylaminoethyl(meth)acrylate; cyano group-containing monomers such as acrylonitrile and methacrylonitrile; heterocycle-containing monomers such as (meth)acryloylmorpholine, N-vinylpiperazine, N-vinylpyrrole, N-vinylimidazole, N-vinylpyrazine, N-vinylmorpholine, N-vinylpyrazole, vinylpyridine, vinylpyrimidine, vinyloxazole, vinylisooxazole, vinylthiazole, vinylisothiazole, vinylpyridazine, (meth)acryloylpyrrolidone, (meth)acryloylpyrrolidine, (meth)acryloylpiperidine, and N-methylvinylpyrrolidone; imide group-containing monomers, such as maleimide monomers such as N-cyclohexylmaleimide, N-isopropylmaleimide, N-laurylmaleimide, and N-phenylmaleimide, itaconimide monomers such as N-methylitaconimide, N-ethylitaconimide, N-butylitaconimide, N-octylitaconimide, N-2-ethylhexylitaconimide, N-laurylitaconimide, and N-cyclohexylitaconimide, and succinimide monomers such as N-(meth)acryloyloxymethylene succinimide, N-(meth)acryloyl-6-oxyhexamethylene succinimide, and N-(meth)acryloyl-8-oxyoctamethylene succinimide; and isocyanate group-containing monomers such as 2-(meth)acryloyloxyethyl isocyanate.

When the acrylic polymer (A) described above contains the nitrogen atom-containing monomer described above as a monomer component constituting the polymer, the proportion of the nitrogen atom-containing monomer in the total monomer components constituting the acrylic polymer (A) (100 parts by weight) is, but not particularly limited to, preferably 1 part by weight or more, more preferably 3 parts by weight or more, further preferably 5 parts by weight or more. The proportion described above of 1 part by weight or more is preferable from the viewpoint that favorable cohesion is more easily obtained and adhesion reliability at high temperatures is more easily obtained. Further, the proportion of this value is preferable because suppression of clouding under a high-humidity environment and durability are more improved, and higher adhesion reliability to metal mesh wiring or a silver nanowire layer can be obtained. The upper limit of the

proportion of the nitrogen atom-containing monomer described above is preferably 30 parts by weight or less, more preferably 25 parts by weight or less, further preferably 20 parts by weight or less, in respect that a pressure-sensitive adhesive layer having moderate flexibility is obtained and that a pressure-sensitive adhesive layer excellent in transparency is obtained.

[1-6. Alicyclic structure-containing monomer]

An alicyclic structure-containing monomer means a monomer that has a polymerizable functional group having an unsaturated double bond such as a (meth)acryloyl group, a vinyl group, or the like and has an alicyclic structure. For example, (meth)acrylic alkyl esters having a cycloalkyl group are included in the alicyclic structure-containing monomers described above. However, a monomer having at least one alicyclic structure in the molecule and having at least one carboxyl group in the molecule is a carboxyl group-containing monomer and is intended not to be an alicyclic structure-containing monomer. The alicyclic structure-containing monomers may be used singly or in combination of two or more.

The alicyclic structure in the alicyclic structure-containing monomer described above is preferably a cyclic hydrocarbon structure, and has preferably 5 or more carbon atoms, more preferably 6 to 24 carbon atoms, further preferably 6 to 15 carbon atoms, particularly preferably 6 to 10 carbon atoms.

Examples of the alicyclic structure-containing monomer described above include (meth)acrylic monomers such as cyclopropyl (meth)acrylate, cyclobutyl (meth)acrylate, cyclopentyl (meth)acrylate, cyclohexyl (meth)acrylate, 3,3,5-trimethylcyclohexyl (meth)acrylate, cycloheptyl (meth)acrylate, cyclooctyl (meth)acrylate, isobornyl (meth)acrylate, dicyclopentanyl (meth)acrylate, HPMPA represented by the following formula (2), TMA-2 represented by the following formula (3), and HCPA represented by the following formula (4). In the following formula (4), the point of attachment at which the cyclohexyl ring and the structural formula in the parentheses are joined with a line is not particularly limited. Of these, isobornyl (meth)acrylate, cyclohexyl (meth)acrylate, and 3,3,5-trimethylcyclohexyl (meth)acrylate are preferable.

[Formula 3]

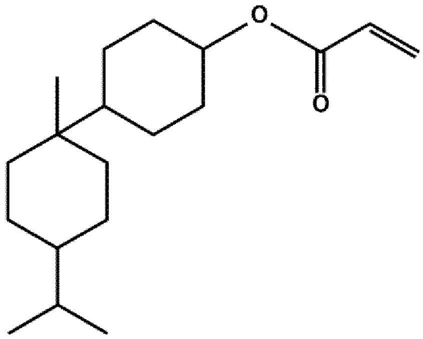

(2)

[Formula 4]

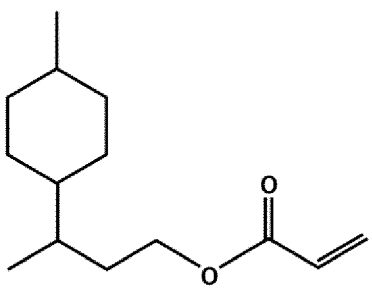

(3)

[Formula 5]

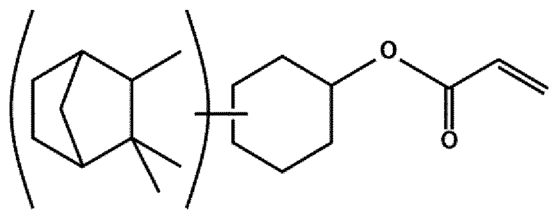

(4)

When the acrylic polymer (A) described above contains the alicyclic structure-containing monomer as a monomer component constituting the polymer, the proportion of the alicyclic structure-containing monomer in the total monomer components constituting the acrylic polymer (A) (100 parts by weight) is, but not particularly limited to, preferably 3 parts by weight or more, more preferably 10 parts by weight or more, in respect of improving durability and obtaining higher adhesion reliability to metal mesh wiring and a silver nanowire layer. The upper limit of the proportion of the alicyclic structure-containing monomer described above is preferably 50 parts by weight or less, more preferably 40 parts by weight or less, further preferably 30 parts by weight or less, in respect that a pressure-sensitive adhesive layer having moderate flexibility is obtained.

[1-7. Other copolymerizable monomers]

Examples of the copolymerizable monomer in the acrylic polymer (A) include, in addition to the nitrogen atom-containing monomers, hydroxyl group-containing monomers, and alicyclic structure-containing monomers described above, (meth)acrylic alkoxyalkyl esters [e.g., 2-methoxyethyl (meth)acrylate, 2-ethoxyethyl (meth)acrylate, methoxytriethyleneglycol (meth)acrylate, 3-methoxypropyl (meth)acrylate, 3-ethoxypropyl (meth)acrylate, 4-methoxybutyl (meth)acrylate, and 4-ethoxybutyl (meth)acrylate]; epoxy group-containing monomers [e.g., glycidyl (meth)acrylate and methylglycidyl (meth)acrylate]; sulfonic acid group-containing monomers [e.g., sodium vinylsulfonate]; phosphate group-containing monomers; (meth)acrylic esters having an aromatic hydrocarbon group [e.g., phenyl (meth)acrylate, phenoxyethyl (meth)acrylate, and benzyl (meth)acrylate]; vinyl esters [e.g., vinyl acetate and vinyl propionate]; aromatic vinyl compounds [e.g., styrene and vinyl toluene]; olefins or dienes [e.g., ethylene, propylene, butadiene, isoprene, and isobutylene]; vinyl ethers [e.g., vinyl alkyl ether]; and vinyl chloride.

[1-8. Hydrogenated polyolefinic resin (B)]

The pressure-sensitive adhesive layer of the present invention is an acrylic pressure-sensitive adhesive layer in which the acrylic polymer (A) is the main component and the hydrogenated polyolefinic resin (B) exhibiting liquid flowability at 25°C is formulated. The phrase "the hydrogenated polyolefinic resin (B) exhibits liquid flowability at 25°C" means that the viscosity measured at 25°C with a B-type viscometer is 10,000 mPa·s or less. The hydrogenated polyolefinic resins (B) may be used singly or in combination of two or more.

The hydrogenated polyolefinic resin (B) is a material having a low dielectric constant and exhibits liquid flowability at 25°C (room temperature). Thus, by formulating the hydrogenated polyolefinic resin (B) to the acrylic polymer (A) of the present invention, the stress relaxation properties of the pressure-sensitive adhesive layer of the present invention is improved to enable the level difference conformability to be enhanced while the adhesive strength and adhesion reliability at high temperatures are maintained, without increasing the dielectric constant and without requiring lowering the molecular weight of the acrylic polymer (A). The hydrogenated polyolefinic resin (B) is also excellent in the compatibility to the acrylic polymer (A) and thus preferable in that the transparency of the pressure-sensitive adhesive layer of the present invention can be maintained at a higher level.

The hydrogenated polyolefinic resin (B) is obtained by reducing carbon-carbon double bonds included in a polyolefinic resin by a hydrogenation reaction. The hydrogenated polyolefinic resin (B), of which carbon-carbon double bonds in the molecular have been reduced, is unlikely to cause inhibition of polymerization in curing the pressure-sensitive adhesive layer of the present invention with ultraviolet irradiation, for example, to thereby be unlikely to cause decrease in polymerization ratio and lowering of the molecular weight, thus enabling the adhesion reliability of the pressure-sensitive adhesive layer of the present invention at high temperatures to be maintained at a high level.

The hydrogenation ratio of the hydrogenated polyolefinic resin (B) is preferably 90% or more, more preferably 95% or more, further preferably 97% or more, from the viewpoint of making inhibition of polymerization unlikely to occur and of the adhesion reliability at high temperatures. The upper limit value of the hydrogenation ratio is, but not particularly limited to, theoretically 100% and may be practically 99.9% or less or may be 99.8% or less. The hydrogenation ratio of

the hydrogenated polyolefinic resin (B) can be determined by quantifying the amount of double bonds remaining in the hydrogenated polyolefinic resin (B) by $^1$H-NMR measurement or the like.

The iodine value (I g/100 g) of the hydrogenated polyolefinic resin (B) is preferably 30 or less, more preferably 25 or less, further preferably 20 or less, from the viewpoint of making inhibition of polymerization unlikely to occur and of the adhesion reliability at high temperatures. The lower limit value of the iodine value, but not particularly limited to, may be 0.1 or more or may be 0.2 or more. The iodine value is a value as measured in accordance with JIS K 0070-1992.

The number average molecular weight (Mn) of the hydrogenated polyolefinic resin (B) is preferably from 1000 to 5000 in respect of imparting moderate stress relaxation properties and flowability to the pressure-sensitive adhesive layer and improving the compatibility to the acrylic polymer (A). The number average molecular weight (Mn) is preferably 1000 or more, more preferably 1500 or more, further preferably 1800 or more, in respect that moderate stress relaxation properties and flowability can be imparted to the pressure-sensitive adhesive layer. The number average molecular weight (Mn) is preferably 5000 or less, more preferably 4800 or less, further preferably 4600 or less, in respect of improving the compatibility to the acrylic polymer (A) and enabling the transparency of the pressure-sensitive adhesive layer of the present invention to be maintained at a higher level.

The polydispersity (Mw/Mn) of the hydrogenated polyolefinic resin (B) is preferably 2.0 or less, 1.8 or less, in respect of imparting moderate stress relaxation properties and flowability to the pressure-sensitive adhesive layer, improving the compatibility to the acrylic polymer (A), maintaining high-level transparency, and enabling haze to be suppressed. The lower limit value of the polydispersity, but not particularly limited to, may be practically 1.0 or may be 1.1 or more.

The number average molecular weight (Mn) and polydispersity (Mw/Mn) of the hydrogenated polyolefinic resin (B) are values determined by measurement by gel permeation chromatography (GPC) in terms of polystyrene standard.

As the hydrogenated polyolefinic resin (B), a hydrogenated polyolefin, a hydrogenated polyolefin polyol, or the like is included. The hydrogenated polyolefin and hydrogenated polyolefin polyol may be each used singly or may be used in combination.

The hydrogenated polyolefin described above is a hydrogenated product of a polymer having a constituent unit derived from an olefin (polyolefin). Examples of the hydrogenated polyolefin include hydrogenated products of homopolymers and copolymers of α-olefins such as ethylene, propylene, 1-butene, isobutene, and 1-hexene; diene compounds such as butadiene and isoprene; and aromatic vinyl compounds such as styrene. As the hydrogenated polyolefin, a hydrogenated product of a homopolymer or copolymer of a diene compound is preferable, and examples thereof include hydrogenated polybutadiene and hydrogenated polyisoprene.

The hydrogenated polyolefin polyol described above is a compound in which an end of the hydrogenated polyolefin is modified with a hydroxyl group. As the hydrogenated polyolefin polyol, a hydroxyl group-modified product of a hydrogenated product of a homopolymer or copolymer of a diene compound is preferable, and examples thereof include hydrogenated polybutadiene polyol and hydrogenated polyisoprene polyol.

As the hydrogenated polyolefinic resin (B), in respect of imparting moderate stress relaxation properties and flowability to the pressure-sensitive adhesive layer and improving the compatibility to the acrylic polymer (A), a hydrogenated polybutadiene and/or a hydrogenated polybutadiene polyol are/is preferable. The hydrogenated polybutadiene and hydrogenated polybutadiene polyol may be each used singly or may be used in combination.

As the hydrogenated polybutadiene, one represented by the following formula (5) is preferable, and as the hydrogenated polybutadiene polyol, one represented by the following formula (6) is preferable.

[Formula 6]

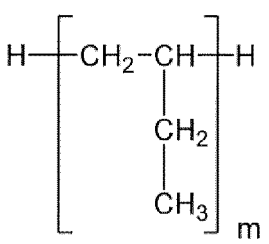

(5)

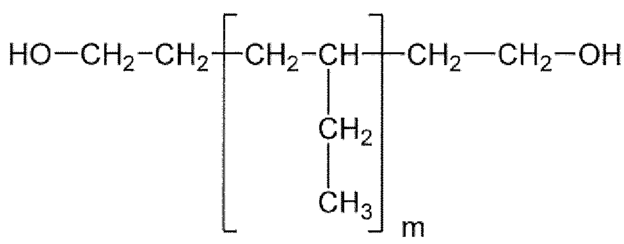

(6)

In the above formulas, m represents the degree of polymerization of the hydrogenated polybutadiene.

As hydrogenated polyolefinic resin (B), a commercially available product can be used. Examples commercially available products of the hydrogenated polyolefinic resin (B) include trade names "GI-1000", "GI-2000", "GI-3000", "BI-2000", and "BI-3000" (all manufactured by Nippon Soda Co., Ltd.) and trade name "EPOL" (manufactured by Idemitsu Kosan Co., Ltd.).

The content of the hydrogenated polyolefinic resin (B) in the pressure-sensitive adhesive layer is, but not particularly limited to, for example, preferably from 3 to 35 parts by weight, more preferably from 5 to 33 parts by weight, further preferably from 8 to 30 parts by weight based on 100 parts by weight of the acrylic polymer (A). A case in which the content of the hydrogenated polyolefinic resin (B) is 3 parts by weight or more is preferable in that excellent level difference absorptivity can be imparted to the pressure-sensitive adhesive layer. Meanwhile, a case in which the content of the hydrogenated polyolefinic resin (B) is 35 parts by weight or less is preferable in that the gel fraction of the pressure-sensitive adhesive layer of the present invention is enhanced, cuttability (stains at ends) during cutting processing is prevented, and adhesive strength and adhesion reliability at high temperatures can be maintained at a high level. The case is preferable also in that process soiling caused by soil at cut ends of the pressure-sensitive adhesive layer is prevented to thereby enhance the handleability.

[1-9. Polyfunctional (meth)acrylate]

The pressure-sensitive adhesive layer of the present invention preferably further contains a polyfunctional (meth)acrylate. The polyfunctional (meth)acrylate serves as a crosslinking component. Then, the pressure-sensitive adhesive layer has moderate cohesion, and the pressure-sensitive adhesive strength and level difference absorptivity are easily enhanced.

Examples of the polyfunctional (meth)acrylate include hexanediol di(meth)acrylate, butanediol di(meth)acrylate, (poly)ethylene glycol di(meth)acrylate, (poly)propylene glycol di(meth)acrylate, neopentyl glycol di(meth)acrylate, pentaerythritol di(meth)acrylate, pentaerythritol tri(meth)acrylate, dipentaerythritol hexa(meth)acrylate, trimethylpropane tri(meth)acrylate, tetramethylolmethane tri(meth)acrylate, allyl (meth)acrylate, vinyl (meth)acrylate, divinylbenzene, epoxy acrylate, polyester acrylate, and urethane acrylate. The polyfunctional (meth)acrylates may be used singly or in combination of two or more.

The content (proportion) of the polyfunctional (meth)acrylate is, but not particularly limited to, preferably from 0.001 to 0.5 parts by weight, more preferably from 0.001 to 0.35 parts by weight, further preferably from 0.002 to 0.2 parts by weight based on 100 parts by weight of the acrylic polymer (A). A case in which the content of the polyfunctional (meth)acrylate is 0.001 parts by weight or more is preferable because the pressure-sensitive adhesive layer has moderate cohesion and the pressure-sensitive adhesive strength and level difference absorptivity are easily enhanced. A case in which the content of the polyfunctional (meth)acrylate is 0.5 parts by weight or less is preferable because changes in the physical properties over time due to unreacted crosslink points and corrosion are more unlikely to occur.

[1-10. Anti-corrosive agent]

The pressure-sensitive adhesive layer of the present invention preferably further contains an anti-corrosive agent. A case in which in an anti-corrosive agent is contained in the pressure-sensitive adhesive layer is preferable in that an excellent corrosion prevention effect on metal wiring such as metal mesh wiring and silver nanowire can be obtained.

An anti-corrosive agent is a compound that prevents rust and corrosion of metal. Examples of the anti-corrosive agent, include but not particularly limited to, amine compounds, benzotriazole compounds, and nitrites. Other examples thereof include ammonium benzoate, ammonium phthalate, ammonium stearate, ammonium palmitate, ammonium oleate, ammonium carbonate, dicyclohexylamine benzoate, urea, urotropin, thiourea, phenyl carbamate, and cyclohexylammonium-N-cyclohexyl carbamate (CHC). The anti-corrosive agents may be used singly or in combination of two or more.

Examples of the amine compounds include hydroxy group-containing amine compounds such as 2-amino-2-methyl-1-propanol, monoethanolamine, monoisopropanolamine, diethylethanolamine, ammonia, and aqueous ammonia; cyclic amines such as cyclic morpholine; cyclic alkylamine compounds such as cyclohexylamine; and linear-chain alkylamines such as 3-methoxypropylamine. Examples of the nitrites include dicyclohexyl ammonium nitrite (DICHAN), diisopropyl ammonium nitrite (DIPAN), sodium nitrite, potassium nitrite, and calcium nitrite.

The content of the anti-corrosive agent is, but not particularly limited to, from 0.02 to 15 parts by weight based on 100 parts by weight of the acrylic polymer (A). A case in which the content is 0.02 parts by weight or more is preferable because favorable corrosion prevention performance is more easily obtained. Meanwhile, a case in which the content is less than 15 parts by weight is preferable because transparency is more easily ensured and adhesion reliability such as foaming and peeling resistance is more easily ensured.

Of these, the anti-corrosive agent is preferably a benzotriazole compound in respect of compatibility to the acrylic polymer (A) and transparency, and further in case in which the acrylic polymer (A) is allowed to react after addition thereof, in respect of difficulty in inhibition of the reaction (crosslinking and polymerization). Particularly, in respect that properties such as adhesion reliability, transparency, and corrosion prevention properties can be obtained in a well-balanced manner at a high level and in respect of excellent appearance properties can be obtained, the anti-corrosive agent is preferably a benzotriazole compound.

The content of the benzotriazole compound is, but not particularly limited to, preferably from 0.02 to 3 parts by weight, more preferably from 0.02 to 2.5 parts by weight, further from preferably 0.02 to 2 parts by weight based on 100 parts by weight of the acrylic polymer (A). Since the content of the benzotriazole compound is equal to or smaller than a certain content, adhesion reliability such as foaming and peeling resistance is securely ensured and additionally, the haze of the pressure-sensitive adhesive sheet also can be securely prevented from increasing.

The benzotriazole compound is not particularly limited as long as being a compound having a benzotriazole skeleton, and having a structure represented by the following formula (7) is preferable from the viewpoint that a more excellent corrosion prevention effect can be obtained.

[Formula 7]

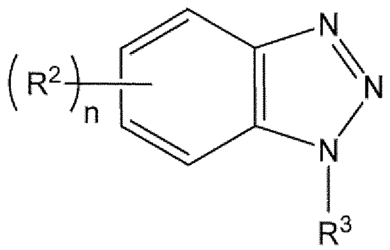

(7)

In the above formula (7), $R^2$ and $R^3$ are the same or different, $R^2$, which is a substituent on the benzene ring, represents a substituent such as an alkyl group having 1 to 6 carbon atoms, an alkoxy group having 1 to 6 carbon atoms, an aryl group having 6 to 14 carbon atoms, an amino group, a mono- or di-$C_{1-10}$ alkylamino group, an amino-$C_{1-6}$ alkyl group, a mono- or di-$C_{1-10}$ alkylamino-$C_{1-6}$ alkyl group, a mercapto group, an alkoxycarbonyl group having 1 to 6 carbon atoms, or an alkoxy group having 1 to 6 carbon atoms, n is an integer of 0 to 4, when n is 2 or more, n R's may be the same or different, and $R^3$ represents a substituent such as a hydrogen atom, an alkyl group having 1 to 12 carbon atoms, an alkoxy group having 1 to 12 carbon atoms, an aryl group having 6 to 14 carbon atoms, an amino group, a mono- or di-$C_{1-10}$ alkylamino group, an amino-$C_{1-6}$ alkyl group, a mono- or di-$C_{1-10}$ alkylamino-$C_{1-6}$ alkyl group, a mercapto group, an alkoxycarbonyl group having 1 to 12 carbon atoms, or an alkoxy group having 1 to 12 carbon atoms.

From the viewpoint that a more excellent corrosion prevention effect can be obtained, $R^2$ is preferably an alkyl group having 1 to 3 carbon atoms, an alkoxycarbonyl group, or the like, more preferably a methyl group or the like. n is preferably 0 or 1.

From the similar viewpoint, $R^3$ is preferably a hydrogen atom, a mono- or di-$C_{1-10}$ alkylamino-$C_{1-6}$ alkyl group, or the like, more preferably a hydrogen atom, a di-$C_{1-8}$ alkylamino-$C_{1-4}$ alkyl group, or the like.

[1-11. Silane coupling agent]

The pressure-sensitive adhesive layer of the present invention preferably further contains a silane coupling agent. A case in which a silane coupling agent is contained in the pressure-sensitive adhesive layer is preferable in that excellent adhesiveness to glass (particularly, excellent adhesion reliability to glass at high temperatures and high humidity) is more easily obtained.

Examples of the silane coupling agent described above include, but not particularly limited to, γ-glycidoxypropyltrimethoxysilane, γ-glycidoxypropyltriethoxysilane, γ-aminopropyltrimethoxysilane, and N-phenyl-aminopropyltrimethoxysilane. Of these, γ-glycidoxypropyltrimethoxysilane is preferable. Further examples of the silane coupling agent include commercially available products such as trade name "KBM-403" (manufactured by Shin-Etsu Chemical Co., Ltd.). The silane coupling agents may be used singly or in combination of two or more.

The content of the silane coupling agent described above is, but not particularly limited to, preferably from 0.01 to 1 part by weight, more preferably from 0.03 to 0.5 parts by weight based on 100 parts by weight of the acrylic polymer (A), in respect of improving the adhesion reliability to glass.

[1-12. Antioxidant]

The pressure-sensitive adhesive layer of the present invention preferably further contains an antioxidant. A case in which an antioxidant is contained in the pressure-sensitive adhesive layer is preferable for preventing oxidative degradation during storage of the pressure-sensitive adhesive sheet.

An antioxidant can prevent inhibition by oxygen of radicals generated from a radical generator to ensure a stable gel fraction (degree of crosslinking) and also can increase the gel fraction while suppressing increase in the release strength of a release film (separator) applied on the pressure-sensitive adhesive layer.

Examples of the antioxidant include phenolic, phosphorus, sulfuric, and amine antioxidants, and at least any one selected from these is used. Of these, phenolic antioxidants are preferable. The antioxidants may be used singly or in combination of two or more.

Specific examples of the phenolic antioxidant include monocyclic phenol compounds such as 2,6-di-t-butyl-p-cresol, 2,6-di-t-butyl-4-ethylphenol, 2,6-dicyclohexyl-4-methylphenol, 2,6-diisopropyl-4-ethylphenol, 2,6-di-t-amyl-4-methylphenol, 2,6-di-t-octyl-4-n-propylphenol, 2,6-dicyclohexyl-4-n-octylphenol, 2-isopropyl-4-methyl-6-t-butylphenol, 2-t-butyl-4-ethyl-6-t-octylphenol, 2-isobutyl-4-ethyl-6-t-hexylphenol, 2-cyclohexyl-4-n-butyl-6-isopropylphenol, styrenated mixed cresol, DL-$\alpha$-tocopherol, and stearyl $\beta$-(3,5-di-t-butyl-4-hydroxyphenyl) propionate; bicyclic phenol compounds such as 2,2'-methylenebis(4-methyl-6-t-butylphenol), 4,4'-butylidenebis(3-methyl-6-t-butylphenol), 4,4'-thiobis(3-methyl-6-t-butylphenol), 2,2'-thiobis(4-methyl-6-t-butylphenol), 4,4'-methylenebis(2,6-di-t-butylphenol), 2,2'-methylenebis[6-(1-methylcyclohexyl)-p-cresol], 2,2'-ethylidenebis(4,6-di-t-butylphenol), 2,2'-butylidenebis(2-t-butyl-4-methylphenol), 3,6-dioxaoctamethylenebis[3-(3-t-butyl-4-hydroxy-5-methylphenyl)propionate], triethylene glycol bis[3-(3-t-butyl-5-methyl-4-hydroxyphenyl)propionate], 1,6-hexanediol bis[3-(3,5-di-t-butyl-4-hydroxyphenyl)propionate], and 2,2'-thiodiethylenebis[3-(3,5-di-t-butyl-4-hydroxyphenyl)propionate]; tricyclic phenol compounds such as 1,1,3-tris(2-methyl-4-hydroxy-5-t-butylphenyl)butane, 1,3,5-tris(2,6-dimethyl-3-hydroxy-4-t-butylbenzyl)isocyanurate, 1,3,5-tris[(3,5-di-t-butyl-4-hydroxyphenyl)propionyloxyethyl]isocyanurate, tris(4-t-butyl-2,6-dimethyl-3-hydroxybenzyl)isocyanurate, and 1,3,5-trimethyl-2,4,6-tris(3,5-di-t-butyl-4-hydroxybenzyl)benzene; and tetracyclic phenol compounds such as tetrakis[methylene-3-(3,5-di-t-butyl-4-hydroxyphenyl)propionate]methane, and phosphorus-containing phenol compounds such as calcium bis(ethyl 3,5-di-t-butyl-4-hydroxybenzylphosphonate) and nickel bis(ethyl 3,5-di-t-butyl-4-hydroxybenzylphosphonate).

Specific examples of the phosphorus antioxidant include trioctyl phosphite, trilauryl phosphite, trisdecyl phosphite, trisisodecyl phosphite, phenyldiisooctyl phosphite, phenyldiisodecyl phosphite, phenyldi(tridecyl) phosphite, diphenylisooctyl phosphite, diphenylisodecyl phosphite, diphenyltridecyl phosphite, triphenyl phosphite, tris(nonylphenyl) phosphite, tris(2,4-di-t-butylphenyl) phosphite, tris(butoxyethyl) phosphite, tetratridecyl-4,4'-butylidenebis(3-methyl-6-t-butylphenol)-diphosphite, 4,4'-isopropylidene-diphenol alkyl phosphite (provided that the alkyl has about 12 to 15 carbon atoms), 4,4'-isopropylidenebis(2-t-butylphenol) ·di(nonylphenyl) phosphite, tris(biphenyl) phosphite, tetra(tridecyl)-1,1,3-tris(2-methyl-5-t-butyl-4-hydroxyphenyl)butane diphosphite, tris(3,5-di-t-butyl-4-hydroxyphenyl) phosphite, hydrogenated-4,4'-isopropylidenediphenol polyphosphite, bis(octylphenyl) ·bis[4,4'-butylidenebis(3-methyl-6-t-butylphenol)] ·1,6-hexanediol diphosphite, hexatridecyl-1,1,3-tris(2-methyl-4-hydroxy-5-t-butylphenol) diphosphite, tris[4,4'-isopropylidenebis(2-t-butylphenol)] phosphite, tris(1,3-distearoyloxyisopropyl) phosphite, 9,10-dihydro-9-phosphaphenanthrene-10-oxide, tetrakis(2,4-di-t-butylphenyl)-4,4'-biphenylene diphosphonite, distearyl pentaerythritol diphosphite, di(nonylphenyl)pentaerythritol diphosphite, phenyl·4,4'-isopropylidenediphenol-pentaerythritol diphosphite, bis(2,4-di-t-butylphenyl)pentaerythritol diphosphite, bis(2,6-di-t-butyl-4-methylphenyl)pentaerythritol diphosphite, and phenylbisphenol-A-pentaerythritol diphosphite.

As the sulfur antioxidant, a dialkylthio dipropionate and a polyhydric alcohol ester of alkyl thiopropionic acid are preferably used. As the dialkylthio dipropionate used here, a dialkylthio dipropionate having an alkyl group having 6 to 20 carbon atoms is preferable, and as the polyhydric alcohol ester of alkyl thiopropionic acid, a polyhydric alcohol ester of alkyl thiopropionic acid having an alkyl group having 4 to 20 carbon atoms is preferable. Examples of the polyhydric alcohol constituting the polyhydric alcohol ester in this case can include glycerin, trimethylolethane, trimethylolpropane, pentaerythritol, and trishydroxyethyl isocyanurate. Examples of the dialkylthio dipropionate can include dilaurylthio dipropionate, dimyristylthio dipropionate, and distearylthio dipropionate. Meanwhile, examples of the polyhydric alcohol ester of alkyl thiopropionic acid include glycerin tributylthiopropionate, glycerin trioctylthiopropionate, glycerin trilaurylthiopropionate, glycerin tristearylthiopropionate, trimethylolethane tributylthiopropionate, trimethylolethane trioctylthiopropionate, trimethylolethane trilaurylthiopropionate, trimethylolethane tristearylthiopropionate, pentaerythritol tetrabutylthiopropionate, pentaerythritol tetraoctylthiopropionate, pentaerythritol tetralaurylthiopropionate, and pentaerythritol tetrastearylthiopropionate.

Specific examples of the amine antioxidant can include bis(2,2,6,6-tetramethyl-4-piperidyl)sebacate, a polycondensate of dimethyl succinate and 1-(2-hydroxyethyl)-4-hydroxy-2,2,6,6-tetramethylpiperidineethanol, N,N',N'',N'''-tetrakis-(4,6-bis-(butyl-(N-methyl-2,2,6,6-tetramethylpiperidin-4-yl)amino)-triazin-2-yl)-4,7-diazadecane-1,10-diamine, a polycondensate of dibutylamine·1,3,5-triazine·N,N'-bis(2,2,6,6-tetramethyl-4-piperidyl-1,6-hexamethylenediamine

and N-(2,2,6,6-tetramethyl-4-piperidyl)butylamine, poly[{6-(1,1,3,3-tetramethylbutyl)amino-1,3,5-triazin-2,4-diyl}{(2,2,6,6-tetramethyl-4-piperidyl)imino}hexamethylene{(2,2,6,6-tetramethyl-4-piperidyl)imino}], tetrakis(2,2,6,6-tetramethyl-4-piperidyl)-1,2,3,4-butanetetracarboxylate, 2,2,6,6-tetramethyl-4-piperidylbenzoate, bis-(1,2,6,6-pentamethyl-4-piperidyl)-2-(3,5-di-t-butyl-4-hydroxybenzyl)-2-n-butylmalonate, bis-(N-methyl-2,2,6,6-tetramethyl-4-piperidyl)sebacate, 1,1'-(1,2-ethanediyl)bis(3,3,5,5-tetramethylpiperazinone), (mixed 2,2,6,6-tetramethyl-4-piperidyl/tridecyl)-1,2,3,4-butanetetracarboxylate, (mixed 1,2,2,6,6-pentamethyl-4-piperidyl/tridecyl)-1,2,3,4-butanetetracarboxylate, mixed [2,2,6,6-tetramethyl-4-piperidyl/β,β,β',β'-tetramethyl-3,9-[2,4,8,10-tetraoxaspiro(5,5)undecane]diethyl]-1,2,3,4-butanetetracarboxylate, mixed [1,2,2,6,6-pentamethyl-4-piperidyl/β,β,β',β'-tetramethyl-3,9-[2,4,8,10-tetraoxaspiro(5,5)undecane]diethyl]-1,2,3,4-butanetetracarboxylate, N,N'-bis(3-aminopropyl)ethylenediamine-2,4-bis[N-butyl-N-(1,2,2,6,6-pentamethyl-4-piperidyl)amino]-6-chloro-1,3,5-triazine condensate, poly[6-N-morpholyl-1,3,5-triazin-2,4-diyl][(2,2,6,6-tetramethyl-4-piperidyl)imino]hexamethylene[(2,2,6,6-tetramethyl-4-piperidyl)imide], a condensate of N,N'-bis(2,2,6,6-tetramethyl-4-piperidyl)hexamethylenediamine and 1,2-dibromoethane, and [N-(2,2,6,6-tetramethyl-4-piperidyl)-2-methyl-2-(2,2,6,6-tetramethyl-4-piperidyl)imino]propionamide.

The content of the antioxidant is, but not particularly limited to, preferably in the range of 0.05 parts by weight or more based on 100 parts by weight of the acrylic polymer (A), from the viewpoint of preventing oxidation of the polymer due to the radical generator. Meanwhile, increase in the content of the antioxidant leads to increase in the proportion of radicals to be captured which are generated from the radical generator. Consequently, inhibition of crosslinking of the pressure-sensitive adhesive layer to be formed from the pressure-sensitive adhesive composition easily occurs, and the gel fraction of the pressure-sensitive adhesive layer tends to decrease to result in a defective appearance. From the viewpoint, the content of the antioxidant is in the range of preferably 5 parts by weight or less, further preferably 1.5 parts by weight or less based on 100 parts by weight of the acrylic polymer (A). From the viewpoint of achieving both ensuring of the gel fraction and prevention of oxidation of the polymer, the content of the antioxidant is preferably 0.05 to 5 parts by weight, further preferably from 0.1 to 1.5 parts by weight, further preferably from 0.1 to 1.0 parts by weight based on 100 parts by weight of the acrylic polymer (A).

[1-13. Crosslinking agent]

The pressure-sensitive adhesive composition of the present invention is preferably not a solvent type, as described above, that is, the pressure-sensitive adhesive layer of the present invention is free of or substantially free of a crosslinking agent.

Examples of the crosslinking agent described above include isocyanate crosslinking agents, epoxy crosslinking agents, melamine crosslinking agents, and peroxide crosslinking agents and additionally include urea crosslinking agents, metal alkoxide crosslinking agents, metal chelate crosslinking agents, metal salt crosslinking agents, carbodiimide crosslinking agents, oxazoline crosslinking agents, aziridine crosslinking agents, and amine crosslinking agents. Particularly, the pressure-sensitive adhesive layer of the present invention is preferably free of or substantially free of an isocyanate crosslinking agent and/or epoxy crosslinking agent and is preferably free of or substantially free of an isocyanate crosslinking agent, as the crosslinking agent.

Examples of the isocyanate crosslinking agent (polyfunctional isocyanate compound) described above include lower aliphatic polyisocyanates such as 1,2-ethylene diisocyanate, 1,4-butylene diisocyanate, and 1,6-hexamethylene diisocyanate; alicyclic polyisocyanates such as cyclopentylene diisocyanate, cyclohexylene diisocyanate, isophorone diisocyanate, hydrogenated tolylene diisocyanate, and hydrogenated xylene diisocyanate; and aromatic polyisocyanates such as 2,4-tolylene diisocyanate, 2,6-tolylene diisocyanate, 4,4'-diphenylmethane diisocyanate, and xylylene diisocyanate. Examples of the isocyanate crosslinking agent also include commercially available products such as a trimethylolpropane/tolylene diisocyanate adduct [manufactured by Nippon Polyurethane Industry Co., Ltd., trade name "Coronate L"], a trimethylolpropane/hexamethylene diisocyanate adduct [manufactured by Nippon Polyurethane Industry Co., Ltd., trade name "Coronate HL"], and a trimethylolpropane/xylylene diisocyanate adduct [manufactured by Mitsui Chemicals, Inc., trade name "TAKENATE D-110N"].

Examples of the epoxy crosslinking agent (polyfunctional epoxy compound) described above include N,N,N',N'-tetraglycidyl-m-xylenediamine, diglycidylaniline, 1,3-bis(N,N-diglycidylaminomethyl)cyclohexane, 1,6-hexanediol diglycidyl ether, neopentyl glycol diglycidyl ether, ethylene glycol diglycidyl ether, propylene glycol diglycidyl ether, polyethylene glycol diglycidyl ether, polypropylene glycol diglycidyl ether, sorbitol polyglycidyl ether, glycerol polyglycidyl ether, pentaerythritol polyglycidyl ether, polyglycerol polyglycidyl ether, sorbitan polyglycidyl ether, trimethylolpropane polyglycidyl ether, diglycidyl adipate, diglycidyl o-phthalate, triglycidyl-tris (2-hydroxyethyl) isocyanurate, resorcin diglycidyl ether, and bisphenol-S-diglycidyl ether and additionally include epoxy resins having 2 or more epoxy groups in the molecule. Examples of the epoxy crosslinking agent also include commercially available products such as trade name "TETRAD C" manufactured by Mitsubishi Gas Chemical Company, Inc.

In the pressure-sensitive adhesive layer of the present invention, the phrase "substantially free of" a crosslinking agent refers to actively formulating no crosslinking agent except when a crosslinking agent is inevitably mixed. Specifically,

it can be said that one in which the content of the crosslinking agent in the pressure-sensitive adhesive layer is 1.0% by weight or less (preferably 0.5% by weight or less, further preferably 0.2% by weight or less) based on the total amount of the pressure-sensitive adhesive layer (total weight, 100% by weight) is substantially free of a crosslinking agent. One in which the content thereof is preferably 0.05 parts by weight or less (e.g., from 0 to 0.05 parts by weight), more preferably 0.01 parts by weight or less (e.g., from 0 to 0.01 parts by weight), further preferably 0.001 parts by weight or less (e.g., from 0 to 0.001 parts by weight) based on the total amount of the monomer components constituting the acrylic polymer (A) (100 parts by weight) also can be said to be substantially free of a crosslinking agent.

[1-14. Additives]

In the pressure-sensitive adhesive layer of the present invention, known additives such as a crosslinking accelerator, a tackifier resin (a rosin derivative, a polyterpene resin, oil-soluble phenol, or the like), an antiaging agent, a filler, a colorant (dye, pigment, or the like), a UV absorbing agent, a chain transfer agent, a plasticizer, a softener, a surfactant, and an antistatic agent may be contained as required as long as characteristics of the present invention are not impaired. Such additives may be used singly or in combination of two or more.

[2. Pressure-sensitive adhesive sheet]

The pressure-sensitive adhesive sheet of the present invention is only required to have the pressure-sensitive adhesive layer of the present invention (the pressure-sensitive adhesive layer formed of the pressure-sensitive adhesive composition of the present invention), and other respects are not particularly limited.

The pressure-sensitive adhesive sheet of the present invention may be a double-coated pressure-sensitive adhesive sheet of which both the surfaces is formed as a pressure-sensitive adhesive layer surface or may be a single-coated pressure-sensitive adhesive sheet of which only one surface is formed as a pressure-sensitive adhesive layer surface. Of these, from the viewpoint of laminating two members, the pressure-sensitive adhesive sheet is preferably a double-coated pressure-sensitive adhesive sheet. When the "pressure-sensitive adhesive sheet" is referred to herein, a tape-like sheet, that is, "pressure-sensitive adhesive tape" is also included. A surface of the pressure-sensitive adhesive layer herein may be called an "adhesive face".

The pressure-sensitive adhesive sheet of the present invention may be provided with a separator (release liner) on the adhesive face until used.

The pressure-sensitive adhesive sheet of the present invention may be a so-called "substrateless type pressure-sensitive adhesive sheet that has no substrate (substrate layer) (hereinafter, may be referred to as a "substrateless pressure-sensitive adhesive sheet") or may be a pressure-sensitive adhesive sheet having a substrate (hereinafter, may be referred to as a "pressure-sensitive adhesive sheet with a substrate"). Examples of the substrateless pressure-sensitive adhesive sheet described above include a double-coated pressure-sensitive adhesive sheet consisting only of the pressure-sensitive adhesive layer described above and a double-coated pressure-sensitive adhesive sheet comprising the pressure-sensitive adhesive layer and a pressure-sensitive adhesive layer other than the pressure-sensitive adhesive layer (may be referred to as "another pressure-sensitive adhesive layer"). Meanwhile, examples of the pressure-sensitive adhesive sheet having a substrate include a pressure-sensitive adhesive sheet having the pressure-sensitive adhesive layer on at least one face of the substrate. Of these, the substrateless pressure-sensitive adhesive sheet (substrateless double-coated pressure-sensitive adhesive sheet) is preferable, and the substrateless double-coated pressure-sensitive adhesive sheet consisting only of pressure-sensitive adhesive layer is more preferable. The "substrate (substrate layer)" does not include a separator to be separated when the pressure-sensitive adhesive sheet is used (laminated).

The pressure-sensitive adhesive sheet of the present invention is preferably a substrateless pressure-sensitive adhesive sheet. This is because a pressure-sensitive adhesive sheet having a substrate, in which a substrate is used, also can be said to prevent, to some extent, degradation or a malfunction of the sensor function caused by ion migration or the like due to moisture absorption and permeation of corrosive gas from the side ends and thus a substrateless pressure-sensitive adhesive sheet has a further higher significance of enabling a low dielectric constant to be imparted.

[2-1. Other physical properties of pressure-sensitive adhesive sheet]

The 180° peel adhesive strength of the pressure-sensitive adhesive sheet of the present invention to an acrylic plate at a tensile speed of 300 mm/minute at 25°C (particularly, the 180° peel adhesive strength of the adhesive face provided by the pressure-sensitive adhesive layer described above (the pressure-sensitive adhesive layer formed of the pressure-sensitive adhesive composition of the present invention) to an acrylic plate at a tensile speed of 300 mm/minute at 25°C) is, but not particularly limited to, preferably 10 N/20 mm or more, more preferably 12 N/20 mm or more, further preferably 14 N/20 mm or more, from the viewpoint that, when the adhesive strength is high, sufficient adherence to a

metal surface is obtained, and the corrosion prevention effect is also improved. The pressure-sensitive adhesive sheet of the present invention is preferable when the 180° peel adhesive strength to an acrylic plate at a tensile speed of 300 mm/minute at 25°C is 10 N/20mm because favorable adhesiveness to the acrylic plate and favorable inhibition of lifting at a level difference are more easily obtained. The upper limit value of the 180° peel adhesive strength of the pressure-sensitive adhesive sheet of the present invention to an acrylic plate at a tensile speed of 300 mm/minute at 25°C is, but not particularly limited to, for example, 40 N/20 mm, more preferably 60 N/20 mm. The 180° peel adhesive strength to an acrylic plate at a tensile speed of 300 mm/minute at 25°C is obtained by the following method for measuring the 180° peel adhesive strength.

The 180° peel adhesive strength to an acrylic plate at a tensile speed of 300 mm/minute at 25°C is obtained by the above method for measuring the 180° peel adhesive strength. Examples of the acrylic plate described above include, but not particularly limited to, PMMA plates (trade name "ACRYLITE", manufactured by Mitsubishi Rayon Co., Ltd.).

The above-described adhesive strength to an acrylic plate and the proportion of the adhesive strength in the pressure-sensitive adhesive sheet of the present invention can be adjusted by adjusting the monomer composition of the acrylic polymer (A), the type of the hydrogenated polyolefinic resin (B), the formulation ratio of the acrylic polymer (A) and the hydrogenated polyolefinic resin (B), and the like.

[2-2. Method for producing pressure-sensitive adhesive sheet]

The pressure-sensitive adhesive sheet of the present invention is preferably produced in accordance with a known or customary production method, but not particularly limited thereto. For example, the pressure-sensitive adhesive sheet of the present invention, when being a substrateless pressure-sensitive adhesive sheet, can be obtained by forming the pressure-sensitive adhesive layer described above by the method described above on a separator. Alternatively, the pressure-sensitive adhesive sheet of the present invention, when being a pressure-sensitive adhesive sheet having a substrate, may be obtained by forming the pressure-sensitive adhesive layer directly on the face of the substrate (direct application method), or may be obtained by once forming the pressure-sensitive adhesive layer on a separator and providing the pressure-sensitive adhesive layer on the substrate by transferring (laminating) the pressure-sensitive adhesive layer onto the substrate (transfer method).

[2-3. Pressure-sensitive adhesive layer of pressure-sensitive adhesive sheet]

(Storage elastic modulus at 25°C)

The storage elastic modulus at 25°C of the pressure-sensitive adhesive layer of the present invention (the pressure-sensitive adhesive layer formed of the pressure-sensitive adhesive composition of the present invention) is, but not particularly limited to, preferably 0.01 MPa or more, more preferably 0.05 MPa or more, further preferably 0.1 MPa or more. A case in which the storage elastic modulus is 0.01 MPa or more is preferable because favorable adhesion reliability is more easily obtained. From the viewpoint of level difference conformability, the storage elastic modulus at 25°C of the pressure-sensitive adhesive layer is preferably 0.5 MPa or less, more preferably 0.4 MPa or less. The storage elastic modulus of the pressure-sensitive adhesive layer is measured via dynamic viscoelasticity.

The storage elastic modulus of the pressure-sensitive adhesive layer of the present invention can be adjusted by adjusting the monomer composition of the acrylic polymer (A), the type of the hydrogenated polyolefinic resin (B), the formulation ratio of the acrylic polymer (A) and the hydrogenated polyolefinic resin (B), and the like.

(300% Tensile residual stress)

The 300% tensile residual stress of the pressure-sensitive adhesive layer of the present invention is, but not particularly limited to, preferably from 7 to 16 $N/cm^2$, more preferably from 7 to 15 $N/cm^2$, further preferably from 7 to 14 $N/cm^2$. A case in which the 300% tensile residual stress is 7 $N/cm^2$ or more is preferable because favorable foaming and peeling resistance is more easily obtained. A case in which the 300% tensile residual stress is 16 $N/cm^2$ or less is preferable because favorable stress relaxation properties are obtained and favorable level difference conformability is more easily obtained.

When the pressure-sensitive adhesive sheet of the present invention has the pressure-sensitive adhesive layer having a 300% tensile residual stress within a specific range, excellent stress relaxation properties are more easily obtained, and excellent level difference conformability is more easily exerted. For example, it is possible to well conform to a large level difference (e.g., a level difference having a height of about 45 um, particularly a level difference having a height of 20 to 50 μm).

The 300% tensile residual stress described above is a value ($N/cm^2$) obtained by tensioning the pressure-sensitive adhesive layer under a 23°C environment up to an elongation (strain) of 300% in the lengthwise direction, retaining the elongation, determining the tensile load applied to the pressure-sensitive adhesive layer after lapse of 300 seconds from the completion of the tensioning, and dividing the tensile load by the initial cross-sectional area (cross-sectional area before the tensioning) of the pressure-sensitive adhesive layer. The initial elongation of the pressure-sensitive adhesive layer is 100%. The initial elongation of the pressure-sensitive adhesive layer is 100%.

The pressure-sensitive adhesive layer of the present invention has excellent transparency because of being excellent in computability between the acrylic polymer (A) and the hydrogenated polyolefinic resin (B) of the present invention. For this reason, the visibility and appearance through the pressure-sensitive adhesive layer described above are excellent. As described above, the pressure-sensitive adhesive layer of the present invention is suitably used for optical purposes.

(Haze)

The haze of the pressure-sensitive adhesive layer of the present invention (in accordance with JIS K 7136) is, but not particularly limited to, preferably 1.0% or less, more preferably 0.8% or less. A haze of 1.0% or less is preferable because excellent transparency and excellent appearance can be obtained. The lower limit value of the haze is, but not particularly limited to, theoretically 0%, and may be practically more than 0.01%. The haze described above can be measured, for example, on a specimen made by allowing the pressure-sensitive adhesive layer (thickness: 100 pm) to stand under normal conditions (23°C, 50% RH) for at least 24 hours and then laminating the layer on slide glass (e.g., one having a total light transmittance of 92% and a haze of 0.2%), by use of a haze meter (manufactured by Murakami Color Research Laboratory Co., Ltd., trade name "HM-150N") or an equivalent thereof.

(Total light transmittance)

The total light transmittance in the visible light wavelength region of the pressure-sensitive adhesive layer of the present invention (in accordance with JIS K 7361-1) is, but not particularly limited to, preferably 90% or more, more preferably 91% or more, further preferably 92% or more. A case in which the total light transmittance is 90% or more is preferable because excellent transparency and an excellent appearance can be obtained. The upper limit value of the total light transmittance is, but not particularly limited to, theoretically a value obtained by subtracting the optical loss due to the reflection occurring at the air interface (Fresnel Loss) from 100%, and may be practically 95% or less. The total light transmittance described above can be measured, for example, on a specimen made by allowing the pressure-sensitive adhesive layer (thickness: 100 pm) to stand under normal conditions (23°C, 50% RH) for at least 24 hours, then, if the layer has a separator, separating the separator, and laminating the layer on slide glass (e.g., one having a total light transmittance of 92% and a haze of 0.2%), by use of a haze meter (manufactured by Murakami Color Research Laboratory Co., Ltd., trade name "HM-150N") or an equivalent thereof.

(Thickness)

The thickness of the pressure-sensitive adhesive layer described above (particularly, the pressure-sensitive adhesive layer formed of the pressure-sensitive adhesive composition of the present invention) is, but not particularly limited to, preferably 12 to 350 μm, more preferably 12 to 300 um. A case in which the thickness is equal to or larger than a certain thickness is preferable because the level difference conformability and adhesion reliability are enhanced. A case in which the thickness is equal to or smaller than a certain thickness is preferable because the handleability and manufacturability are particularly excellent.

(Production method)

An example of the method for producing the pressure-sensitive adhesive layer described above include, but not particularly limited to, applying (coating) the pressure-sensitive adhesive composition described above on a substrate or release liner followed by drying, curing, or drying and curing, as required.

For application (coating) of the pressure-sensitive adhesive composition described above, a known coating method may be used. For example, a coater, such as a gravure roll coater, a reverse roll coater, a kiss roll coater, a dip roll coater, a bar coater, a knife coater, a spray coater, a comma coater, or a direct coater may be used.

[2-4. Other layers of pressure-sensitive adhesive sheet]

The pressure-sensitive adhesive sheet of the present invention may have other layers in addition to the pressure-sensitive adhesive layer described above. Examples of the other layers include a different pressure-sensitive adhesive

layer (pressure-sensitive adhesive layer other than the pressure-sensitive adhesive layer described above (pressure-sensitive adhesive layer other than the pressure-sensitive adhesive layer formed of the pressure-sensitive adhesive composition of the present invention)), an intermediate layer, and an undercoat layer. The pressure-sensitive adhesive sheet of the present invention may have 2 or more other layers.

[2-5. Substrate for pressure-sensitive adhesive sheet]

Examples of the substrate in a case in which the pressure-sensitive adhesive sheet of the present invention is a pressure-sensitive adhesive sheet with a substrate include, but not particularly limited to, plastic films and various optical films such as an antireflection (AR) film, a polarizing plate, and a retardation plate. Examples of materials for the plastic films and the like include plastic materials, such as polyester resins such as polyethylene terephthalate (PET), acrylic resins such as polymethyl methacrylate (PMMA), polycarbonate, triacetyl cellulose (TAC), polysulfone, polyarylate, polyimide, polyvinyl chloride, polyethylene, polypropylene, ethylene-propylene copolymers, and cyclic olefinic polymers such as trade name "ARTON (cyclic olefinic polymer, manufactured by JSR Corporation)" and trade name "ZEONOR (cyclic olefinic polymer, manufactured by Zeon Corporation)". These plastic materials may be used singly or in combination of two or more. The "substrate" described above is a portion to be laminated to an object together with the pressure-sensitive adhesive layer when the pressure-sensitive adhesive sheet is laminated to the object. A separator (release liner) to be separated in use (lamination) of the pressure-sensitive adhesive sheet is not included in the "substrate".

The substrate described above is preferably transparent. The total light transmittance in the visible light wavelength region of the substrate (in accordance with JIS K 7361-1) is, but not particularly limited to, preferably 85% or more, more preferably 88% or more. The haze of the substrate (in accordance with JIS K7136) is, but not particularly limited to, preferably 1.0% or less, more preferably 0.8% or less. Examples of such a transparent substrate include PET films, and non-oriented films such as trade name "ARTON" and trade name "ZEONOA".

The thickness of the substrate is, but not particularly limited to, preferably from 12 to 500 um. The substrate may have either of a single layer form and a multilayer form. The surface of the substrate may be appropriately subjected to a known and customary surface treatment, for example, a physical treatment such as a corona discharge treatment or a plasma treatment or a chemical treatment such as a base coat treatment.

[2-6. Separator of pressure-sensitive adhesive sheet]

The pressure-sensitive adhesive sheet of the present invention may be provided with a separator (release liner) on the adhesive face until used. When the pressure-sensitive adhesive sheet of the present invention is a double-coated pressure-sensitive adhesive sheet, each adhesive face may be protected by a separator or may be protected in a roll form wound with one separator having a release face on each side. The separator is used as a protective material of the pressure-sensitive adhesive layer and peeled off in lamination of the sheet onto the object. When the pressure-sensitive adhesive sheet of the present invention is a substrateless pressure-sensitive adhesive sheet, the separator also serves as a support for the pressure-sensitive adhesive layer. The separator may not necessarily be provided.

Examples of the separator described above include, but not particularly limited to, a separator having a release layer (release-treated layer) on at least one surface of the separator substrate, a low-adhesive separator comprising a fluorine polymer, and a low-adhesive separator comprising a non-polar polymer. Examples of the fluorine polymer described above include, but not particularly limited to, polytetrafluoroethylene, polychlorotrifluoroethylene, polyvinyl fluoride, polyvinylidene fluoride, tetrafluoroethylene-hexafluoropropylene copolymers, and chlorofluoroethylene-vinylidene fluoride copolymers. Examples of the non-polar polymer described above include, but not particularly limited to, olefinic resins such as polyethylene (PE) and polypropylene (PP). Of these, a separator having a release layer on at least one surface of the separator substrate is preferably used.

Examples of the separator substrate described above include, but not particularly limited to, plastic films. Examples of such plastic films include plastic films constituted by a polyester resin such as polyethylene terephthalate (PET), polyethylene naphthalate (PEN), or polybutylene terephthalate (PBT); an olefinic resin including $\alpha$-olefin as a monomer component, such as polyethylene (PE), polypropylene (PP), polymethylpentene (PMP), an ethylene-propylene copolymer, or an ethylenevinyl acetate copolymer (EVA) ; polyvinyl chloride (PVC); a vinyl acetate resin; polycarbonate (PC); polyphenylene sulfide (PPS); an amide resin such as polyamide (nylon) or all-aromatic polyamide (aramide); a polyimide resin; or polyether ether ketone (PEEK). Of these, plastic films formed of a polyester resin are preferable, and PET films are further preferable, from the viewpoint of processability, availability, workability, dustproofness, costs, and the like.

Examples of a release treatment agent constituting the release layer described above include, but not particularly limited to, release treatment agents such as silicone release treatment agents, fluorine release treatment agents, long chain alkyl release treatment agents, and molybdenum sulfide. Of these, silicone release treatment agents are preferable

from the viewpoint of release control and stability over time. The release treatment agent may be used singly or in combination of two or more.

The release layer may be a single layer, or may have a lamination structure in which 2 or more layers are laminated as long as characteristics of the present invention are not impaired.

Of these, one example of a specific configuration of the separator include a configuration in which a PET film is used as a separator substrate and a release layer including a silicone release treatment agent is provided on at least one surface of the separator substrate. Of both the surfaces of the separator, the surface that is opposite to the side in contact with the pressure-sensitive adhesive layer and on which no release layer is provided may be referred to as the "back face" of the separator.

In the separator, a carrier material may be laminated on the back face, from the viewpoint that punching processability and handleability are ensured and thickening is made while bendability is retained. Examples of such a carrier material include, but not particularly limited to, a configuration in which two PET film substrates are laminated with the pressure-sensitive adhesive layer intervened therebetween and a configuration in which a COP film substrate and a PET film substrate are laminated with the pressure-sensitive adhesive layer intervened therebetween. The separator may not have a carrier material.

The separator may have a conductive-treated layer on the release layer and/or back face from the viewpoint of suppressing charging generated during transport or separation of the separator to reduce deposition and mixing of foreign matter. Examples of such conductive-treated layers include, but not particularly limited to, a coating-treated layer that includes, as the main component, a composite of poly(3,4-ethylenedioxythiophene) (PEDOT) and polystyrene sulfonic acid (PSS), which is a conductive polymer. The separator may not have a conductive-treated layer.

The separator may be produced by a known and customary method. The carrier material and conductive-treated layer can be prepared by lamination on the release layer and/or back face of the separator by a known method. The separator of the present invention may have other layers (e.g., an intermediate layer, an undercoat layer, and the like) as long as characteristics of the present invention are not impaired.

The thickness of the separator is, but not particularly limited to, preferably from 12 to 200 $\mu$m, more preferably from 25 to 150 $\mu$m, further preferably 38 to 125 um, from the viewpoint of, for example, costs, the handleability of the pressure-sensitive adhesive sheet in lamination operation, and the like.

When the pressure-sensitive adhesive sheet of the present invention is a double-coated pressure-sensitive adhesive sheet of a double separator type, a separator is provided on one adhesive face, and a separator is provided also on the other adhesive face. In such a case, both the separators each are preferably a separator in which only one of the surfaces is a release layer (particularly, a separator in which one surface of the plastic substrate has a release layer constituted by a silicone release agent). The separator is provided such that the release layer is in contact with the adhesive face.

Further, when the pressure-sensitive adhesive sheet of the present invention is a double-coated pressure-sensitive adhesive sheet of a double separator type, a difference in the release strength is preferably provided between the two separators. For example, when the pressure-sensitive adhesive sheet of the present invention is a double-coated pressure-sensitive adhesive sheet of a double separator type, it is preferable that one of the separators be used on the adhesive face to be used (laminated) first (also referred to as the "first face side") and the other separator be used on the adhesive face to be used (laminated) later (also referred to as the "second face side"). Accordingly, it is preferable that the one separator be used as the separator on the "light release side", which can be separated with a smaller strength (release strength), and the other separator be used as the separator on the "heavy release side", which requires a larger strength (release strength) for the separator to be separated from the pressure-sensitive adhesive layer. Herein, the above-described separator on the light release side may be referred to as "the light release separator", and the above-described separator on the heavy release face side may be referred to as "the heavy release separator".

When the pressure-sensitive adhesive sheet of the present invention is a double-coated pressure-sensitive adhesive sheet of a single separator type, a separator is provided on one adhesive face, and winding this separator allows the other adhesive face of the pressure-sensitive adhesive body also to be protected by the separator. When the pressure-sensitive adhesive sheet of the present invention is a single separator type, both the surfaces of the separator each are preferably a release layer (release-treated layer). Of both the release layer of the separator, the release layer on the side to be wound and in contact with the adhesive face may be particularly referred to as the "back face release layer". The back face release layer side of the separator is usually used for the "first face side" of the double-coated pressure-sensitive adhesive sheet.

The pressure-sensitive adhesive sheet of the present invention, to which stress relaxation properties has been imparted without lowering the molecular weight of the acrylic polymer, is preferable in that roughness and deformation of the face of the adhesive of the pressure-sensitive adhesive layer during separation of the separator and occurrence of stick slip are suppressed to thereby enable the pressure-sensitive adhesive sheet to be stably used. Stick slip is a vibration phenomenon that occurs at a release face, breaking the object by causing damage thereto or leaving an adhesive residue partially on the object.

When the pressure-sensitive adhesive sheet of the present invention is a double-coated pressure-sensitive adhesive sheet, in respect that roughness and deformation of the face of the adhesive of the pressure-sensitive adhesive layer during separation of the separator and occurrence of stick slip are suppressed to thereby enable the pressure-sensitive adhesive sheet to be stably used, the release strength (separator release strength) from the pressure-sensitive adhesive layer described above on the first face side (light release side) of the separator is from 0.01 to 0.5 N/50 mm, preferably from 0.05 to 0.25 N/50 mm, the release strength (separator release strength) from the pressure-sensitive adhesive layer (e.g., the above-described acrylic pressure-sensitive adhesive layer, the above-described rubber pressure-sensitive adhesive layer, or the like) on the second face side (heavy release side) of the separator is from 0.1 to 1.00 N/50 mm, preferably from 0.2 to 0.85 N/50 mm, and it is preferable that the separator release strength on the heavy release face side be always larger than the separator release strength on the light release face side and a release difference of the order of from 1.1 to 10.0 times be present.

Particularly, when the pressure-sensitive adhesive sheet of the present invention is a double-coated pressure-sensitive adhesive sheet, in respect that a so-called premature separation phenomenon, roughness and deformation of the face of the adhesive of the pressure-sensitive adhesive layer during separation of the separator, and occurrence of stick slip are suppressed to thereby enable the pressure-sensitive adhesive sheet to be stably used, the difference between the release strength (separator release strength) from the pressure-sensitive adhesive layer of the heavy release separator and the release strength (separator release strength) from the pressure-sensitive adhesive layer of the light release separator is preferably 0.01 N/50 mm or more, more preferably 0.02 N/50 mm or more, further preferably 0.05 N/50 mm or more, particularly preferably 0.06 N/50 mm or more.

The separator release strength described above means a 180° peel pressure-sensitive adhesive strength of the separator to the pressure-sensitive adhesive layer as measured by a 180° release test. The tensile speed is 300 mm/minute.

[2-7. Applications and the like of pressure-sensitive adhesive sheet]

The pressure-sensitive adhesive sheet of the present invention has the pressure-sensitive adhesive layer of the present invention (the pressure-sensitive adhesive layer formed of the pressure-sensitive adhesive composition of the present invention), and thus is excellent in adhesiveness and foaming and peeling resistance. The pressure-sensitive adhesive sheet of the present invention has a low dielectric constant as well as is excellent in stress relaxation properties and excellent in level difference conformability. Thus, an optical member having the pressure-sensitive adhesive sheet of the present invention is unlikely to suffer malfunctions due to a high dielectric constant. The optical member is also excellent in adhesion reliability, particularly adhesion reliability at high temperatures.

For this reason, the pressure-sensitive adhesive sheet of the present invention is usefully used for an object that easily generates foaming at the interface at high temperatures. For example, polymethyl methacrylate resin (PMMA) may contain an unreacted monomer and thus easily generates foaming due to foreign matter at high temperatures. Polycarbonate (PC) easily generates outgassing of water and carbon dioxide at high temperatures. The pressure-sensitive adhesive sheet of the present invention is excellent in foaming and peeling resistance and thus usefully used also for a plastic object containing such resins.

The pressure-sensitive adhesive sheet of the present invention is usefully used also for an object having a large linear expansion coefficient, in addition to an object having a small linear expansion coefficient. Examples of the above-described object having a small linear expansion coefficient include, but not particularly limited to, glass plates (linear expansion coefficient: $0.3 \times 10^{-5}$ to $0.8 \times 10^{-5}$/°C) and polyethylene terephthalate substrates (PET films, linear expansion coefficient: $1.5 \times 10^{-5}$ to $2 \times 10^{-5}$/°C). Examples of the above-described object having a large linear expansion coefficient include, but not particularly limited to, resin substrates having a large linear expansion coefficient, and more specific examples thereof include polycarbonate resin substrates (PC, linear expansion coefficient: $7 \times 10^{-5}$ to $8 \times 10^{-5}$/°C), polymethyl methacrylate resin substrates (PMMA, linear expansion coefficient: $7 \times 10^{-5}$ to $8 \times 10^{-5}$/°C), and cycloolefin polymer substrates (COP, linear expansion coefficient: $6 \times 10^{-5}$ to $7 \times 10^{-5}$/°C), trade name "ZEONOR" (manufactured by Zeon Corporation) and trade name "ARTON " (manufactured by JSR Corporation).

The pressure-sensitive adhesive sheet of the present invention is usefully used for lamination of an object having a small linear expansion coefficient and an object having a large linear expansion coefficient. Specifically, the pressure-sensitive adhesive sheet of the present invention is preferably used for lamination of a glass object (e.g., a glass plate, chemically reinforced glass, a glass lens, or the like) and the above-described resin substrate having a large linear expansion coefficient.

As described above, the pressure-sensitive adhesive sheet of the present invention is useful for lamination of objects of various materials, and particularly usefully used for lamination of a glass object and a plastic object. The plastic object may be an optical film such as a plastic film having metal mesh wiring or silver nanowire on the surface thereof.

Further, the pressure-sensitive adhesive sheet of the present invention is usefully used also for objects having a level difference on the surface thereof, in addition to objects having a smooth surface. Particularly, the pressure-sensitive adhesive sheet of the present invention is usefully used for lamination of a glass object and the above-described resin substrate having a large linear expansion coefficient, even when at least one of the glass object and the resin substrate having a large linear expansion coefficient has a level difference on the surface thereof.

The pressure-sensitive adhesive sheet of the present invention is preferably used in applications for production of mobile electronic devices. Examples of the mobile electronic devices described above include mobile phones, PHS's, smartphones, tablets (tablet-type computers), mobile computers (mobile PC's), personal digital assistants (PDA's), electronic organizers, portable broadcast receiving devices such as portable televisions and portable radios, portable game machines, portable audio players, portable DVD players, cameras such as digital cameras, and camcorder-type video cameras.

The pressure-sensitive adhesive sheet of the present invention is preferably used for, for example, lamination of members or modules composing a mobile electronic device, fixing of a member or a module composing a mobile electronic device to a housing, and the like. More specific examples include lamination of cover glass or a lens (particularly a glass lens) and a touch panel or a touch sensor, fixing of cover glass or a lens (particularly a glass lens) to a housing, fixing of a display panel to a housing, fixing of an input device such as a sheet keyboard, a touch panel, or the like to a housing, lamination of the protection panel of an information display unit and a housing, lamination of housings, lamination of a housing and a decorative sheet, and fixing and lamination of various members or modules composing a mobile electronic device. Herein, a display panel refers to a structure composed of at least a lens (particularly a glass lens) and a touch panel. A lens herein is a concept including both of a transparent body that exhibits an action of light refraction and a transparent body that has no action of light refraction. That is, the lens herein also includes a mere window panel having no refractive action.

Further, the pressure-sensitive adhesive sheet of the present invention is preferably used for optical applications. That is, the pressure-sensitive adhesive sheet of the present invention is preferably an optical pressure-sensitive adhesive sheet for use in optical applications. More specifically, the pressure-sensitive adhesive sheet of the present invention is preferably used for, for example, applications of laminating optical members (for lamination of optical members), production applications of products in which the optical member is used (optical products), and the like.

[3. Optical member]

The optical member of the present invention is an optical member having at least the pressure-sensitive adhesive sheet described above and a substrate. It is only required that the substrate described above comprise metal wiring (e.g., metal mesh wiring or silver nanowire) on at least one face and that the pressure-sensitive adhesive layer of the present invention (the pressure-sensitive adhesive layer formed of the pressure-sensitive adhesive composition of the present invention) be laminated on the face of the substrate on the side having the metal wiring, and other respects are not particularly limited. The pressure-sensitive adhesive sheet of the present invention may be provided with a separator on the adhesive face until used, but the pressure-sensitive adhesive sheet in the optical member of the present invention is a pressure-sensitive adhesive sheet during use, and thus has no separator.

From the viewpoint of obtaining a further excellent corrosion prevention effect, the optical member preferably has the pressure-sensitive adhesive layer on the side of the substrate opposite to the side having the metal wiring, and the pressure-sensitive adhesive layer is more preferably laminated on the face of the substrate on the side opposite to the side having the metal wiring.

Examples of materials constituting the metal wiring include, but not particularly limited to, metals such as titanium, silicon, niobium, indium, zinc, tin, gold, silver, copper, aluminum, cobalt, chromium, nickel, lead, iron, palladium, platinum, tungsten, zirconium, tantalum, and hafnium. Further examples include ones containing 2 or more of these metals and alloys including these metals as the main component. Of these, in respect of electrical conductivity, gold, silver, and copper are preferable, and in respect of electrical conductivity and costs, silver and copper are more preferable. That is, the metal wiring is preferably silver wiring and/or copper wiring, and particularly, copper mesh wiring, silver mesh wiring, and silver nanowire are preferable. For the purpose of higher anti-corrosion, an oxide film or metal-coated film may be provided on the metal wiring. The same applies to the material constituting the metal wiring of a touch panel mentioned below.

An optical member refers to a member having optical properties (e.g., polarizability, photorefractivity, light scattering, light reflectivity, optical transparency, optical absorptivity, optical diffractive ability, optical rotatory, and visibility). Examples of a substrate composing the optical member include, but not particularly limited to, substrates composing devices such as display devices (image display devices) and input devices or substrates for use in these devices. Examples thereof include polarizing plates, wavelength plates, retardation plates, optical compensation films, brightness enhancing films, light-guiding panels, reflective films, antireflective films, hard-coated films (films obtained by subjecting at least one face of plastic films such as PET films to hard coat treatment), transparent conductive films (e.g., plastic films having an ITO layer on the surface thereof (preferably, ITO films such as PET-ITO, polycarbonate, and cycloolefin polymer)), design films, decorative films, surface-protective plates, prisms, lenses, color filters, transparent substrates

(glass substrates such as glass sensors, glass display panels (such as LCD's), and glass plates having a transparent electrode), and further, substrates in which these are laminated (these may be collectively referred to as "functional films"). These films may also have a metal nanowire layer, an electrically-conductive polymer layer, or the like. On these films, metallic thin wires may be mesh-printed. The "plates" and "films" described above are each intended to include one in the form of plate, film, sheet, or the like. For example, "polarizing films" are intended to include "polarizing plates", "polarizing sheets", and the like. The "films" are intended to include film sensors and the like.

Particularly, the pressure-sensitive adhesive sheet of the present invention can be suitably used in transparent conductive films (metal mesh films, silver nanowire films) in which the metal wiring described above is metal mesh wiring or silver nanowire, particularly, in optical members having a metal mesh film. Silver and copper are metals likely to generate ion migration. Particularly, silver and copper in the form of metal mesh wiring or silver nanowire is likely to generate ion migration, and malfunctions easily result from short circuiting due to metal ions that have penetrated the pressure-sensitive adhesive layer. The pressure-sensitive adhesive sheet of the present invention, which has a low dielectric constant and is excellent in stress relaxation properties, fills a level difference caused by metal wiring or the like without leaving air bubbles, and silver and copper are unlikely to cause malfunctions due to ion migration. The same applies to the metal mesh film or silver nanowire film constituting the touch panels mentioned below.

Examples of the display device include liquid crystal display devices, organic EL (electroluminescent) display devices, PDPs (plasma display panels), and electronic paper. Examples of the input device also include touch panels.

Examples of substrates composing the optical members include, but not particularly limited to, substrates comprising glass, acryl resin, polycarbonate, polyethylene terephthalate, a cycloolefin polymer, a metal thin film (e.g., substrates in a sheet, film, or plate form), or the like. The "optical members" in the present invention are intended to also include members that serve to decorate or protect a display device and an input device while keeping the visibility of the devices (design films, decorative films, surface-protective films, and the like), as described above.

When the pressure-sensitive adhesive sheet of the present invention is a pressure-sensitive adhesive sheet having a substrate, and the pressure-sensitive adhesive sheet composes a member having optical properties, the substrate can be regarded as the same as the substrate, and the pressure-sensitive adhesive sheet can be said to be also an optical member of the present invention.

When the pressure-sensitive adhesive sheet of the present invention is a pressure-sensitive adhesive sheet having a substrate, and the functional film is used as the substrate, the pressure-sensitive adhesive sheet of the present invention also can be used as a "pressure-sensitive adhesive functional film" that has the pressure-sensitive adhesive layer on at least one face of the functional film.

Next, a specific example of a particularly preferable form of the optical member of the present invention will be described with reference to the schematic view of Figure 1.

In Figure 1, there is depicted an optical member 1 having at least a pressure-sensitive adhesive sheet 10 and a substrate as a metal mesh film 11, the metal mesh film 11 comprising metal mesh wiring 3 on one face, the pressure-sensitive adhesive sheet 10 being laminated on the face of the metal mesh film 11 on the side having the metal mesh wiring 3.

[4. Touch panel]

The touch panel of the present invention is a touch panel having at least the pressure-sensitive adhesive sheet and a substrate. It is only required that the substrate comprise metal wiring (e.g., metal mesh wiring or silver nanowire) on one surface and that the pressure-sensitive adhesive layer be laminated on the face of the substrate on the side having the metal wiring, and other respects are not particularly limited. The pressure-sensitive adhesive sheet in the touch panel of the present invention is a pressure-sensitive adhesive sheet during use and thus has no separator.

As the touch panel, preferable is a form configured by laminating the optical member of the present invention with another optical member (although the member may or may not necessarily has the pressure-sensitive adhesive sheet, the member preferably has the sheet from the view point of obtaining a further excellent corrosion prevention effect). The another optical member may be a single optical member or a plurality of optical members.

Examples of the lamination form of the optical member of the present invention and the another optical member in the case of form described above include, but not particularly limited to, (1) a form in which the optical member of the present invention and the another optical member are laminated with the pressure-sensitive adhesive sheet of the present invention intervened therebetween, (2) a form in which the pressure-sensitive adhesive sheet of the present invention including or composing an optical member is laminated on the another optical member, (3) a form in which an optical member is laminated on a member other than an optical member with the pressure-sensitive adhesive tape of the present invention intervened therebetween, and (4) a form in which the pressure-sensitive adhesive tape of the present invention including or composing an optical member is laminated on a member other than an optical member. In the form (2), the pressure-sensitive adhesive sheet of the present invention is preferably a double-coated pressure-sensitive adhesive sheet of which the substrate is an optical member (e.g., an optical film).

Next, a specific example of a particularly preferable form of the touch panel of the present invention will be described with reference to the schematic view of Figure 2.

In Figure 2(A), a touch panel 2 is depicted which has a transparent substrate 12a, a pressure-sensitive adhesive sheet 10a, a metal mesh film 11, a pressure-sensitive adhesive sheet 10b, and a transparent substrate 12b in this order and in contact mutually. The metal mesh film 11 comprises metal mesh wiring 3 on the face on the side of the pressure-sensitive adhesive sheet 10a, and the pressure-sensitive adhesive sheet 10a is laminated on the face of the metal mesh film 11 on the side having the metal mesh wiring 3. The transparent substrate 12a and transparent substrate 12b are preferably of glass, and the substrate of the metal mesh film 11 is preferably of PET. The pressure-sensitive adhesive sheet 10b may or may not be the pressure-sensitive adhesive sheet of the present invention, and is preferably the pressure-sensitive adhesive sheet of the present invention.

In Figure 2(B), a touch panel 2 is depicted which has a transparent substrate 12a, a pressure-sensitive adhesive sheet 10a, a metal mesh film 13, a pressure-sensitive adhesive sheet 10b, a polarizing plate 14a, a transparent substrate 12b and a polarizing plate 14b in this order and in contact mutually. The metal mesh film 13 comprises metal mesh wiring 3 on the face on the side of the pressure-sensitive adhesive sheet 10a, and the pressure-sensitive adhesive sheet 10a is laminated on the face of the metal mesh film 13 on the side having the metal mesh wiring 3. The transparent substrate 12a is preferably of glass, and the transparent substrate 12b is preferably a display panel of glass such as an LCD. The pressure-sensitive adhesive sheet 10b may or may not be composed of the pressure-sensitive adhesive layer (the pressure-sensitive adhesive layer formed of the pressure-sensitive adhesive composition of the present invention), and is preferably composed of the pressure-sensitive adhesive layer (the pressure-sensitive adhesive layer formed of the pressure-sensitive adhesive composition of the present invention).

In Figure 2(C), a touch panel 2 is depicted which has a transparent substrate 12a, a pressure-sensitive adhesive sheet 10a, a metal mesh film 13, a pressure-sensitive adhesive sheet 10b, a hard-coated film 15, a pressure-sensitive adhesive sheet 10c, a polarizing plate 14a, a transparent substrate 12b, and a polarizing plate 14b in this order and in contact mutually. The metal mesh film 13 comprises metal mesh wiring 3 on the face on the side of the pressure-sensitive adhesive sheet 10a, and the pressure-sensitive adhesive sheet 10a is laminated on the face of the metal mesh film 13 on the side having the metal mesh wiring 3. The transparent substrate 12a is preferably of glass, the transparent substrate 12b is preferably a display panel of glass such as an LCD, and the hard-coated film 15 is preferably a hard-coated PET film. The pressure-sensitive adhesive sheets 10b and 10c each may or may not be composed of the pressure-sensitive adhesive layer (the pressure-sensitive adhesive layer formed of the pressure-sensitive adhesive composition of the present invention), and are preferably composed of the pressure-sensitive adhesive layer (the pressure-sensitive adhesive layer formed of the pressure-sensitive adhesive composition of the present invention).

In Figure 2(D), a touch panel 2 is depicted which comprises an optical member 4 having a transparent substrate 12a, a pressure-sensitive adhesive sheet 10a, a metal mesh film 13, a pressure-sensitive adhesive sheet 10b, and a hard-coated film 15 in this order and in contact mutually, and an optical member 5 having a polarizing plate 14a, a transparent substrate 12b, and a polarizing plate 14b in this order and in contact mutually. The optical member 4 and the optical member 5 are in a positional relationship in which the hard-coated film 15 and the polarizing plate 14a are facing each other. The hard-coated film 15 is not in contact with the polarizing plate 14a, and an air layer has been formed between the hard-coated film 15 and the polarizing plate 14a. The metal mesh film 13 comprises metal mesh wiring 3 on the face on the side of the pressure-sensitive adhesive sheet 10a, and the pressure-sensitive adhesive sheet 10a is laminated on the face of the metal mesh film 13 on the side having the metal mesh wiring 3. The transparent substrate 12a is preferably of glass, the transparent substrate 12b is preferably a display panel of glass such as an LCD, and the hard-coated film 15 is preferably a hard-coated PET film. The pressure-sensitive adhesive sheets 10b and 10c each may or may not be composed of the pressure-sensitive adhesive layer (the pressure-sensitive adhesive layer formed of the pressure-sensitive adhesive composition of the present invention), and are preferably composed of the pressure-sensitive adhesive layer (the pressure-sensitive adhesive layer formed of the pressure-sensitive adhesive composition of the present invention).

A method for forming the metal mesh wiring on the metal mesh film is not particularly limited, and examples thereof include a method in which a metal layer provided in advance is removed by etching or the like and a printing method.

## Examples

The present invention will be described hereinafter more specifically based on examples, but the present invention is not intended to be limited to these examples. The numbers of parts formulated (parts by weight) each indicate the number of parts formulated of each component described.

[Production Example 1: Preparation of prepolymer composition A]

To a monomer mixture constituted by 40 parts by weight of 2-ethylhexyl acrylate (2EHA), 40 parts by weight

of isostearyl acrylate (ISTA), 19 parts by weight of N-vinyl-2-pyrrolidone (NVP), and 1 part by weight of 4-hydroxybutyl acrylate (4-HBA), 0.05 parts by weight of a photopolymerization initiator (trade name "Omnirad 184", manufactured by IGM Resins B.V.) and 0.05 parts by weight of a photopolymerization initiator (trade name "Omnirad 651", manufactured by IGM Resins B.V.) were formulated. Then, ultraviolet was applied until the viscosity (BH viscometer No. 5 rotor, 10 rpm, measurement temperature: 30°C) reached about 20 Pa·s to thereby obtain a prepolymer composition A, in which the monomer components were partially polymerized.

[Production Example 2: Preparation of prepolymer composition B]

To a monomer mixture constituted by 31 parts by weight of 2-ethylhexyl acrylate (2EHA), 31 parts by weight of isostearyl acrylate (ISTA), 17 parts by weight of isobornyl acrylate (IBXA), 2 parts by weight of N-vinyl-2-pyrrolidone (NVP), and 19 parts by weight of 4-hydroxybutyl acrylate (4-HBA), 0.05 parts by weight of a photopolymerization initiator (trade name "Omnirad 184", manufactured by IGM Resins B.V.) and 0.05 parts by weight of a photopolymerization initiator (trade name "Omnirad 651", manufactured by IGM Resins B.V.) were formulated. Then, ultraviolet was applied until the viscosity (BH viscometer No. 5 rotor, 10 rpm, measurement temperature: 30°C) reached about 20 Pa·s to thereby obtain a prepolymer composition B, in which the monomer components were partially polymerized.

[Production Example 3: Preparation of prepolymer composition C]

To a monomer mixture constituted by 29 parts by weight of 2-ethylhexyl acrylate (2EHA), 29 parts by weight of isostearyl acrylate (ISTA), 21 parts by weight of isobornyl acrylate (IBXA), and 21 part by weight of 4-hydroxybutyl acrylate (4-HBA), 0.05 parts by weight of a photopolymerization initiator (trade name "Omnirad 184", manufactured by IGM Resins B.V.) and 0.05 parts by weight of a photopolymerization initiator (trade name "Omnirad 651", manufactured by IGM Resins B.V.) were formulated. Then, ultraviolet was applied until the viscosity (BH viscometer No. 5 rotor, 10 rpm, measurement temperature: 30°C) reached about 20 Pa·s to thereby obtain a prepolymer composition C, in which the monomer components were partially polymerized.

[Example 1]

To 100 parts by weight of the prepolymer composition A obtained in Production Example 1, 15 parts by weight of hydrogenated 1,2-polybutadiene glycol (trade name "GI-2000", number average molecular weight (Mn): 3110 (found), weight average molecular weight (Mw): 5090 (found), polydispersity (Mw/Mn): 1.64 (found), hydrogenation ratio: 93% or more (catalog value), iodine value: 21 or less (catalog value), manufactured by Nippon Soda Co., Ltd.), 0.040 parts by weight of trimethylolpropane triacrylate (TMPTA), and 0.3 parts by weight of a silane coupling agent (trade name "KBM-403", manufactured by Shin-Etsu Chemical Co., Ltd.) were added and mixed to thereby obtain a pressure-sensitive adhesive composition (composition before curing).

The pressure-sensitive adhesive composition was applied on a polyethylene terephthalate (PET) separator (heavy release separator, trade name "MRF75", manufactured by Mitsubishi Resin Co., Ltd.) such that the final thickness (thickness of the pressure-sensitive adhesive layer) was 200 um to form an applied layer (pressure-sensitive adhesive composition layer). Then, the applied layer was covered by providing a PET separator (light release separator, trade name "MRE75", manufactured by Mitsubishi Resin Co., Ltd.) on the applied layer to block oxygen. A laminate of MRF75/applied layer (pressure-sensitive adhesive composition layer)/MRE75 was thus obtained.

Next, this laminate was irradiated from the top face of the laminate (MRF38 side) with ultraviolet having an illuminance of 5 $mW/cm^2$ for 300 seconds using a black light (manufactured by TOSHIBA CORPORATION). Additionally, a drying treatment was conducted in a dryer at 90°C for 2 minutes to volatilize the remaining monomers. Then, obtained was a substrateless double-coated pressure-sensitive adhesive sheet that was composed only of the pressure-sensitive adhesive layer and in which both the faces of the pressure-sensitive adhesive layer were protected with the separators.

[Examples 2 to 5 and Comparative Examples 1 to 8]

Each substrateless double-coated pressure-sensitive adhesive sheet was obtained in the same manner as in Example 1 except for the composition of the pressure-sensitive adhesive composition and the thickness of the pressure-sensitive adhesive layer shown in Table 1.

[Table 1]

[Table 1]

| Formulation | | Ex. 1 | Ex. 2 | Ex. 3 | Ex. 4 | Ex. 5 | Comp. Ex. 1 | Comp. Ex. 2 | Comp. Ex. 3 | Comp. Ex. 4 | Comp. Ex. 5 | Comp. Ex. 6 | Comp. Ex. 7 | Comp. Ex. 8 |
|---|---|---|---|---|---|---|---|---|---|---|---|---|---|---|
| Prepolymer composition | A | 100 | 100 | 100 | - | - | 100 | - | - | 100 | 100 | 100 | - | 100 |
| | B | - | - | - | 100 | - | - | 100 | - | - | - | - | 100 | - |
| | C | - | - | - | - | 100 | - | - | 100 | - | - | - | - | - |
| Hydrogenated polyolefin | GI-1000 | - | - | - | 5 | - | - | - | - | - | - | - | 40 | - |
| | GI-2000 | 15 | - | - | - | 5 | - | - | - | - | - | - | - | - |
| | GI-3000 | - | 12 | - | - | - | - | - | - | - | - | - | - | - |
| | BI-2000 | - | - | - | - | 10 | - | - | - | - | - | - | - | - |
| | BI-3000 | - | 18 | 10 | - | - | - | - | - | - | - | - | - | - |
| Non-hydrogenated polyolefin | HV-35 | - | - | - | - | - | - | - | - | 20 | - | - | - | - |
| | G-1000 | - | - | - | - | - | - | - | - | - | 20 | - | - | - |
| | B-2000 | - | - | - | - | - | - | - | - | - | - | 20 | - | - |
| Polyfunctional acrylate | TMPTA | 0.040 | 0.035 | 0.040 | 0.050 | - | 0.035 | - | - | 0.015 | 0.015 | 0.015 | 0.060 | 0.100 |
| | HDDA | - | - | - | - | 0.075 | - | 0.100 | 0.100 | - | - | - | - | - |
| Photopolymerization initiator | Omnirad651 | - | - | - | - | 0.050 | - | - | 0.050 | - | - | - | - | 0.050 |
| Chain transfer agent | α-Thioglycerol | - | - | - | - | - | - | - | - | - | - | - | - | 0.100 |
| Stabilizer | Triphenyl phosphite | - | - | - | - | - | - | - | - | - | - | - | - | 1.5 |
| Anti-corrosive agent | BT-120 | - | 0.500 | 0.100 | 1000 | 0.300 | - | - | - | - | - | - | - | - |
| Antioxidant | Irganox1010 | - | - | - | 0.600 | - | - | - | - | - | - | - | - | - |
| Silane coupling agent | KBM-403 | 0.300 | 0.300 | 0.300 | 0.300 | 0.300 | 0.300 | 0.300 | 0.300 | 0.300 | 0.300 | 0.300 | 0.300 | - |
| Pressure-sensitive adhesive thickness (mm) | | 200 | 100 | 50 | 250 | 250 | 150 | 150 | 150 | 150 | 150 | 150 | 250 | 200 |

The details of the components shown in Table 1 are as follows.

(Prepolymer composition)

A: Prepolymer composition A produced in Production Example 1
B: Prepolymer composition B produced in Production Example 2
C: Prepolymer composition C produced in Production Example 3

(Hydrogenated polyolefin)

GI-1000: trade name "GI-1000", hydrogenated 1,2-polybutadiene glycol, number average molecular weight (Mn): 2320 (found), weight average molecular weight (Mw): 4040 (found), polydispersity (Mw/Mn): 1.75 (found), hydrogenation ratio: 97% or more (catalog value), iodine value: 21 or less (catalog value), manufactured by Nippon Soda Co., Ltd.
GI-2000: trade name "GI-2000", hydrogenated 1,2-polybutadiene glycol, number average molecular weight (Mn): 3110 (found), weight average molecular weight (Mw): 5090 (found), polydispersity (Mw/Mn): 1.64 (found), hydrogenation ratio: 97% or more (catalog value), iodine value: 21 or less (catalog value), manufactured by Nippon Soda Co., Ltd.
GI-3000: trade name "GI-3000", hydrogenated 1,2-polybutadiene glycol, number average molecular weight (Mn): 4660 (found), weight average molecular weight (Mw): 6130 (found), polydispersity (Mw/Mn): 1.32 (found), hydrogenation ratio: 97% or more (catalog value), iodine value: 21 or less (catalog value), manufactured by Nippon Soda Co., Ltd.
BI-2000: trade name "BI-2000", hydrogenated 1,2-polybutadiene, number average molecular weight (Mn): 2930 (found), weight average molecular weight (Mw): 4050 (found), polydispersity (Mw/Mn): 1.38 (found), hydrogenation ratio: 97% or more (catalog value), iodine value: 21 or more (catalog value), manufactured by Nippon Soda Co., Ltd.
BI-3000: trade name "BI-3000", hydrogenated 1,2-polybutadiene, number average molecular weight (Mn): 4750 (found), weight average molecular weight (Mw): 6150 (found), polydispersity (Mw/Mn): 1.30 (found), hydrogenation ratio: 97% or more (catalog value), iodine value: 21 or less (catalog value), manufactured by Nippon Soda Co., Ltd.

(Non-hydrogenated polyolefin)

HV-15: trade name "HV-15", polybutene, number average molecular weight (Mn): 680 (found), weight average molecular weight (Mw): 1000 (found), polydispersity (Mw/Mn): 1.50 (found), manufactured by JXTG Nippon Oil & Energy Corporation
G-1000: trade name "G-1000", 1,2-polybutadiene glycol, number average molecular weight (Mn): 2200 (found), weight average molecular weight (Mw): 3800 (found), polydispersity (Mw/Mn): 1.7 (found), vinyl group content: 85% or more (catalog value), manufactured by Nippon Soda Co., Ltd.
B-1000: trade name "B-1000", 1,2-polybutadiene, number average molecular weight (Mn): 2000 (found), weight average molecular weight (Mw): 3100 (found), polydispersity (Mw/Mn): 1.5 (found), vinyl group content: 85% or more (catalog value), manufactured by Nippon Soda Co., Ltd.

(Polyfunctional acrylate)

TMPTA: trimethylolpropane triacrylate
HDDA: hexanediol diacrylate

(Photopolymerization initiator)

Omnirad 651: trade name "Omnirad 651", 2,2-dimethoxy-2-phenylacetophenone, manufactured by IGM Resins B.V.

(Chain transfer agent)

α-thioglycerol

(Stabilizer)

Triphenyl phosphite

(Anti-corrosive agent)

BT-120: trade name "BT-120", 1,2,3-benzotriazole, manufactured by Johoku Chemical Co., Ltd.

(Antioxidant)

Irganox 1010: trade name "Irganox 1010", pentaerythritol tetrakis[3-(3,5-di-tert-butyl-4-hydroxyphenyl)propionate], manufactured by BASF SE

(Silane coupling agent)

KBM-403: trade name "KBM-403", 3-glycidoxypropyltrimethoxysilane, manufactured by Shin-Etsu Chemical Co., Ltd.
The founds of the number average molecular weight (Mn), weight average molecular weight (Mw), and polydispersity (Mw/Mn) of the hydrogenated polyolefins and non-hydrogenated polyolefin were determined from values obtained by measurement by GPC (gel permeation chromatography) under the following conditions and calculation in terms of polystyrene.

Analysis apparatus: GPC: HLC-8320GPC (TOSOH CORPORATION)

Measurement conditions:

Column: TSKgel Super HZM-H/HZ4000/HZ3000/HZ2000
Column size: 6.0 mm I.D. × 150 mm
Eluent: THF (tetrahydrofuran)
Flow rate: 0.6 mL/min
Detector: differential refractometer (RI)
Column temperature: 40°C
Amount injected: 20 μL

The molecular weights were calculated in terms of polystyrene.

[Evaluation of characteristics]

The following measurements and evaluations were conducted on the substrateless double-coated pressure-sensitive adhesive sheets of Examples and Comparative Examples. The evaluation results were shown in Table 2.

(1) Non-volatile content

A sample was placed in an aluminum pan having a known weight (W1), the weight thereof (W2) was measured, the weight thereof after heated at 130°C for 2 hours (W3) was measured, and the weights were substituted into the following equation to calculate the non-volatile content of the pressure-sensitive adhesive composition.

$$\text{Non-volatile content (\%)} = (W3 - W1)/(W2 - W1) \times 100$$

(2) Gel fraction

About 0.1 g of the pressure-sensitive adhesive layer was collected from the double-coated pressure-sensitive adhesive sheet and wrapped with a porous tetrafluoroethylene sheet having an average pore diameter of 0.2 um (trade

name "NTF1122", manufactured by NITTO DENKO CORPORATION), and then tied up with a kite string. The weight at this time was measured, and this weight was defined as the weight before immersion. The weight before immersion is the total weight of the pressure-sensitive adhesive layer (the pressure-sensitive adhesive layer collected above), the tetrafluoroethylene sheet, and the kite string. The total weight of the tetrafluoroethylene sheet and the kite string is also measured, and this weight is defined as the packaging weight.

Next, the pressure-sensitive adhesive layer wrapped with the tetrafluoroethylene sheet and tied up with the kite string (referred to as the "sample") was put in a 50 ml vessel filled with ethyl acetate, followed by allowing to stand at 23°C for 7 days. The sample (after ethyl acetate treatment) was then taken out of the vessel and transferred to an aluminum cup, followed by drying in a dryer at 130°C for 2 hours to remove ethyl acetate. Thereafter, the weight was measured, and this weight was defined as the weight after immersion.

Then, the gel fraction was calculated according to the following formula.

$$\text{Gel fraction [\% (\% by weight)]} = (X - Y)/(Z - Y) \times 100$$

(4) Total light transmittance and haze

One of the separators were separated from the double-coated pressure-sensitive adhesive sheet, the double-coated pressure-sensitive adhesive sheet was laminated to a slide glass (manufactured by Matsunami Glass Ind., Ltd., "ShiroKenma (White Polish) No. 1", thickness: 0.8 to 1.0 mm, total light transmittance: 92%, haze: 0.2%), and the other separator was separated to produce a specimen having a double-coated pressure-sensitive adhesive sheet (pressure-sensitive adhesive layer)/slide glass layer configuration.

The total light transmittance in the visible light region and the haze of the specimen were measured using a haze meter (apparatus name "HM-150", manufactured by Murakami Color Research Laboratory Co., Ltd.).

(5) Dielectric constant

The pressure-sensitive adhesive layer obtained in Example or Comparative Example (double-coated pressure-sensitive adhesive sheet from which the PET separator subjected to a silicone treatment had been separated) was interposed between copper foil and an electrode, and specific dielectric constants at frequencies at 100 kHz and 1 MHz were measured by the following apparatus. Three samples were prepared for the measurement, and the average of the measurements of the 3 samples was defined as the specific dielectric constant.

The specific dielectric constant at a frequency at 100 kHz of the pressure-sensitive adhesive layer was measured under the following conditions in accordance with JIS K 6911.

Measurement method: capacitive method (apparatus: Agilent Technologies 4294A Precision Impedance Analyzer)
Electrode configuration: 12.1 mmΦ, 0.5 mm-thick aluminum plate
Counter electrode: 3 oz copper plate
Measurement environment: 2311°C, 52±1% RH

(6) Storage elastic modulus

The storage elastic modulus at 25°C of the pressure-sensitive adhesive layer obtained in Example or Comparative Example (double-coated pressure-sensitive adhesive sheet from which the PET separator subjected to a silicone treatment had been separated) was determined by dynamic viscoelasticity measurement. A measurement sample of the pressure-sensitive adhesive layer was measured using a dynamic viscoelasticity measurement apparatus (apparatus name "ARES",(manufactured by TA Instruments, Inc.) under conditions of a frequency of 1 MHz in the temperature range of -20 to 100°C at a temperature increase rate of 5°C/minute, and the shear storage elastic modulus at 25°C was calculated.

(7) 180° peel adhesive strength (180° peel adhesive strength to glass plate)

A sheet piece of 100 mm in length and 20 mm in width was cut out from the double-coated pressure-sensitive adhesive sheet. Then, one of the separators was separated from the sheet piece, and the sheet piece was laminated (lined) with a PET film (trade name "Lumirror S-10", thickness: 25 um, manufactured by Toray Industries, Inc.). Next,

the other separator was separated, and the sheet piece was pressure-bonded onto a test plate under pressure-bonding conditions of a 2-kg roller and one reciprocation. Thereafter, the sheet piece was aged under an atmosphere of 23°C and 50% RH for 30 minutes. After the aging, the pressure-sensitive adhesive sheet was peeled off from the test plate using a tensile tester (apparatus name "Autograph AG-IS", manufactured by Shimadzu Corporation) in accordance with JIS Z 0237 under an atmosphere of 25°C or 65°C and 50% RH under conditions of a tensile speed of 300 mm/minute and a separation angle of 180°, and the 180° peel adhesive strength (N/20 mm) was measured.

As the test plate, a glass plate (trade name "Soda lime glass #0050", manufactured by Matsunami Glass Ind., Ltd.) was used.

(8) Separator release strength

The double-coated pressure-sensitive adhesive sheet sample obtained in Example or Comparative Example was cut into a size of 50 mm in width and 100 mm in length, and then, the release strength (N/50 mm) was measured when a separator (light release separator) was peeled off at a separation angle of 180° and a separation speed of 300 mm/min a tensile tester (apparatus name "Autograph AG-IS", manufactured by Shimadzu Corporation). The pressure-sensitive adhesive surface of the sample from which the light release separator had been removed was laminated (lined) with a PET film (trade name "Lumirror S-10", thickness: 25 um, manufactured by Toray Industries, Inc.) by a hand roller so as to avoid air bubbles and strain. The release strength was measured when the other separator (heavy release separator) was peeled off from the sample obtained under the same conditions mentioned above.

(9) Foaming and peeling resistance

Provided was a film including an ITO (oxide of indium and tin) layer provided on one face of a cycloolefin (COP) substrate (trade name "ZEONOR", manufactured by Zeon Corporation, thickness: 100 μm) such that the sheet resistance value reached 70 Ω/square (hereinafter, also referred to as "the COP-ITO film"). One of the separators was separated from the double-coated pressure-sensitive adhesive sheet, and the double-coated pressure-sensitive adhesive sheet was laminated by pressure-bonding on the face on the ITO layer side of the film in a roll laminator under pressure-bonding conditions of 0.3 MPa. Then, a structure A' was obtained having a lamination structure of the COP-ITO film and the double-coated pressure-sensitive adhesive sheet.

Next, the separator on the heavy release side of the double-coated pressure-sensitive adhesive sheet in the structure A' was separated, and the structure A' was laminated by pressure-bonding on the face on the side having a level difference of glass having a level difference (see Figures 3 to 5) under the following pressure-bonding conditions.

(Lamination conditions)

Surface pressure: 0.3 MPa
Lamination speed: 25 mm/s
Roll rubber hardness: 70°

Thereafter, the structure A' was placed in an autoclave and subjected to an autoclave treatment under conditions of a temperature of 50°C and a pressure of 0.5 MPa for 15 minutes. A structure B' was obtained having a lamination structure of the COP-ITO film, the double-coated pressure-sensitive adhesive sheet, and the glass having a level difference.

The structure B' was left under an atmosphere of 23°C and 50% RH for 24 hours. Then, the structure B' was placed in a drier set at 85°C and left for 240 hours.

Thereafter, the structure B' was removed from the drier and left under an atmosphere of 23°C and 50% RH for 30 minutes. Then, the presence/absence of foaming (foaming including foaming derived from foreign matter) or peeling in the structure B' was examined with a microscope.

Then, evaluation was conducted in accordance with the following evaluation criteria.

Evaluation criteria

E: No foaming or peeling is observed.

A: Foaming derived only from foreign matter having a size of 100 μm or more is observed.

X: Foaming derived from foreign matter having a size of less than 100 μm, peeling at the ends, and displacement of films are observed.

(10) ITO corrosiveness [rate of change in sheet resistance value]

Provided was a film including an ITO layer provided on one face of a cycloolefin (COP) substrate (trade name "ZEONOR", manufactured by Zeon Corporation, thickness: 100 μm) such that the sheet resistance value reached 70 Ω/square (hereinafter, also referred to as "the COP-ITO film"). One of the separators was separated from the double-coated pressure-sensitive adhesive sheet, and the double-coated pressure-sensitive adhesive sheet was laminated by pressure-bonding on the other face of the film under pressure-bonding conditions of a 2-kg roller and one reciprocation to obtain a structure A having a lamination structure of the ITO film and the double-coated pressure-sensitive adhesive sheet.

Next, the structure A was cut into a size of 15 mm × 15 mm, then the separator of the double-coated pressure-sensitive adhesive sheet was separated, and the sheet was laminated by pressure-bonding on a soda glass plate (25 mm × 25 mm, thickness: 0.7 mm) under pressure-bonding conditions of a 2-kg roller and one reciprocation. Then, a structure B was obtained having a lamination structure of the ITO film, the double-coated pressure-sensitive adhesive sheet, and the glass.

Separately, one of the separators of the double-coated pressure-sensitive adhesive sheet same as described above was separated, the double-coated pressure-sensitive adhesive sheet was laminated by pressure-bonding on the substrate face side of a film including an antireflection-treated layer provided on one face of a triacetyl cellulose (TAC) substrate (trade name "DSC-03", manufactured by Dai Nippon Printing Co., Ltd., thickness: 90 um, hereinafter, may be referred to as "the AR film") under pressure-bonding conditions of a 2-kg roller and one reciprocation to thereby obtain a structure C having a lamination structure of the AR film and the double-coated pressure-sensitive adhesive sheet. Next, the structure C was cut into a size of 10 mm × 10 mm, then the separator of the double-coated pressure-sensitive adhesive sheet was separated, and the sheet was laminated by pressure-bonding on the center portion on the copper face side in the structure B under pressure-bonding conditions of a 2-kg roller and one reciprocation to thereby obtain a structure D having a lamination structure comprising the 5 layers: the AR film, the double-coated pressure-sensitive adhesive sheet, the ITO film, the double-coated pressure-sensitive adhesive sheet, and the glass.

After left under an atmosphere of 23°C and 50% RH for 30 minutes, the structure D was placed in an autoclave and subjected to an autoclave treatment under conditions of a temperature of 50°C and a pressure of 0.5 MPa for 15 minutes.

After the autoclave treatment, the structure D was removed from the autoclave and left under an atmosphere of 23°C and 50% RH (RH: relative humidity) for 24 hours.

As the apparatus for measuring the sheet resistance value of the ITO layer in the structure D, a hall effect measurement apparatus (trade name "HL5500PC", manufactured by Toho Technology Corporation) was used.

The sheet resistance value of each of the structures D (initial sheet resistance: R0) was measured under an atmosphere of 23°C and 50% RH.

After the measurement, the structures D were each placed under an environment of 85°C and 85% RH.

After removal, temperature and humidity conditioning was conducted under an environment of 23°C and 50% RH for 24 hours, and then the sheet resistance value (sheet resistance after test: R1) was measured under an atmosphere of 23°C and 50% RH.

The rate of change in the resistance value T was determined from the initial sheet resistance value (R0) and the sheet resistance value after the test (R1), obtained after placing under an environment of 85°C and 85% RH for 500 hours, by the following calculation equation.

$$\text{Rate of change } T(\%) = (R1 - R0)/R0 \times 100$$

A case which the rate of change in the sheet resistance value T was less than 130% was considered acceptable ("o"), and the sheet was determined to have favorable corrosion prevention performance.

Meanwhile, a case in which the rate of change in the sheet resistance from the initial stage was 130% or more was considered failure ("×"), and the sheet was determined to have no favorable corrosion prevention performance.

[Table 2]

[Table 2]

| Evaluation | | Ex. 1 | Ex. 2 | Ex. 3 | Ex. 4 | Ex. 5 | Comp. Ex. 1 | Comp. Ex. 2 | Comp. Ex. 3 | Comp. Ex. 4 | Comp. Ex. 5 | Comp. Ex. 6 | Comp. Ex. 7 | Comp. Ex. 8 |
|---|---|---|---|---|---|---|---|---|---|---|---|---|---|---|
| Non-volatile content (%) | | 99.1 | 99.0 | 98.9 | 98.9 | 98.8 | 98.9 | 98.8 | 98.8 | 92.0 | 90.0 | 91.0 | 99.0 | 99.0 |
| Gel fraction (%) | | 52.0 | 62.0 | 64.0 | 56.0 | 74.0 | 80.4 | 91.2 | 92.0 | 34.0 | 31.0 | 33.0 | 32.0 | 28.0 |
| Total light transmittance (%) | | 92.3 | 92.2 | 92.2 | 92.2 | 92.2 | 92.3 | 92.3 | 92.3 | 91.2 | 91.0 | 90.8 | 92.3 | 92.3 |
| Haze (%) | | 0.2 | 0.4 | 0.5 | 0.5 | 0.4 | 0.2 | 0.3 | 0.3 | 7.2 | 0.5 | 0.7 | 0.3 | 0.2 |
| Dielectric constant | 100kHz | 2.9 | 2.8 | 2.9 | 3.7 | 3.8 | 3.0 | 3.8 | 4.0 | 2.8 | 3.6 | 3.8 | 3.5 | 3.0 |
| | 1MHz | 2.6 | 2.5 | 2.6 | 3.3 | 3.4 | 2.7 | 3.4 | 3.6 | 2.5 | 3.3 | 3.2 | 3.1 | 2.8 |
| Elastic modulus G' Mpa | 25°C | 0.10 | 0.12 | 0.11 | 0.10 | 0.10 | 0.16 | 0.14 | 0.11 | 0.05 | 0.07 | 0.06 | 0.07 | 0.12 |
| 180 degree adhesive strength to glass [N/20 mm] | 25°C | 18.1 | 13.6 | 12.2 | 15.9 | 16.7 | 20.0 | 19.0 | 20.4 | 13.4 | 13.0 | 13.5 | 12.5 | 16.0 |
| | 65°C | 9.5 | 7.8 | 7.1 | 8.5 | 8.0 | 12.0 | 12.5 | 14.0 | 3.8 | 3.0 | 3.8 | 3.2 | 7.5 |
| SP 300 mm/min | 65°C/ 25°C ratio | 52.5 | 57.4 | 58.2 | 53.5 | 47.9 | 60.0 | 65.8 | 68.6 | 28.4 | 23.1 | 28.1 | 25.6 | 46.9 |
| Separator release strength [N/50 mm] | Light release side | 0.18 | 0.17 | 0.18 | 0.17 | 0.16 | 0.22 | 0.19 | 0.17 | 0.23 | 0.22 | 0.22 | 0.17 | 0.26 |
| SP 300 mm/min | Heavy release side | 0.45 | 0.40 | 0.45 | 0.45 | 0.50 | 0.56 | 0.46 | 0.45 | 0.60 | 0.50 | 0.56 | 0.56 | 0.54 |
| Foaming and peeling resistance | | E | E | E | E | E | A | E | E | X | X | X | X | X |
| ITO corrosiveness | | ○ | ○ | ○ | ○ | ○ | ○ | ○ | ○ | × | × | × | ○ | × |

Variations of the present invention will be attached below.

[Attachment 1] A pressure-sensitive adhesive sheet comprising a pressure-sensitive adhesive layer, wherein

the pressure-sensitive adhesive layer contains an acrylic polymer (A) and a hydrogenated polyolefinic resin (B) that exhibits liquid flowability at 25°C,
the pressure-sensitive adhesive layer has a dielectric constant at a frequency of 1 MHz of from 2.3 to 3.5,
the pressure-sensitive adhesive sheet has a 180° peel adhesive strength to a glass plate at a tensile speed of 300 mm/minute at 65°C of 6 N/20 mm or more, and
a proportion of the 180° peel adhesive strength to a glass plate at a tensile speed of 300 mm/minute at 65°C to a 180° peel adhesive strength to a glass plate at a tensile speed of 300 mm/minute at 25°C (180° peel adhesive strength to a glass plate at a tensile speed of 300 mm/minute at 65°C/180° peel adhesive strength to a glass plate at a tensile speed of 300 mm/minute at 25°C × 100) is 30 or more.

[Attachment 2] The pressure-sensitive adhesive sheet according to attachment 1, having a 180° peel adhesive strength to a glass plate at a tensile speed of 300 mm/minute at 25°C of 10 N/20 mm or more.
[Attachment 3] The pressure-sensitive adhesive sheet according to attachment 1 or 2, wherein the pressure-sensitive adhesive layer has a gel fraction of from 40 to 85%.
[Attachment 4] The pressure-sensitive adhesive sheet according to any one of attachments 1 to 3, having a haze (in accordance with JIS K 7136) of 1.0% or less.
[Attachment 5] The pressure-sensitive adhesive sheet according to any one of attachments 1 to 4, having a total light transmittance (in accordance with JIS K 7361-1) of 90% or more.
[Attachment 6] The pressure-sensitive adhesive sheet according to any one of attachments 1 to 5, having a thickness of from 12 to 350 um.
[Attachment 7] The pressure-sensitive adhesive sheet according to any one of attachments 1 to 6, wherein the hydrogenated polyolefinic resin (B) has a number average molecular weight (Mn) of 1000 to 5000 and a polydispersity (Mw/Mn) of 2.0 or less.
[Attachment 8] The pressure-sensitive adhesive sheet according to any one of attachments 1 to 7, wherein the hydrogenated polyolefinic resin (B) comprises at least one selected from the group consisting of a hydrogenated polyolefin and a hydrogenated polyolefin polyol.
[Attachment 9] The pressure-sensitive adhesive sheet according to any one of attachments 1 to 8, wherein the hydrogenated polyolefinic resin (B) comprises at least one selected from the group consisting of a hydrogenated polybutadiene and a hydrogenated polybutadiene polyol.
[Attachment 10] The pressure-sensitive adhesive sheet according to any one of attachments 1 to 9, wherein the pressure-sensitive adhesive layer comprises 3 to 35 parts by weight of the hydrogenated polyolefinic resin (B) based on 100 parts by weight of the acrylic polymer (A).
[Attachment 11] The pressure-sensitive adhesive sheet according to any one of attachments 1 to 10, comprising, as a monomer component constituting the acrylic polymer (A), a (meth)acrylic alkyl ester having a branched-chain alkyl group having 10 to 24 carbon atoms.
[Attachment 12] The pressure-sensitive adhesive sheet according to attachment 11, wherein the (meth)acrylic alkyl ester having a branched-chain alkyl group having 10 to 24 carbon atoms comprises isostearyl (meth)acrylate.
[Attachment 13] The pressure-sensitive adhesive sheet according to attachment 11 or 12, comprising 3 to 50 parts by weight of a (meth)acrylic alkyl ester having a branched-chain alkyl group having 10 to 24 carbon atoms based on the total amount of the monomer components constituting the acrylic polymer (A) (100 parts by weight).
[Attachment 14] The pressure-sensitive adhesive sheet according to any one of attachments 1 to 13, further comprising, as a monomer component constituting the acrylic polymer (A), at least one selected from the group consisting of a (meth)acrylic alkyl ester having a linear-chain alkyl group having 1 to 24 carbon atoms and a (meth)acrylic alkyl ester having a branched-chain alkyl group having 3 to 9 carbon atoms.
[Attachment 15] The pressure-sensitive adhesive sheet according to any one of attachments 1 to 14, comprising 0.1 to 25 parts by weight of a hydroxyl group-containing monomer based on the total amount of the monomer components constituting the acrylic polymer (A) (100 parts by weight).
[Attachment 16] The pressure-sensitive adhesive sheet according to any one of attachments 1 to 15, comprising 3 to 30 parts by weight of at least one selected from a nitrogen atom-containing monomer and an alicyclic structure-containing monomer based on the total amount of the monomer components constituting the acrylic polymer (A) (100 parts by weight).
[Attachment 17] The pressure-sensitive adhesive sheet according to any one of attachments 1 to 16, wherein the acrylic polymer (A) is free of or substantially free of a carboxyl group-containing monomer as a constituent monomer component.

[Attachment 18] The pressure-sensitive adhesive sheet according to any one of attachments 1 to 17, wherein the pressure-sensitive adhesive layer further comprises a polyfunctional (meth)acrylate.
[Attachment 19] The pressure-sensitive adhesive sheet according to any one of attachments 1 to 18, wherein the pressure-sensitive adhesive layer further comprises an anti-corrosive agent.
[Attachment 20] The pressure-sensitive adhesive sheet according to attachment 19, wherein the anti-corrosive agent is a benzotriazole compound.
[Attachment 21] The pressure-sensitive adhesive sheet according to any one of attachments 1 to 20, wherein the pressure-sensitive adhesive layer further comprises a silane coupling agent.
[Attachment 22] The pressure-sensitive adhesive sheet according to any one of attachments 1 to 21, wherein the pressure-sensitive adhesive layer further comprises an antioxidant.
[Attachment 23] An optical member comprising at least the pressure-sensitive adhesive sheet according to any one of attachments 1 to 22 and a substrate, wherein the substrate comprises metal wiring on at least one face, and the pressure-sensitive adhesive sheet is laminated on the face of the substrate on the side having the metal wiring.
[Attachment 24] The optical member according to attachment 23, wherein the metal wiring is metal mesh wiring or silver nanowire.
[Attachment 25] A touch panel comprising at least the pressure-sensitive adhesive sheet according to any one of attachments 1 to 22 and a substrate, wherein
the substrate comprises metal wiring on at least one face, and the pressure-sensitive adhesive sheet is laminated on the face of the substrate on the side having the metal wiring.
[Attachment 26] The touch panel according to attachment 25, wherein the metal wiring is metal mesh wiring or silver nanowire.

Reference Signs List

1, 4, 5 optical member
2 touch panel
3 metal mesh wiring
10, 10a, 10b, 10c pressure-sensitive adhesive sheet
11 metal mesh film
12a, 12b transparent substrate
13 metal mesh film
14a, 14b polarizing plate
15 hard-coated film
20 glass having a level difference (level difference specimen)
21 glass plate
22 level difference

## Claims

**1.** A pressure-sensitive adhesive sheet comprising a pressure-sensitive adhesive layer, wherein

the pressure-sensitive adhesive layer contains an acrylic polymer (A) and a hydrogenated polyolefinic resin (B) that exhibits liquid flowability at 25°C,
the pressure-sensitive adhesive layer has a dielectric constant at a frequency of 1 MHz of from 2.3 to 3.5,
the pressure-sensitive adhesive sheet has a 180° peel adhesive strength to a glass plate at a tensile speed of 300 mm/minute at 65°C of 6 N/20 mm or more, and
a proportion of the 180° peel adhesive strength to a glass plate at a tensile speed of 300 mm/minute at 65°C to a 180° peel adhesive strength to a glass plate at a tensile speed of 300 mm/minute at 25°C (180° peel adhesive strength to a glass plate at a tensile speed of 300 mm/minute at 65°C/180° peel adhesive strength to a glass plate at a tensile speed of 300 mm/minute at 25°C × 100) is 30 or more.

**2.** The pressure-sensitive adhesive sheet according to claim 1, having a 180° peel adhesive strength to a glass plate at a tensile speed of 300 mm/minute at 25°C of 10 N/20 mm or more.

**3.** The pressure-sensitive adhesive sheet according to claim 1 or 2, wherein the pressure-sensitive adhesive layer has

a gel fraction of from 40 to 85%.

4. The pressure-sensitive adhesive sheet according to any one of claims 1 to 3, having a haze (in accordance with JIS K 7136) of 1.0% or less.

5. The pressure-sensitive adhesive sheet according to any one of claims 1 to 4, having a total light transmittance (in accordance with JIS K 7361-1) of 90% or more.

6. The pressure-sensitive adhesive sheet according to any one of claims 1 to 5, having a thickness of from 12 to 350 um.

7. The pressure-sensitive adhesive sheet according to any one of claims 1 to 6, wherein the hydrogenated polyolefinic resin (B) has a number average molecular weight (Mn) of 1000 to 5000 and a polydispersity (Mw/Mn) of 2.0 or less.

8. The pressure-sensitive adhesive sheet according to any one of claims 1 to 7, wherein the hydrogenated polyolefinic resin (B) comprises at least one selected from the group consisting of a hydrogenated polyolefin and a hydrogenated polyolefin polyol.

9. The pressure-sensitive adhesive sheet according to any one of claims 1 to 8, wherein the hydrogenated polyolefinic resin (B) comprises at least one selected from the group consisting of a hydrogenated polybutadiene and a hydrogenated polybutadiene polyol.

10. The pressure-sensitive adhesive sheet according to any one of claims 1 to 9, wherein the pressure-sensitive adhesive layer comprises 3 to 35 parts by weight of the hydrogenated polyolefinic resin (B) based on 100 parts by weight of the acrylic polymer (A).

11. The pressure-sensitive adhesive sheet according to any one of claims 1 to 10, comprising, as a monomer component constituting the acrylic polymer (A), a (meth)acrylic alkyl ester having a branched-chain alkyl group having 10 to 24 carbon atoms.

12. The pressure-sensitive adhesive sheet according to claim 11, wherein the (meth)acrylic alkyl ester having a branched-chain alkyl group having 10 to 24 carbon atoms comprises isostearyl (meth)acrylate.

13. The pressure-sensitive adhesive sheet according to claim 11 or 12, comprising 3 to 50 parts by weight of a (meth)acrylic alkyl ester having a branched-chain alkyl group having 10 to 24 carbon atoms based on the total amount of the monomer components constituting the acrylic polymer (A) (100 parts by weight).

14. The pressure-sensitive adhesive sheet according to any one of claims 1 to 13, further comprising, as a monomer component constituting the acrylic polymer (A), at least one selected from the group consisting of a (meth)acrylic alkyl ester having a linear-chain alkyl group having 1 to 24 carbon atoms and a (meth)acrylic alkyl ester having a branched-chain alkyl group having 3 to 9 carbon atoms.

15. The pressure-sensitive adhesive sheet according to any one of claims 1 to 14, comprising 0.1 to 25 parts by weight of a hydroxyl group-containing monomer based on the total amount of the monomer components constituting the acrylic polymer (A) (100 parts by weight).

16. The pressure-sensitive adhesive sheet according to any one of claims 1 to 15, comprising 3 to 30 parts by weight of at least one selected from a nitrogen atom-containing monomer and an alicyclic structure-containing monomer based on the total amount of the monomer components constituting the acrylic polymer (A) (100 parts by weight).

17. The pressure-sensitive adhesive sheet according to any one of claims 1 to 16, wherein the acrylic polymer (A) is free of or substantially free of a carboxyl group-containing monomer as a constituent monomer component.

18. The pressure-sensitive adhesive sheet according to any one of claims 1 to 17, wherein the pressure-sensitive adhesive layer further comprises a polyfunctional (meth)acrylate.

19. The pressure-sensitive adhesive sheet according to any one of claims 1 to 18, wherein the pressure-sensitive adhesive layer further comprises an anti-corrosive agent.

20. The pressure-sensitive adhesive sheet according to claim 19, wherein the anti-corrosive agent is a benzotriazole compound.

21. The pressure-sensitive adhesive sheet according to any one of claims 1 to 20, wherein the pressure-sensitive adhesive layer further comprises a silane coupling agent.

22. The pressure-sensitive adhesive sheet according to any one of claims 1 to 21, wherein the pressure-sensitive adhesive layer further comprises an antioxidant.

23. An optical member comprising at least the pressure-sensitive adhesive sheet according to any one of claims 1 to 22 and a substrate, wherein the substrate comprises metal wiring on at least one face, and the pressure-sensitive adhesive sheet is laminated on the face of the substrate on the side having the metal wiring.

24. The optical member according to claim 23, wherein the metal wiring is metal mesh wiring or silver nanowire.

25. A touch panel comprising at least the pressure-sensitive adhesive sheet according to any one of claims 1 to 22 and a substrate, wherein
the substrate comprises metal wiring on at least one face, and the pressure-sensitive adhesive sheet is laminated on the face of the substrate on the side having the metal wiring.

26. The touch panel according to claim 25, wherein the metal wiring is metal mesh wiring or silver nanowire.

[Fig. 1]

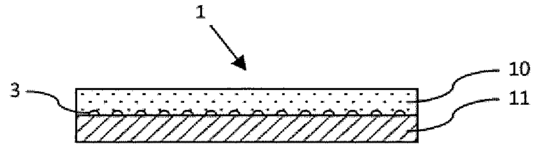
1
3
10
11

[Fig. 2]

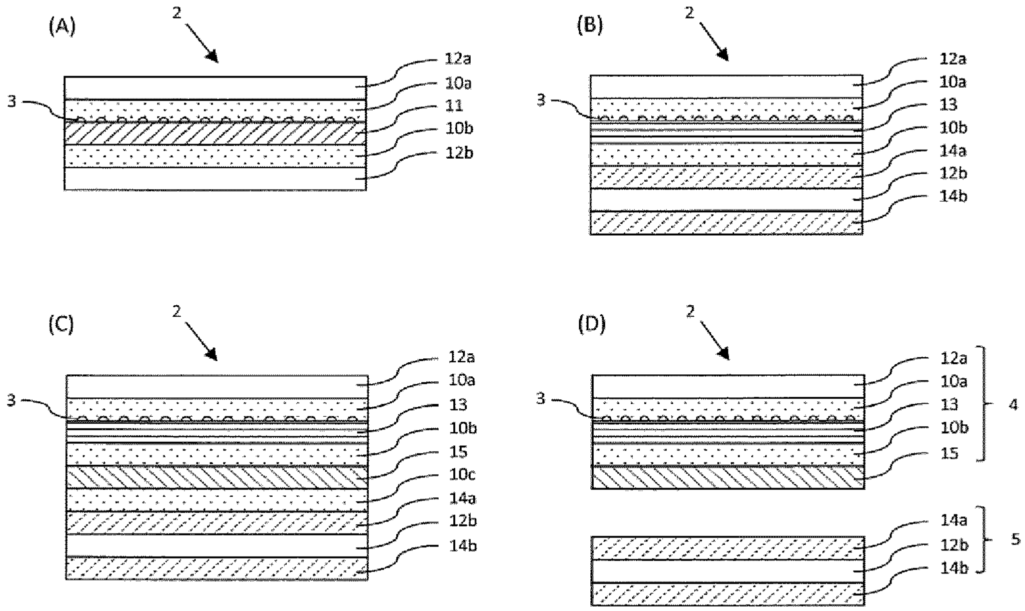
(A)
2
3
12a
10a
11
10b
12b
(B)
2
3
12a
10a
13
10b
14a
12b
14b
(C)
2
3
12a
10a
13
10b
15
10c
14a
12b
14b
(D)
2
3
12a
10a
13
10b
15
4
14a
12b
14b
5

[Fig. 3]

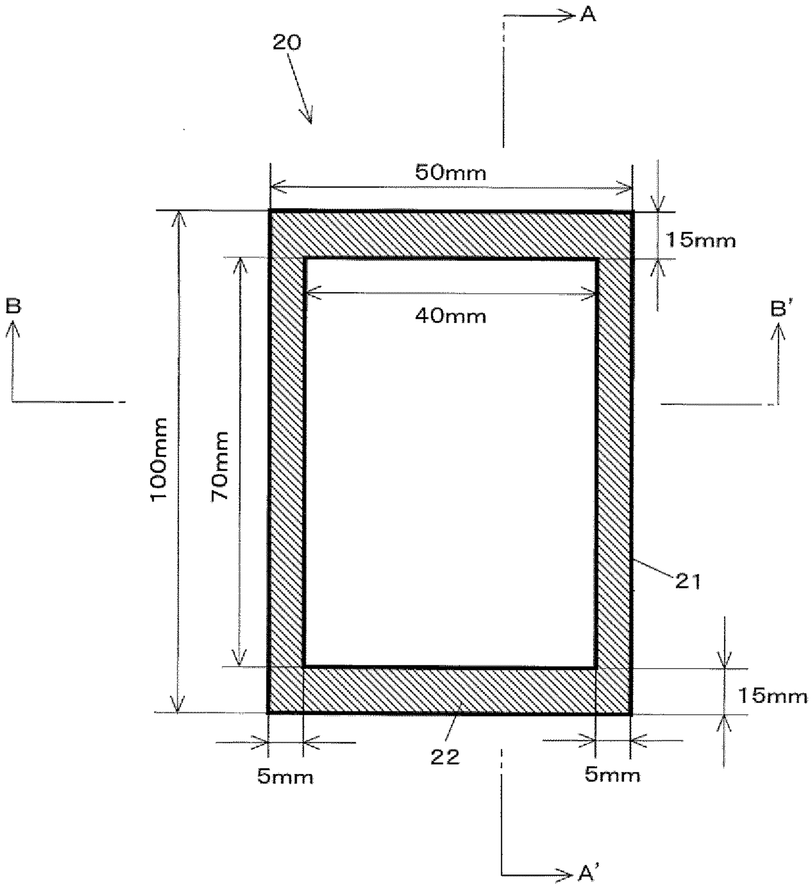
20
A
50mm
15mm
B
40mm
B'
100mm
70mm
21
15mm
22
5mm
5mm
A'

[Fig. 4]

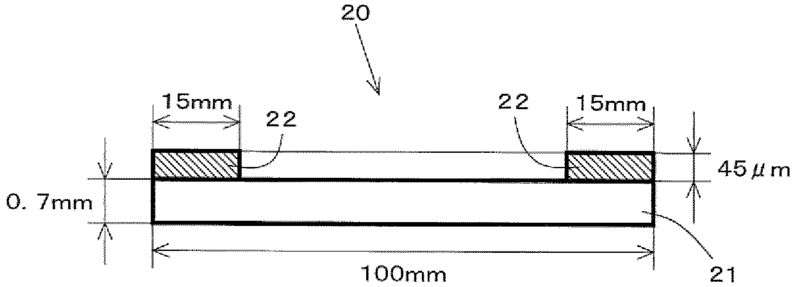
20
15mm
22
22
15mm
45μm
0. 7mm
100mm
21

[Fig. 5]

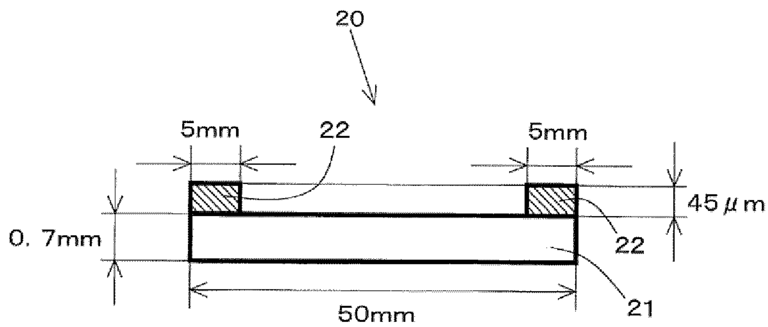

## INTERNATIONAL SEARCH REPORT

International application No. PCT/JP2021/021961

A. CLASSIFICATION OF SUBJECT MATTER
B32B 27/00(2006.01)i; B32B 27/30(2006.01)i; C09J 11/06(2006.01)i; C09J 109/00(2006.01)i; C09J 123/26(2006.01)i; C09J 133/00(2006.01)i; C09J 133/04(2006.01)i; C09J 133/14(2006.01)i; C09J 7/38(2018.01)i
FI: C09J7/38; C09J133/00; C09J133/14; C09J123/26; C09J109/00; C09J11/06; B32B27/00 M; B32B27/30 A; C09J133/04
According to International Patent Classification (IPC) or to both national classification and IPC

B. FIELDS SEARCHED

Minimum documentation searched (classification system followed by classification symbols)
B32B1/00-43/00; C08C19/00-19/44; C08F6/00-246/00; C08F283/01; C08F290/00-290/14; C08F299/00-299/08; C08F301/00; C09J1/00-5/10; C09J7/00-7/50; C09J9/00-201/10

Documentation searched other than minimum documentation to the extent that such documents are included in the fields searched

| | |
|---|---|
| Published examined utility model applications of Japan | 1922-1996 |
| Published unexamined utility model applications of Japan | 1971-2021 |
| Registered utility model specifications of Japan | 1996-2021 |
| Published registered utility model applications of Japan | 1994-2021 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2019-44119 A (NITTO DENKO CORP.) 22 March 2019 (2019-03-22) claims 1, 5-7, 9-14, paragraphs [0033]-[0034], [0044]-[0045], [0097]-[0104], [0112]-[0118], [0127]-[0131], [0171]-[0173], examples 1-4, table 1 | 1-26 |
| A | JP 2020-83996 A (NITTO DENKO CORP.) 04 June 2020 (2020-06-04) claims 1, 4, 6-8, 10, 16, paragraphs [0009]-[0010], [0020], [0031]-[0034], [0036]-[0050], [0061]-[0066], [0081]-[0082], examples 1-8, table 1 | 1-26 |
| A | JP 2015-214594 A (SHOWA DENKO KABUSHIKI KAISHA) 03 December 2015 (2015-12-03) claims 1, 6-7, 14-15, paragraphs [0007], [0023], [0034]-[0035], [0077]-[0080], [0094]-[0109], [0117], [0127], [0136], [0145], examples, tables 1-5 | 1-26 |

☒ Further documents are listed in the continuation of Box C. ☒ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 26 July 2021 (26.07.2021) | 10 August 2021 (10.08.2021) |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**

International application No.
PCT/JP2021/021961

C (Continuation). DOCUMENTS CONSIDERED TO BE RELEVANT

| Category* | Citation of document, with indication, where appropriate, of the relevant passages | Relevant to claim No. |
|---|---|---|
| A | WO 2013/187508 A1 (SHOWA DENKO KABUSHIKI KAISHA) 19 December 2013 (2013-12-19) claims 1, 7-12, paragraphs [0019]-[0020], [0024], [0046]-[0047], [0051], [0118]-[0123], [0136]-[0148], [0159]-[0160], [0178], [0187]-[0189], examples, tables 1-3 | 1-26 |
| A | WO 2014/069134 A1 (SHOWA DENKO KABUSHIKI KAISHA) 08 May 2014 (2014-05-08) claims 1-3, 11-16, paragraphs [0008], [0019], [0024], [0047], [0132]-[0137], [0153]-[0168], [0208], examples, tables 1-4 | 1-26 |
| A | WO 2013/146015 A1 (SHOWA DENKO KABUSHIKI KAISHA) 03 October 2013 (2013-10-03) claims 1, 3-6, 9-10, 12-17, paragraphs [0009], [0038]-[0039], [0063]-[0087], [0096]-[0106], [0115]-[0116], [0148], examples, tables 1-8 | 1-26 |

Form PCT/ISA/210 (continuation of second sheet) (January 2015)

**INTERNATIONAL SEARCH REPORT**
Information on patent family members

International application No.
PCT/JP2021/021961

| Patent Documents referred in the Report | Publication Date | Patent Family | Publication Date |
|---|---|---|---|
| JP 2019-44119 A | 22 Mar. 2019 | CN 111051452 A<br>claims 1, 5-7, 9-14, paragraphs [0050]-[0051], [0070]-[0072], [0144]-[0152], [0167]-[0176], [0186]-[0190], [0234]-[0237], examples 1-4, table 1<br>KR 10-2020-0050957 A | |
| JP 2020-83996 A | 04 Jun. 2020 | CN 111286277 A<br>claims 1, 4, 6-8, 10, 16, paragraphs [0013]-[0014], [0042]-[0043], [0054]-[0057], [0059]-[0075], [0061]-[0066], [0088]-[0097], examples 1-8, table 1<br>KR 10-2020-0060235 A | |
| JP 2015-214594 A | 03 Dec. 2015 | (Family: none) | |
| WO 2013/187508 A1 | 19 Dec. 2013 | US 2015/0079379 A1<br>claims 1, 7-12, paragraphs [0065]-[0069], [0076]-[0077], [0109]-[0112], [0116]-[0117], [0217]-[0223], [0240]-[0253], [0269]-[0270], [0297]-[0300], [0321]-[0324], examples, tables 1-3<br>CN 104364282 A<br>KR 10-2014-0119172 A | |
| WO 2014/069134 A1 | 08 May 2014 | CN 104755517 A<br>claims 1-3, 11-16, paragraphs [0020], [0093]-[0094], [0101]-[0102], [0142], [0289]-[0299], [0330]-[0347], [0412], examples, tables 1-4<br>KR 10-2015-0023809 A | |

Form PCT/ISA/210 (patent family annex) (January 2015)

**INTERNATIONAL SEARCH REPORT**
Information on patent family members

International application No.
PCT/JP2021/021961

| Patent Documents referred in the Report | Publication Date | Patent Family | Publication Date |
|---|---|---|---|
| WO 2013/146015 A1 | 03 Oct. 2013 | US 2015/0050432 A1 claims 1, 3-6, 9-10, 12-17, paragraphs [0009], [0046]-[0047], [0074]-[0096], [0105], [0124]-[0125], [0159], examples, tables 1-3<br>CN 104169316 A<br>KR 10-2014-0129140 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2003238915 A
- JP 2003342542 A
- JP 2004231723 A
- JP 2016172865 A
- JP 2019038947 A
- JP 2019182928 A
- JP 2002069411 A